(19) Europäisches Patentamt
European Patent Office
Office européen des brevets

(11) **EP 2 101 318 B1**

(12) **EUROPEAN PATENT SPECIFICATION**

(45) Date of publication and mention
of the grant of the patent:
**04.06.2014 Bulletin 2014/23**

(51) Int Cl.:
*G10L 19/038* (2013.01)     *G10L 19/083* (2013.01)
*G10L 19/02* (2013.01)     *G10L 19/24* (2013.01)

(21) Application number: **07850512.0**

(86) International application number:
**PCT/JP2007/073966**

(22) Date of filing: **12.12.2007**

(87) International publication number:
**WO 2008/072670 (19.06.2008 Gazette 2008/25)**

(54) **Encoding device, decoding device and corresponding methods**

Kodierungseinrichtung, Dekodierungseinrichtung und entsprechende Verfahren

Dispositif de codage, dispositif de décodage et procédés correspondants

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **13.12.2006  JP 2006336270
02.03.2007  JP 2007053499
17.05.2007  JP 2007132078
13.07.2007  JP 2007185078**

(43) Date of publication of application:
**16.09.2009  Bulletin 2009/38**

(73) Proprietor: **Panasonic Corporation
Kadoma-shi
Osaka 571-8501 (JP)**

(72) Inventors:
• **YAMANASHI, Tomofumi**
**Chuo-ku, Osaka-shi, Osaka 540-6207 (JP)**
• **OSHIKIRI, Masahiro**
**Chuo-ku, Osaka-shi, Osaka 540-6207 (JP)**

(74) Representative: **Grünecker, Kinkeldey,
Stockmair & Schwanhäusser
Leopoldstrasse 4
80802 München (DE)**

(56) References cited:
**JP-A- 09 127 987     JP-A- 10 143 198
JP-A- 2006 293 405     US-A1- 2003 093 271**

• **SALAVEDRA J M ET AL: "APVQ encoder applied to wideband speech coding", SPOKEN LANGUAGE, 1996. ICSLP 96. PROCEEDINGS., FOURTH INTERNATIONAL CO NFERENCE ON PHILADELPHIA, PA, USA 3-6 OCT. 1996, NEW YORK, NY, USA,IEEE, US, vol. 2, 3 October 1996 (1996-10-03), pages 941-944, XP010237775, DOI: DOI:10.1109/ICSLP.1996.607757 ISBN: 978-0-7803-3555-4**

**Description**

Technical Field

The present invention relates to an encoding apparatus/decoding apparatus and encoding method/decoding method used in a communication system in which a signal is encoded and transmitted, and received and decoded.

Background Art

When a speech/audio signal is transmitted in a mobile communication system or a packet communication system typified by Internet communication, compression/encoding technology is often used in order to increase speech/audio signal transmission efficiency. Also, in recent years, a scalable encoding/decoding method has been developed that enables a good-quality decoded signal to be obtained from part of encoded information even if a transmission error occurs during transmission.

One above-described compression/encoding technology is a time-domain predictive encoding technology that increases compression efficiency by using the temporal correlation of a speech signal and/or audio signal (hereinafter referred to as "speech/audio signal"). For example, in Patent Document 1, a current-frame signal is predicted from a past-frame signal, and the predictive encoding method is switched according to the prediction error. Also, in Non-patent Document 1, a technology is described whereby a predictive encoding method is switched according to the degree of change in the time domain of a speech parameter such as LSF (Line Spectral Frequency) and the frame error occurrence state.

Patent Document 1: Japanese Patent Application Laid-Open No. HEI 8-211900
Non-patent Document 1: Thomas Eriksson, Jan Linden, and Jan Skoglund, "Exploiting Inter-frame Correlation In Spectral Quantization," "Acoustics, Speech, and Signal Processing," 1996. ICASSP-96. Conference Proceedings, 7-10 May 1996 Page(s): 765 - 768 vol. 2

US 2003/093271 A1 aims at providing an encoding device that is capable of encoding an audio signal with a high compression rate, at providing a decoding device that is capable of decoding the encoded audio signal, and at reproducing wideband frequency spectral data and a wideband audio signal. In order to achieve this aim, the system of the document focuses on a band extending unit and an encoding unit. A frequency spectrum, transformed from an input signal in a time domain, is divided into a lower frequency spectrum and an extension data which specifies a higher frequency spectrum. The encoding unit is operable to encode the lower frequency spectrum and the extension data and to output the encoded lower frequency spectrum and extension data.

Further, a partial spectrum is copied as the higher frequency spectrum from among a plurality of the partial spectrums which form the lower frequency spectrum. Regarding the higher frequency spectrum, not the spectrum itself has to be encoded, but mainly the data for copying the lower frequency spectrum, which substitutes for the higher frequency spectrum. This results in the effect that the data amount which is consumed by the encoded data stream representing the higher frequency components can be reduced.

The article "APVQ Encoder Applied to Wideband Speech Coding" by Salavedra J. M. et al., October 3, 1996, relates to a wideband speech coding technique in which an APVQ encoder combines subband coding, vector quantization and adaptive prediction techniques. It is taught that a speech signal is split into 16 subbands by means of a QMF filter bank, wherein every subband has a frequency bandwidth of 500Hz. According to the disclosed coding scheme, a signal vector is formed with one sample of the normalized prediction error signal coming from different subbands and then it is vector quantized. A prediction error signal is normalized by its gain and the normalized prediction error signal is input to the vector quantization, and therefore an adaptive gain-shape vector quantization is considered.

Disclosure of Invention

Problems to be Solved by the Invention

However, with any of the above technologies, predictive encoding is performed based on a time domain parameter on a frame-by-frame basis, and predictive encoding based on a non-time domain parameter such as a frequency domain parameter is not mentioned. If a predictive encoding method based on a time domain parameter such as described above is simply applied to frequency domain parameter encoding, there is no problem if a quantization target band is the same in a past frame and current frame, but if the quantization target band is different in a past frame and current frame, encoding error and decoded signal audio quality degradation increases greatly, and a speech/audio signal may not be able to be decoded.

It is an object of the present invention to provide an encoding apparatus and so forth capable of reducing the encoded information amount of a speech/audio signal, and also capable of reducing speech/audio signal encoding error and decoded signal audio quality degradation, when a frequency component of a different band is made a quantization target in each frame.

Means for Solving the Problems

An encoding apparatus in accordance with the present invention is defined in claim 1.
A decoding apparatus in accordance with the present invention is defined in claim 16.
An encoding method in accordance with the present invention is defined in claim 17.
A decoding method in accordance with the present invention is defined in claim 18.

Advantageous Effect of the Invention

The present invention reduces the encoded information amount of a speech/audio signal or the like, and also can prevent sharp quality degradation of a decoded signal, decoded speech, and so forth, and can reduce encoding error of a speech/audio signal or the like and decoded signal quality degradation.

Brief Description of Drawings

FIG.1 is a block diagram showing the main configuration of a speech encoding apparatus according to Embodiment 1 of the present invention;
FIG.2 is a drawing showing an example of the configuration of regions obtained by a band selection section according to Embodiment 1 of the present invention;
FIG.3 is a block diagram showing the main configuration of a speech decoding apparatus according to Embodiment 1 of the present invention;
FIG.4 is a block diagram showing the main configuration of a variation of a speech encoding apparatus according to Embodiment not related to the present invention;
FIG. 5 is a block diagram showing the main configuration of a variation of a speech decoding apparatus according to Embodiment not related to the present invention;
FIG.6 is a block diagram showing the main configuration of a speech encoding apparatus according to Embodiment 2 of the present invention;
FIG.7 is a block diagram showing the main configuration of the interior of a second layer encoding section according to Embodiment 2 of the present invention;
FIG.8 is a block diagram showing the main configuration of a speech decoding apparatus according to Embodiment 2 of the present invention;
FIG.9 is a block diagram showing the main configuration of the interior of a second layer decoding section according to Embodiment 2 of the present invention;
FIG.10 is a block diagram showing the main configuration of a speech encoding apparatus according to Embodiment 3 of the present invention;
FIG.11 is a block diagram showing the main configuration of a speech decoding apparatus according to Embodiment 3 of the present invention;
FIG.12 is a block diagram showing the main configuration of a speech encoding apparatus according to Embodiment 4 of the present invention;
FIG.13 is a block diagram showing the main configuration of a speech decoding apparatus according to Embodiment 4 of the present invention;
FIG.14 is a block diagram showing the main configuration of a speech encoding apparatus according to Embodiment 5 of the present invention;
FIG.15 is a block diagram showing the main configuration of the interior of a band enhancement encoding section according to Embodiment 5 of the present invention;
FIG.16 is a block diagram showing the main configuration of the interior of a corrective scale factor encoding section according to Embodiment 5 of the present invention;
FIG.17 is a block diagram showing the main configuration of the interior of a second layer encoding section according to Embodiment 5 of the present invention;
FIG.18 is a block diagram showing the main configuration of a speech decoding apparatus according to Embodiment 5 of the present invention;

FIG.19 is a block diagram showing the main configuration of the interior of a band enhancement decoding section according to Embodiment 5 of the present invention;

FIG.20 is a block diagram showing the main configuration of the interior of a second layer decoding section according to Embodiment 5 of the present invention;

FIG.21 is a block diagram showing the main configuration of a speech encoding apparatus according to Embodiment 6 of the present invention;

FIG.22 is a block diagram showing the main configuration of the interior of a second layer encoding section according to Embodiment 6 of the present invention;

FIG.23 is a drawing showing an example of the configuration of regions obtained by a band selection section according to Embodiment 6 of the present invention;

FIG.24 is a block diagram showing the main configuration of a speech decoding apparatus according to Embodiment 6 of the present invention;

FIG.25 is a block diagram showing the main configuration of the interior of a second layer decoding section according to Embodiment 6 of the present invention;

FIG.26 is a block diagram showing the main configuration of a speech encoding apparatus according to Embodiment 7 of the present invention;

FIG.27 is a block diagram showing the main configuration of the interior of a second layer encoding section according to Embodiment 7 of the present invention;

FIG.28 is a block diagram showing the main configuration of a speech decoding apparatus according to Embodiment 7 of the present invention; and

FIG.29 is a block diagram showing the main configuration of the interior of a second layer decoding section according to Embodiment 7 of the present invention.

Best Mode for Carrying Out the Invention

As an overview of an example of the present invention, in quantization of a frequency component of a different band in each frame, if the number of subbands common to a past-frame quantization target band and current-frame quantization target band is determined to be greater than or equal to a predetermined value, predictive encoding is performed on a frequency domain parameter, and if the number of common subbands is determined to be less than the predetermined value, a frequency domain parameter is encoded directly. By this means, the encoded information amount of a speech/audio signal or the like is reduced, and also sharp quality degradation of a decoded signal, decoded speech, and so forth, can be prevented, and encoding error of a speech/audio signal or the like and decoded signal quality degradation - and decoded speech audio quality degradation, in particular - can be reduced.

Embodiments of the present invention will now be described in detail with reference to the accompanying drawings. In the following descriptions, a speech encoding apparatus and speech decoding apparatus are used as examples of an encoding apparatus and decoding apparatus of the present invention.

(Embodiment 1)

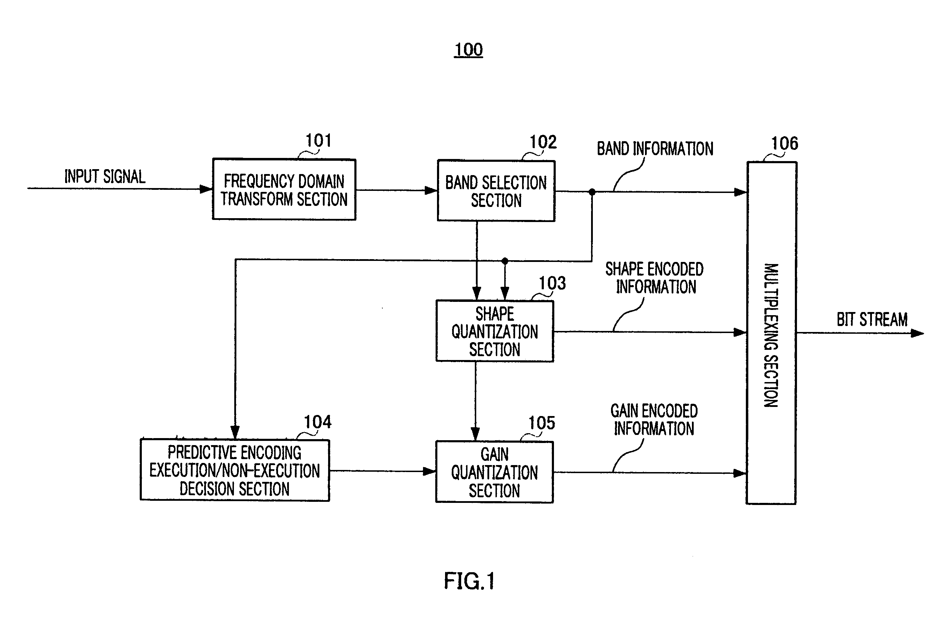

FIG.1 is a block diagram showing the main configuration of speech encoding apparatus 100 according to Embodiment 1 of the present invention.

In this figure, speech encoding apparatus 100 is equipped with frequency domain transform section 101, band selection section 102, shape quantization section 103, predictive encoding execution/non-execution decision section 104, gain quantization section 105, and multiplexing section 106.

Frequency domain transform section 101 performs a Modified Discrete Cosine Transform (MDCT) using an input signal, to calculate an MDCT coefficient, which is a frequency domain parameter, and outputs this to band selection section 102.

Band selection section 102 divides the MDCT coefficient input from frequency domain transform section 101 into a plurality of subbands, selects a band as a quantization target band from the plurality of subbands, and outputs band information indicating the selected band to shape quantization section 103, predictive encoding execution/non-execution decision section 104, and multiplexing section 106. In addition, band selection section 102 outputs the MDCT coefficient to shape quantization section 103. MDCT coefficient input to shape quantization section 103 may also be performed directly from frequency domain transform section 101 separately from input from frequency domain transform section 101 to band selection section 102.

Shape quantization section 103 performs shape quantization using an MDCT coefficient corresponding to a band indicated by band information input from band selection section 102 from among MDCT coefficients input from band selection section 102, and outputs obtained shape encoded information to multiplexing section 106. In addition, shape quantization section 103 finds a shape quantization ideal gain value, and outputs the obtained ideal gain value to gain quantization section 105.

Predictive encoding execution/non-execution decision section 104 finds a number of subbands common to a current-frame quantization target band and a past-frame quantization target band using the band information input from band selection section 102. Then predictive encoding execution/non-execution decision section 104 determines that predictive encoding is to be performed on the MDCT coefficient of the quantization target band indicated by the band information if the number of common subbands is greater than or equal to a predetermined value, or determines that predictive encoding is not to be performed on the MDCT coefficient of the quantization target band indicated by the band information if the number of common subbands is less than the predetermined value. Predictive encoding execution/non-execution decision section 104 outputs the result of this determination to gain quantization section 105.

If the determination result input from predictive encoding execution/non-execution decision section 104 indicates that predictive encoding is to be performed, gain quantization section 105 performs predictive encoding of current-frame quantization target band gain using a past-frame quantization gain value stored in an internal buffer and an internal gain codebook, to obtain gain encoded information. On the other hand, if the determination result input from predictive encoding execution/non-execution decision section 104 indicates that predictive encoding is not to be performed, gain quantization section 105 obtains gain encoded information by directly quantizing the ideal gain value input from shape quantization section 103. Gain quantization section 105 outputs the obtained gain encoded information to multiplexing section 106.

Multiplexing section 106 multiplexes band information input from band selection section 102, shape encoded information input from shape quantization section 103, and gain encoded information input from gain quantization section 105, and transmits the obtained bit stream to a speech decoding apparatus.

Speech encoding apparatus 100 having a configuration such as described above separates an input signal into sections of N samples (where N is a natural number), and performs encoding on a frame-by-frame basis with N samples as one frame. The operation of each section of speech encoding apparatus 100 is described in detail below. In the following description, an input signal of a frame that is an encoding target is represented by $x_n$ (where n = 0, 1, ..., N-1) . Here, n indicates the index of each sample in a frame that is an encoding target.

Frequency domain transform section 101 has N internal buffers, and first initializes each buffer using a value of 0 in accordance with Equation (1) below.

$$buf_n = 0 \quad \left(n = 0,1,\cdots,N-1\right) \qquad \ldots \text{(Equation 1)}$$

In this equation, $buf_n$ (n = 0, ..., N-1) indicates the (n+1)'th of N buffers in frequency domain transform section 101.

Next, frequency domain transform section 101 finds MDCT coefficient $X_k$ by performing a modified discrete cosine transform (MDCT) of input signal $x_n$ in accordance with Equation (2) below

$$X_k = \frac{2}{N} \sum_{n=0}^{2N-1} x'_n \cos\left[\frac{(2n+1+N)(2k+1)\pi}{4N}\right] \quad \left(k = 0,\cdots,N-1\right) \ldots \text{(Equation 2)}$$

In this equation, k indicates the index of each sample in one frame, and $x'_n$ is a vector linking input signal $x_n$ and $buf_n$ in accordance with Equation (3) below.

$$x'_n = \begin{cases} buf_n & \left(n = 0,\cdots N-1\right) \\ x_{n-N} & \left(n = N,\cdots 2N-1\right) \end{cases} \qquad \ldots \text{(Equation 3)}$$

Next, frequency domain transform section 101 updates $buf_n$ (n = 0, ..., N-1) as shown in Equation (4) below.

$$buf_n = x_n \quad \left(n = 0,\cdots N-1\right) \qquad \ldots \text{(Equation 4)}$$

Then frequency domain transform section 101 outputs found MDCT coefficient $X_k$ to band selection section 102.

Band selection section 102 first divides MDCT coefficient $X_k$ into a plurality of subbands. Here, a description will be given taking a case in which MDCT coefficient $X_k$ is divided equally into J subbands (where J is a natural number) as an example. Then band selection section 102 selects L consecutive subbands (where L is a natural number) from among the J subbands, and obtains M kinds of subband groups (where M is a natural number). Below, these M kinds of subband groups are called regions.

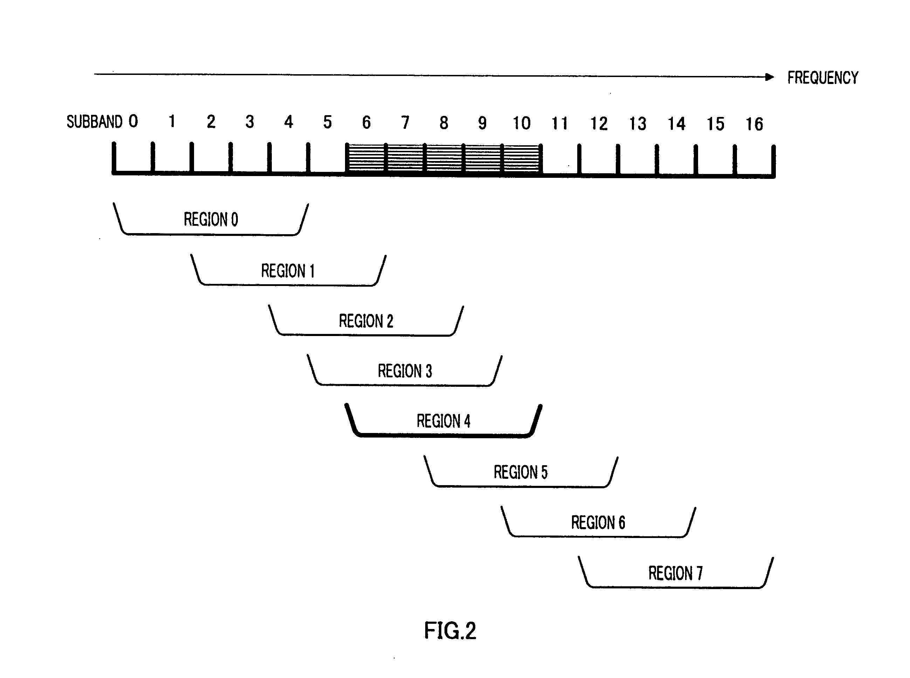

FIG.2 is a drawing showing an example of the configuration of regions obtained by band selection section 102.

In this figure, the number of subbands is 17 (J=17), the number of kinds of regions is eight (M=8), and each region is composed of five consecutive subbands (L=5). Of these, for example, region 4 is composed of subbands 6 through 10.

Next, band selection section 102 calculates average energy E(m) of each of the M kinds of regions in accordance with Equation (5) below.

$$E(m) = \frac{\sum_{j=S(m)}^{S(m)+L-1} \sum_{k=B(j)}^{B(j)+W(j)} (X_k)^2}{L} \quad (m = 0, \cdots, M-1) \quad \ldots(\text{Equation 5})$$

In this equation, j indicates the index of each of J subbands, m indicates the index of each of M kinds of regions, S(m) indicates the minimum value among the indices of L subbands composing region m, B(j) indicates the minimum value among the indices of a plurality of MDCT coefficients composing subband j , and W (j) indicates the bandwidth of subband j . In the following description, a case in which the bandwidths of the J subbands are all equal - that is, a case in which W(j) is a constant - will be described as an example.

Next, band selection section 102 selects a region - for example, a band composed of subbands j" through j"+L-1 - for which average energy E(m) is a maximum as a band that is a quantization target (a quantization target band), and outputs index m_max indicating this region as band information to shape quantization section 103, predictive encoding execution/non-execution decision section 104, and multiplexing section 106. Band selection section 102 also outputs MDCT coefficient $X_k$ to shape quantization section 103. In the following description, the band indices indicating a quantization target band selected by band selection section 102 are assumed to be j" through j"+L-1.

Shape quantization section 103 performs shape quantization on a subband-by-subband basis on an MDCT coefficient corresponding to the band indicated by band information m_max input from band selection section 102. Specifically, shape quantization section 103 searches an internal shape codebook composed of quantity SQ of shape code vectors for each of L subbands, and finds the index of a shape code vector for which the result of Equation (6) below is a maximum.

$$Shape\_q(i) = \frac{\left\{ \sum_{k=0}^{W(j)} (X_{k+B(j)} \cdot SC_k^i) \right\}^2}{\sum_{k=0}^{W(j)} SC_k^i \cdot SC_k^i} \quad (j = j", \cdots, j"+L-1, \ i = 0, \cdots, SQ-1)$$

$$\ldots(\text{Equation 6})$$

In this equation, $SC_k^i$ indicates a shape code vector composing a shape codebook, i indicates a shape code vector index, and k indicates the index of a shape code vector element.

Shape quantization section 103 outputs shape code vector index S_max for which the result of Equation (6) above is a maximum to multiplexing section 106 as shape encoded information. Shape quantization section 103 also calculates ideal gain value Gain_i (j) in accordance with Equation (7) below, and outputs this to gain quantization section 105.

$$Gain\_i(j) = \frac{\sum_{k=0}^{W(j)}\left(X_{k+B(j)} \cdot SC_k^{S\_max}\right)}{\sum_{k=0}^{W(j)} SC_{k+B(j)}^{S\_max} \cdot SC_{k+B(j)}^{S\_max}} \quad (j = j'', \cdots, j''+L-1)$$

$$\ldots(\text{Equation } 7)$$

Predictive encoding execution/non-execution decision section 104 has an internal buffer that stores band information m_max input from band selection section 102 in a past frame. Here, a case will be described by way of example in which predictive encoding execution/non-execution decision section 104 has an internal buffer that stores band information m_max for the past three frames. Predictive encoding execution/non-execution decision section 104 first finds a number of subbands common to a past-frame quantization target band and current-frame quantization target band using band information m_max input from band selection section 102 in a past frame and band information m_max input from band selection section 102 in the current frame. Then predictive encoding execution/non-execution decision section 104 determines that predictive encoding is to be performed if the number of common subbands is greater than or equal to a predetermined value, or determines that predictive encoding is not to be performed if the number of common subbands is less than the predeterminedvalue. Specifically, L subbands indicated by band information m_max input from band selection section 102 one frame back in time are compared with L subbands indicated by band information m_max input from band selection section 102 in the current frame, and it is determined that predictive encoding is to be performed if the number of common subbands is P or more, or it is determined that predictive encoding is not to be performed if the number of common subbands is less than P. Predictive encoding execution/non-execution decision section 104 outputs the result of this determination to gain quantization section 105. Then predictive encoding execution/non-execution decision section 104 updates the internal buffer storing band information using band information m_max input from band selection section 102 in the current frame.

Gain quantization section 105 has an internal buffer that stores a quantization gain value obtained in a past frame. If a determination result input from predictive encoding execution/non-execution decision section 104 indicates that predictive encoding is to be performed, gain quantization section 105 performs quantization by predicting a current-frame gain value using past-frame quantization gain value $C_j^t$ stored in the internal buffer. Specifically, gain quantization section 105 searches an internal gain codebook composed of quantity GQ of gain code vectors for each of L subbands, and finds an index of a gain code vector for which the result of Equation (8) below is a minimum.

$$Gain\_q(i) = \sum_{j=0}^{L-1}\left\{Gain\_i(j+j'') - \sum_{t=1}^{3}\left(\alpha_t \cdot C_{j+j''}^t\right) - \alpha_0 \cdot GC_j^i\right\}^2 \quad (i = 0, \cdots, GQ-1)$$

$$\ldots(\text{Equation } 8)$$

In this equation, $GC_j^i$ indicates a gain code vector composing a gain codebook, i indicates a gain code vector index, and j indicates an index of a gain code vector element. For example, if the number of subbands composing a region is five (L=5), j has a value of 0 to 4. Here, $C_j^t$ indicates a gain value of t frames before in time, so that when t=1, for example, $C_j^t$ indicates a gain value of one frame before in time. Also, $\alpha$ is a 4th-order linear prediction coefficient stored in gain quantization section 105. Gain quantization section 105 treats L subbands within one region as an L-dimensional vector, and performs vector quantization.

Gain quantization section 105 outputs gain code vector index G_min for which the result of Equation (8) above is a minimum to multiplexing section 106 as gain encoded information. If there is no gain value of a subband corresponding to a past frame in the internal buffer, gain quantization section 105 substitutes the gain value of the nearest subband in frequency in the internal buffer in Equation (8) above.

On the other hand, if the determination result input from predictive encoding execution/non-execution decision section 104 indicates that predictive encoding is not to be performed, gain quantization section 105 directly quantizes ideal gain value Gain_i (j) input from shape quantization section 103 in accordance with Equation (9) below. Here, gain quantization section 105 treats an ideal gain value as an L-dimensional vector, and performs vector quantization.

$$Gain\_q(i) = \sum_{j=0}^{L-1}\left\{Gain\_i(j+j'') - GC_j^i\right\}^2 \quad (i = 0, \cdots, GQ - 1) \ . \ . \ . \ \text{(Equation 9)}$$

Here, a codebook index that makes Equation (9) above a minimum is denoted by G_min.

Gain quantization section 105 outputs G_min to multiplexing section 106 as gain encoded information. Gain quantization section 105 also updates the internal buffer in accordance with Equation (10) below using gain encoded information G_min and quantization gain value $C_j^t$ obtained in the current frame.

$$\begin{cases} C_{j+j''}^3 = C_{j+j''}^2 \\ C_{j+j''}^2 = C_{j+j''}^1 \qquad (j = 0, \cdots, L-1) \\ C_{j+j''}^1 = GC_j^{G\_min} \end{cases} \qquad \text{...(Equation 10)}$$

Multiplexing section 106 multiplexes band information m_max input from band selection section 102, shape encoded information S_max input from shape quantization section 103, and gain encoded information G_min input from gain quantization section 105, and transmits the obtained bit stream to a speech decoding apparatus.

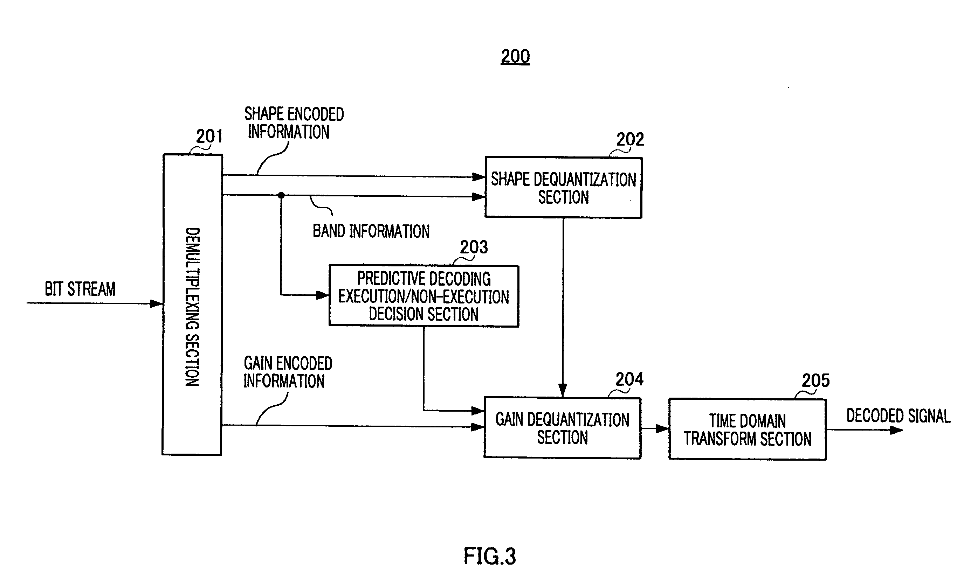

FIG.3 is a block diagram showing the main configuration of speech decoding apparatus 200 according to this embodiment.

In this figure, speech decoding apparatus 200 is equipped with demultiplexing section 201, shape dequantization section 202, predictive decoding execution/non-execution decision section 203, gain dequantization section 204, and time domain transform section 205.

Demultiplexing section 201 demultiplexes band information, shape encoded information, and gain encoded information from a bit stream transmitted from speech encoding apparatus 100, outputs the obtained band information to shape dequantization section 202 and predictive decoding execution/non-execution decision section 203, outputs the obtained shape encoded information to shape dequantization section 202, and outputs the obtained gain encoded information to gain dequantization section 204.

Shape dequantization section 202 finds the shape value of an MDCT coefficient corresponding to a quantization target band indicated by band information input from demultiplexing section 201 by performing dequantization of shape encoded information input from demultiplexing section 201, and outputs the found shape value to gain dequantization section 204.

Predictive decoding execution/non-execution decision section 203 finds a number of subbands common to a current-frame quantization target band and a past-frame quantization target band using the band information input from demultiplexing section 201. Then predictive decoding execution/non-execution decision section 203 determines that predictive decoding is to be performed on the MDCT coefficient of the quantization target band indicated by the band information if the number of common subbands is greater than or equal to a predetermined value, or determines that predictive decoding is not to be performed on the MDCT coefficient of the quantization target band indicated by the band information if the number of common subbands is less than the predetermined value. Predictive decoding execution/non-execution decision section 203 outputs the result of this determination to gain dequantization section 204.

If the determination result input from predictive decoding execution/non-execution decision section 203 indicates that predictive decoding is to be performed, gain dequantization section 204 performs predictive decoding on gain encoded information input from demultiplexing section 201 using a past-frame gain value stored in an internal buffer and an internal gain codebook, to obtain a gain value. On the other hand, if the determination result input from predictive decoding execution/non-execution decision section 203 indicates that predictive decoding is not to be performed, gain dequantization section 204 obtains a gain value by directly performing dequantization of gain encoded information input from demultiplexing section 201 using the internal gain codebook. Gain dequantization section 204 outputs the obtained gain value to time domain transform section 205. Gain dequantization section 204 also finds an MDCT coefficient of the quantization target band using the obtained gain value and a shape value input from shape dequantization section 202, and outputs this to time domain transform section 205 as a decoded MDCT coefficient.

Time domain transform section 205 performs an Inverse Modified Discrete Cosine Transform (IMDCT) on the decoded MDCT coefficient input from gain dequantization section 204 to generate a time domain signal, and outputs this as a decoded signal.

Speech decoding apparatus 200 having a configuration such as described above performs the following operations.

Demultiplexing section 201 demultiplexes band information m_max, shape encoded information S_max, and gain encoded information G_min from a bit stream transmitted from speech encoding apparatus 100, outputs obtained band information m_max to shape dequantization section 202 and predictive decoding execution/non-execution decision section 203, outputs obtained shape encoded information S_max to shape dequantization section 202, and outputs obtained gain encoded information G_min to gain dequantization section 204.

Shape dequantization section 202 has an internal shape codebook similar to the shape codebook with which shape quantization section 103 of speech encoding apparatus 100 is provided, and searches for a shape code vector for which shape encoded information S_max input from demultiplexing section 201 is an index. Shape dequantization section 202 outputs a searched code vector to gain dequantization section 204 as the shape value of an MDCT coefficient of a quantization target band indicated by band information m_max input from demultiplexing section 201. Here, a shape code vector searched as a shape value is denoted by Shape_q(k) (k = B(j"), ..., B(j"+L)-1) .

Predictive decoding execution/non-execution decision section 203 has an internal buffer that stores band information m_max input from demultiplexing section 201 in a past frame. Here, a case will be described by way of example in which predictive decoding execution/non-execution decision section 203 has an internal buffer that stores band information m_max for the past three frames. Predictive decoding execution/non-execution decision section 203 first finds a number of subbands common to a past-frame quantization target band and current-frame quantization target band using band information m_max input from demultiplexing section 201 in a past frame and band information m_max input fromdemultiplexing section 201 in the current frame. Then predictive decoding execution/non-execution decision section 203 determines that predictive decoding is to be performed if the number of common subbands is greater than or equal to a predetermined value, or determines that predictive decoding is not to be performed if the number of common subbands is less than the predetermined value. Specifically, predictive decoding execution/non-execution decision section 203 compares L subbands indicated by band information m_max input from demultiplexing section 201 one frame back in time with L subbands indicated by band information m_max input from demultiplexing section 201 in the current frame, and determines that predictive decoding is to be performed if the number of common subbands is P or more, or determines that predictive decoding is not to be performed if the number of common subbands is less than P. Predictive decoding execution/non-execution decision section 203 outputs the result of this determination to gain dequantization section 204. Then predictive decoding execution/non-execution decision section 203 updates the internal buffer storing band information using band information m_max input from demultiplexing section 201 in the current frame.

Gain dequantization section 204 has an internal buffer that stores a gain value obtained in a past frame. If a determination result input from predictive decoding execution/non-execution decision section 203 indicates that predictive decoding is to be performed, gain dequantization section 204 performs dequantization by predicting a current-frame gain value using a past-frame gain value stored in the internal buffer. Specifically, gain dequantization section 204 has the same kind of internal gain codebook as gain quantization section 105 of speech encoding apparatus 100, and obtains gain value Gain_q' by performing gain dequantization in accordance with Equation (11) below. Here, $C''_j$ indicates a gain value of t frames before in time, so that when t=1, for example, $C''_j$ indicates a gain value of one frame before in time. Also, $\alpha$ is a 4th-order linear prediction coefficient stored in gain dequantization section 204. Gain dequantization section 204 treats L subbands within one region as an L-dimensional vector, and performs vector dequantization.

$$Gain\_q'(j + j") = \sum_{t=1}^{3}\left(\alpha_t \cdot C'''_{j+j"}\right) + \alpha_0 \cdot GC_j^{G\text{-}min} \quad (j = 0, \cdots, L-1)$$

$$...(Equation\ 11)$$

If there is no gain value of a subband corresponding to a past frame in the internal buffer, gain dequantization section 204 substitutes the gain value of the nearest subband in frequency in the internal buffer in Equation (11) above.

On the other hand, if the determination result input from predictive decoding execution/non-execution decision section 203 indicates that predictive decoding is not to be performed, gain dequantization section 204 performs dequantization of a gain value in accordance with Equation (12) below using the above-described gain codebook. Here, a gain value is treated as an L-dimensional vector, and vector dequantization is performed. That is to say, when predictive decoding is not performed, gain code vector $GC_j^{G\text{-}min}$ corresponding to gain encoded information G_min is taken directly as a gain value.

$$Gain\_q'(j+j'') = GC_j^{G-\min} \quad (j=0,\cdots,L-1) \qquad \ldots (\text{Equation } 12)$$

Next, gain dequantization section 204 calculates a decoded MDCT coefficient in accordance with Equation (13) below using a gain value obtained by current-frame dequantization and a shape value input from shape dequantization section 202, and updates the internal buffer in accordance with Equation (14) below. Here, a calculated decoded MDCT coefficient is denoted by $X''_k$. Also, in MDCT coefficient dequantization, if k is present within B(j'') through B(j''+1)-1, gain value Gain_q'(j) takes the value of Gain_q'(j'').

$$X''_k = Gain\_q'(j) \cdot Shape\_q'(k) \begin{pmatrix} k = B(j''),\cdots,B(j''+L)-1 \\ j = j'',\cdots,j''+L-1 \end{pmatrix} \ldots (\text{Equation } 13)$$

$$\begin{cases} C''^3_j = C''^2_j \\ C''^2_j = C''^1_j \qquad (j=j'',\cdots,j''+L-1) \qquad \ldots (\text{Equation } 14) \\ C''^1_j = Gain\_q'(j) \end{cases}$$

Gain dequantization section 204 outputs decoded MDCT coefficient $X''_k$ calculated in accordance with Equation (13) above to time domain transform section 205.
Time domain transform section 205 first initializes internal buffer $buf'_k$ to a value of zero in accordance with Equation (15) below.

$$buf'_k = 0 \quad (k=0,\cdots,N-1) \qquad \ldots (\text{Equation } 15)$$

Then time domain transform section 205 finds decoded signal $Y_n$ in accordance with Equation (16) below using decoded MDCT coefficient $X''_k$ input from gain dequantization section 204.

$$Y_n = \frac{2}{N} \sum_{n=0}^{2N-1} X2''_k \cos\left[\frac{(2n+1+N)(2k+1)\pi}{4N}\right] \quad (n=0,\cdots,N-1)$$

$$\ldots (\text{Equation } 16)$$

In this equation, $X2''_k$ is a vector linking decoded MDCT coefficient $X''_k$ and buffer $buf'_k$.

$$X2''_k = \begin{cases} buf'_k & (k=0,\cdots N-1) \\ X''_k & (k=N,\cdots 2N-1) \end{cases} \ldots (\text{Equation } 17)$$

Next, time domain transform section 205 updates buffer $buf'_k$ in accordance with Equation (18) below.

$$buf'_k = X''_k \quad (k=0,\cdots N-1) \quad \ldots (\text{Equation } 18)$$

Time domain transform section 205 outputs obtained decoded signal $Y_n$ as an output signal.

Thus, according to this embodiment, a high-energy band is selected in each frame as a quantization target band and a frequency domain parameter is quantized, enabling bias to be created in quantized gain value distribution, and vector quantization performance to be improved.

Also, according to this embodiment, in frequency domain parameter quantization of a different quantization target band of each frame, predictive encoding is performed on a frequency domain parameter if the number of subbands common to a past-frame quantization target band and current-frame quantization target band is determined to be greater than or equal to a predetermined value, and a frequency domain parameter is encoded directly if the number of common subbands is determined to be less than the predetermined value. Consequently, the encoded information amount in speech encoding is reduced, and also sharp speech quality degradation can be prevented, and speech/audio signal encoding error and decoded signal audio quality degradation can be reduced.

Furthermore, according to this embodiment, on the encoding side a quantization target band can be decided, and frequency domain parameter quantization performed, in region units each composed of a plurality of subbands, and information as to a frequency domain parameter of which region has become a quantization target can be transmitted to the decoding side. Consequently, quantization efficiency can be improved and the encoded information amount transmitted to the decoding side can be further reduced as compared with deciding whether or not predictive encoding is to be used on a subband-by-subband basis and transmitting information as to which subband has become a quantization target to the decoding side.

In this embodiment, a case has been described by way of example in which gain quantization is performed in region units each composed of a plurality of subbands. A quantization target may also be selected on a subband-by-subband basis - that is, determination of whether or not predictive quantization is to be carried out may also be performed on a subband-by-subband basis.

In this embodiment, a case has been described by way of example in which the gain predictive quantization method is to perform linear prediction in the time domain for gain of the same frequency band, but the present invention is not limited to this, and linear prediction may also be performed in the time domain for gain of different frequency bands.

In this embodiment, a case has been described in which an ordinary speech/audio signal is taken as an example of a signal that becomes a quantization target, but the present invention is not limited to this, and an excitation signal obtained by processing a speech/audio signal by means of an LPC (Linear Prediction Coefficient) inverse filter may also be used as a quantization target.

In this embodiment, a case has been described by way of example in which a region for which the magnitude of individual region energy - that is, perceptual significance - is greatest is selected as a reference for selecting a quantization target band, but the present invention is not limited to this, and in addition to perceptual significance, frequency correlation with a band selected in a past frame may also be taken into consideration at the same time. That is to say, if candidate bands exist for which the number of subbands common to a quantization target band selected in the past is greater than or equal to a predetermined value and energy is greater than or equal to a predetermined value, the band with the highest energy among the above candidate bands may be selected as the quantization target band, and if no such candidate bands exist, the band with the highest energy among all frequency bands may be selected as the quantization target band. For example, if a subband common to the highest-energy region and a band selected in a past frame does not exist, the number of subbands common to the second-highest-energy region and a band selected in a past frame is greater than or equal to a predetermined threshold value, and the energy of the second-highest-energy region is greater than or equal to a predetermined threshold value, the second-highest-energy region is selected rather than the highest-energy region. Also, a band selection section according to this embodiment selects a region closest to a quantization target band selected in the past from among regions whose energy is greater than or equal to a predetermined value as a quantization target band.

In this embodiment, MDCT coefficient quantization may be performed after interpolation is performed using a past frame. For example, a case will be described with reference to FIG.2 in which a past-frame quantization target band is region 3 (that is, subbands 5 through 9), a current-frame quantization target band is region 4 (that is, subbands 6 through 10), and current-frame predictive encoding is performed using a past-frame quantization result. In such a case, predictive encoding is performed on current-frame subbands 6 through 9 using past-frame subbands 6 through 9, and for current-frame subband 10, past-frame subband 10 is interpolated using past-frame subbands 6 through 9, and then predictive encoding is performed using past-frame subband 10 obtained by interpolation.

In this embodiment, a case has been described by way of example in which quantization is performed using the same codebook irrespective of whether or not predictive encoding is performed, but the present invention is not limited to this, and different codebooks may also be used according to whether predictive encoding is performed or is not performed in gain quantization and in shape quantization.

In this embodiment, a case has been described by way of example in which all subband widths are the same, but the present invention is not limited to this, and individual subband widths may also differ.

In this embodiment, a case has been described by way of example in which the same codebook is used for all subbands in gain quantization and in shape quantization, but the present invention is not limited to this, and different codebooks may also be used on a subband-by-subband basis in gain quantization and in shape quantization.

In this embodiment, a case has been described by way of example in which consecutive subbands are selected as a quantization target band A nonconsecutive plurality of subbands may also be selected as a quantization target band. In such a case, speech encoding efficiency can be further improved by interpolating an unselected subband value using adjacent subband values.

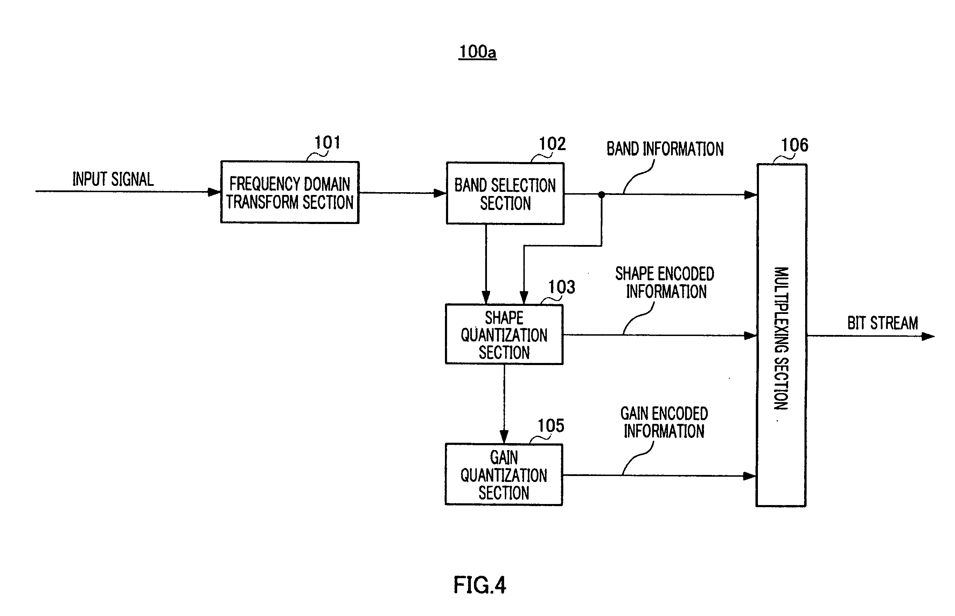

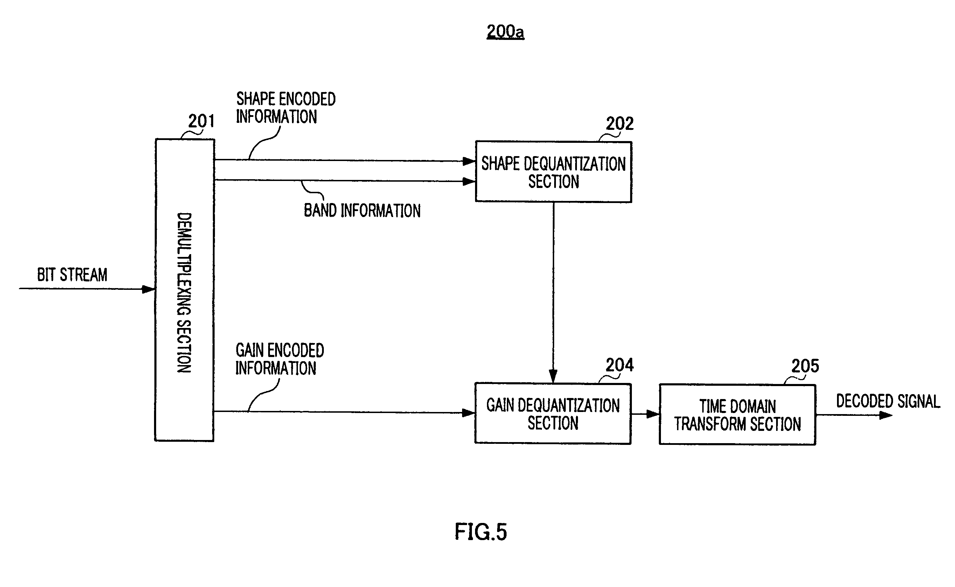

In this embodiment, a case has been described by way of example in which speech encoding apparatus 100 is equipped with predictive encoding execution/non-execution decision section 104. A speech encoding apparatus is not limited to this and may also have a configuration in which predictive encoding execution/non-execution decision section 104 is not provided and predictive quantization is not always performed by gain quantization section 105, as illustrated by speech encoding apparatus 100a shown in FIG.4. In this case, as shown in FIG.4, speech encoding apparatus 100a is equipped with frequency domain transform section 101, band selection section 102, shape quantization section 103, gain quantization section 105, and multiplexing section 106. FIG.5 is a block diagram showing the configuration of speech decoding apparatus 200a corresponding to speech encoding apparatus 100a, speech decoding apparatus 200a being equipped with demultiplexing section 201, shape dequantization section 202, gain dequantization section 204, and time domain transform section 205. In such a case, speech encoding apparatus 100a performs partial selection of a band to be quantized from among all bands, further divides the selected band into a plurality of subbands, and quantizes the gain of each subband. By this means, quantization can be performed at a lower bit rate than with a method whereby components of all bands are quantized, and encoding efficiency can be improved. Also, encoding efficiency can be further improved by quantizing a gain vector using gain correlation in the frequency domain.

A speech encoding apparatus may also have a configuration in which predictive encoding execution/non-execution decision section 104 is not provided and predictive quantization is always performed by gain quantization section 105, as illustrated by speech encoding apparatus 100a shown in FIG. 4. The configuration of speech decoding apparatus 200a corresponding to this kind of speech encoding apparatus 100a is as shown in FIG. 5. In such a case, speech encoding apparatus 100a performs partial selection of a band to be quantized from among all bands, further divides the selected band into a plurality of subbands, and performs gain quantization for each subband. By this means, quantization can be performed at a lower bit rate than with a method whereby components of all bands are quantized, and encoding efficiency can be improved. Also, encoding efficiency can be further improved by predictive quantizing a gain vector using gain correlation in the time domain.

In this embodiment, a case has been described by way of example in which the method of selecting a quantization target band in a band selection section is to select the region with the highest energy in all bands, but the present invention is not limited to this, and selection may also be performed using information of a band selected in a temporally preceding frame in addition to the above criterion. For example, a possible method is to select a region to be quantized after performing multiplication by a weight such that a region that includes a band in the vicinity of a band selected in a temporally preceding frame becomes more prone to selection. Also, if there are a plurality of layers in which a band to be quantized is selected, a band quantized in an upper layer may be selected using information of a band selected in a lower layer. For example, a possible method is to select a region to be quantized after performing multiplication by a weight such that a region that includes a band in the vicinity of a band selected in a lower layer becomes more prone to selection.

In this embodiment, a case has been described by way of example in which the method of selecting a quantization target band is to select the region with the highest energy in all bands, but the present invention is not limited to this, and a certain band may also be preliminarily selected beforehand, after which a quantization target band is finally selected in the preliminarily selected band. In such a case, a preliminarily selected band may be decided according to the input signal sampling rate, coding bit rate, or the like. For example, one method is to select a low band preliminarily when the bit rate or sampling rate is low.

For example, it is possible for a method to be employed in band selection section 102 whereby a region to be quantized is decided by calculating region energy after limiting selectable regions to low-band regions from among all selectable region candidates. As an example of this, a possible method is to perform limiting to five candidates from the low-band side from among the total of eight candidate regions shown in FIG. 2, and select the region with the highest energy among these. Alternatively, band selection section 102 may compare energies after multiplying energy by a weight so that a lower-area region becomes proportionally more prone to selection. Another possibility is for band selection section 102 to select a fixed low-band-side subband. A feature of a speech signal is that the harmonics structure becomes proportionally stronger toward the low-band side, as a result of which a strong peak is present on the low-band side. As this strong peak is difficult to mask, it is prone to be perceived as noise. Here, by increasing the likelihood of selection toward the low-band side rather than simply selecting a region based on energy magnitude, the possibility of a region that includes a strong peak being selected is increased, and a sense of noise is reduced as a result. Thus, the quality of a decoded signal can be improved by limiting selected regions to the low-band side, or performing multiplication by a weight such that the likelihood of selection increases toward the low-band side, in this way.

A speech encoding apparatus according to the present invention has been described in terms of a configuration whereby shape (shape information) quantization is first performed on a component of a band to be quantized, followed by gain (gain information) quantization, but the present invention is not limited to this, and a configuration may also be used whereby gain quantization is performed first, followed by shape quantization.

(Embodiment 2)

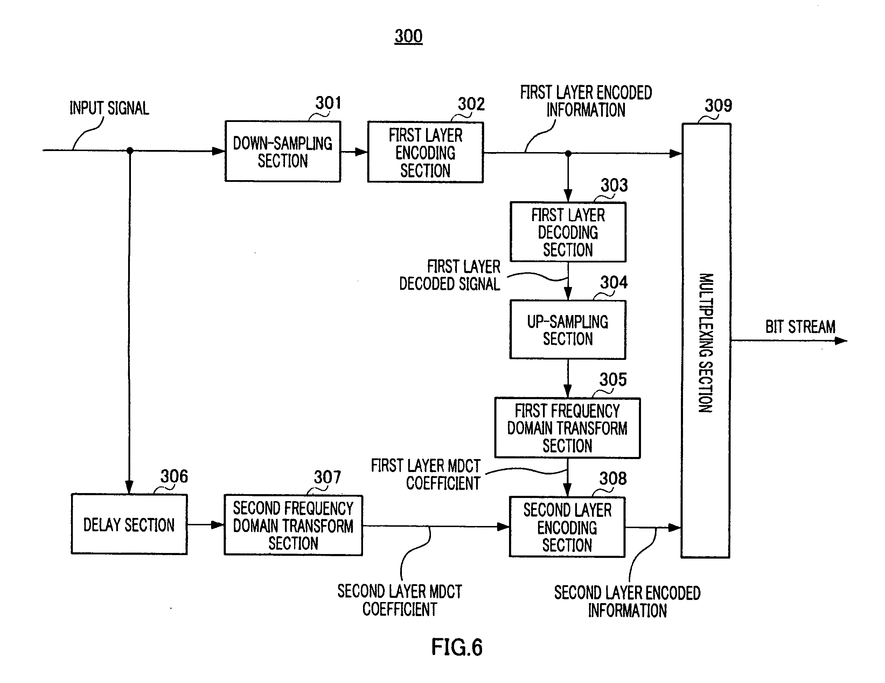

FIG.6 is a block diagram showing the main configuration of speech encoding apparatus 300 according to Embodiment 2 of the present invention.

In this figure, speech encoding apparatus 300 is equipped with down-sampling section 301, first layer encoding section 302, first layer decoding section 303, up-sampling section 304, first frequency domain transform section 305, delay section 306, second frequency domain transform section 307, second layer encoding section 308, and multiplexing section 309, and has a scalable configuration comprising two layers. In the first layer, a CELP (Code Excited Linear Prediction) speech encoding method is applied, and in the second layer, the speech encoding method described in Embodiment 1 of the present invention is applied.

Down-sampling section 301 performs down-sampling processing on an input speech/audio signal, to convert the speech/audio signal sampling rate from Rate 1 to Rate 2 (where Rate 1 > Rate 2), and outputs this signal to first layer encoding section 302.

First layer encoding section 302 performs CELP speech encoding on the post-down-sampling speech/audio signal input from down-sampling section 301, and outputs obtained first layer encoded information to first layer decoding section 303 and multiplexing section 309. Specifically, first layer encoding section 302 encodes a speech signal comprising vocal tract information and excitation information by finding an LPC parameter for the vocal tract information, and for the excitation information, performs encoding by finding an index that identifies which previously stored speech model is to be used-that is, an index that identifies which excitation vector of an adaptive codebook and fixed codebook is to be generated.

First layer decoding section 303 performs CELP speech decoding on first layer encoded information input from first layer encoding section 302, and outputs an obtained first layer decoded signal to up-sampling section 304.

Up-sampling section 304 performs up-sampling processing on the first layer decoded signal input from first layer decoding section 303, to convert the first layer decoded signal sampling rate from Rate 2 to Rate 1, and outputs this signal to first frequency domain transform section 305.

First frequency domain transform section 305 performs an MDCT on the post-up-sampling first layer decoded signal input from up-sampling section 304, and outputs a first layer MDCT coefficient obtained as a frequency domain parameter to second layer encoding section 308. The actual transform method used in first frequency domain transform section 305 is similar to the transform method used in frequency domain transform section 101 of speech encoding apparatus 100 according to Embodiment 1 of the present invention, and therefore a description thereof is omitted here.

Delay section 306 outputs a delayed speech/audio signal to second frequency domain transform section 307 by outputting an input speech/audio signal after storing that input signal in an internal buffer for a predetermined time. The predetermined delay time here is a time that takes account of algorithm delay that arises in down-sampling section 301, first layer encoding section 302, first layer decoding section 303, up-sampling section 304, first frequency domain transform section 305, and second frequency domain transform section 307.

Second frequency domain transform section 307 performs an MDCT on the delayed speech/audio signal input from delay section 306, and outputs a second layer MDCT coefficient obtained as a frequency domain parameter to second layer encoding section 308. The actual transform method used in second frequency domain transform section 307 is similar to the transform method used in frequency domain transform section 101 of speech encoding apparatus 100 according to Embodiment 1 of the present invention, and therefore a description thereof is omitted here.

Second layer encoding section 308 performs second layer encoding using the first layer MDCT coefficient input from first frequency domain transform section 305 and the second layer MDCT coefficient input from second frequency domain transform section 307, and outputs obtained second layer encoded information to multiplexing section 309. The main internal configuration and actual operation of second layer encoding section 308 will be described later herein.

Multiplexing section 309 multiplexes first layer encoded information input from first layer encoding section 302 and second layer encoded information input from second layer encoding section 308, and transmits the obtained bit stream to a speech decoding apparatus.

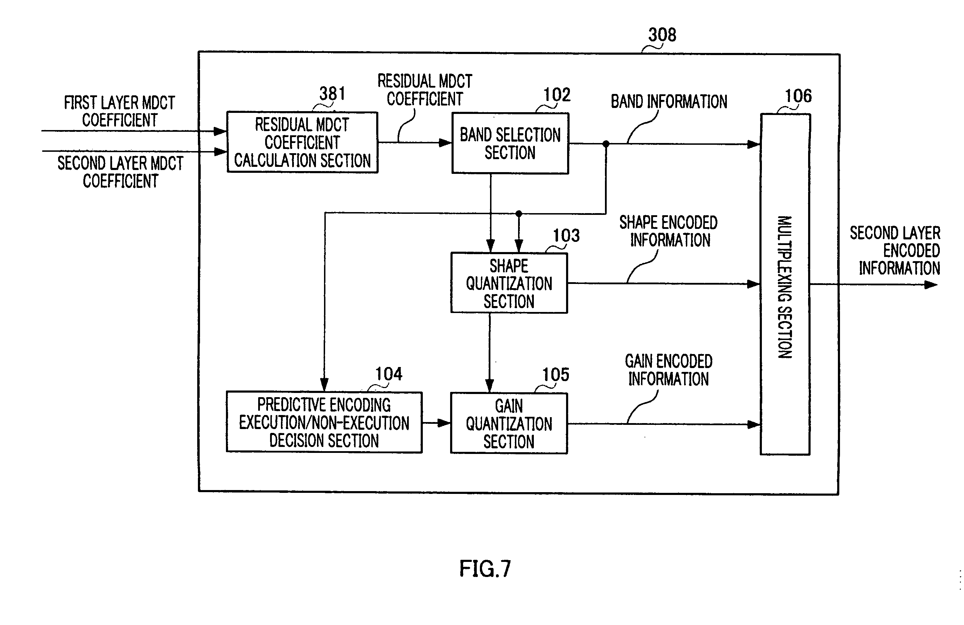

FIG.7 is a block diagram showing the main configuration of the interior of second layer encoding section 308. Second layer encoding section 308 has a similar basic configuration to that of speech encoding apparatus 100 according to Embodiment 1 (see FIG. 1), and therefore identical configuration elements are assigned the same reference codes and descriptions thereof are omitted here.

Second layer encoding section 308 differs from speech encoding apparatus 100 in being equipped with residual MDCT coefficient calculation section 381 instead of frequency domain transform section 101. Processing by multiplexing section 106 is similar to processing by multiplexing section 106 of speech encoding apparatus 100, and for the sake of the description, the name of a signal output from multiplexing section 106 according to this embodiment is given as "second layer encoded information".

Band information, shape encoded information, and gain encoded information may also be input directly to multiplexing section 309 and multiplexed with first layer encoded information without passing through multiplexing section 106.

Residual MDCT coefficient calculation section 381 finds a residue of the first layer MDCT coefficient input from first frequency domain transform section 305 and the second layer MDCT coefficient input from second frequency domain transform section 307, and outputs this to band selection section 102 as a residual MDCT coefficient.

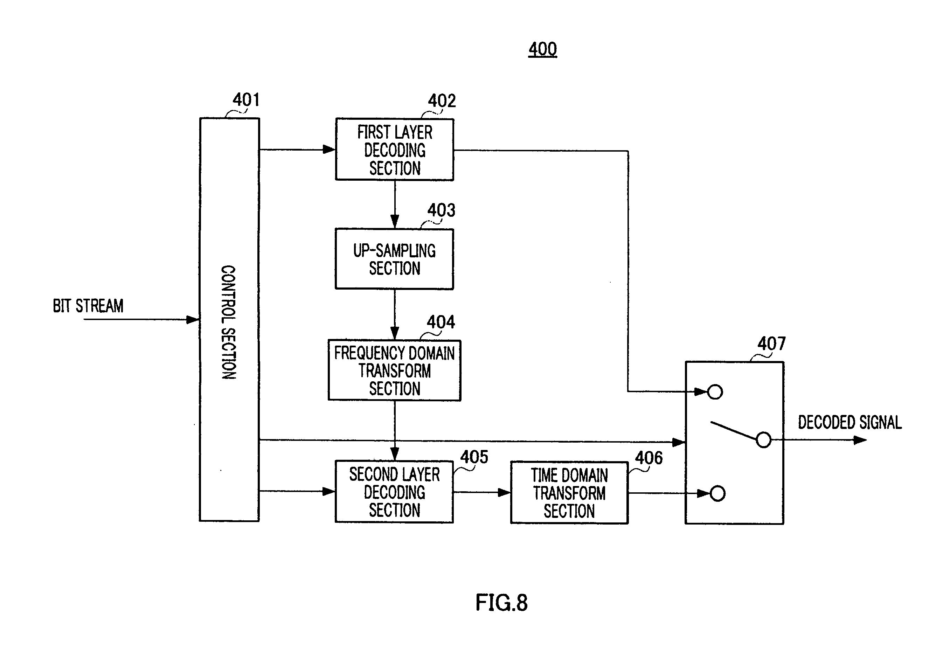

FIG.8 is a block diagram showing the main configuration of speech decoding apparatus 400 according to Embodiment 2 of the present invention.

In this figure, speech decoding apparatus 400 is equipped with control section 401, first layer decoding section 402, up-sampling section 403, frequency domain transform section 404, second layer decoding section 405, time domain transform section 406, and switch 407.

Control section 401 analyzes configuration elements of a bit stream transmitted from speech encoding apparatus 300, and according to these bit stream configuration elements, adaptively outputs appropriate encoded information to first layer decoding section 402 and second layer decoding section 405, and also outputs control information to switch 407. Specifically, if the bit stream comprises first layer encoded information and second layer encoded information, control section 401 outputs the first layer encoded information to first layer decoding section 402 and outputs the second layer encoded information to second layer decoding section 405, whereas if the bit stream comprises only first layer encoded information, control section 401 outputs this first layer encoded information to first layer decoding section 402.

First layer decoding section 402 performs CELP decoding on first layer encoded information input from control section 401, and outputs the obtained first layer decoded signal to up-sampling section 403 and switch 407.

Up-sampling section 403 performs up-sampling processing on the first layer decoded signal input from first layer decoding section 402, to convert the first layer decoded signal sampling rate from Rate 2 to Rate 1, and outputs this signal to frequency domain transform section 404.

Frequency domain transform section 404 performs an MDCT on the post-up-sampling first layer decoded signal input from up-sampling section 403, and outputs a first layer decoded MDCT coefficient obtained as a frequency domain parameter to second layer decoding section 405. The actual transform method used in frequency domain transform section 404 is similar to the transform method used in frequency domain transform section 101 of speech encoding apparatus 100 according to Embodiment 1, and therefore a description thereof is omitted here.

Second layer decoding section 405 performs gain dequantization and shape dequantization using the second layer encoded information input from control section 401 and the first layer decoded MDCT coefficient input from frequency domain transform section 404, to obtain a second layer decoded MDCT coefficient. Second layer decoding section 405 adds together the obtained second layer decoded MDCT coefficient and first layer decoded MDCT coefficient, and outputs the obtained addition result to time domain transform section 406 as an addition MDCT coefficient. The main internal configuration and actual operation of second layer decoding section 405 will be described later herein.

Time domain transform section 406 performs an IMDCT on the addition MDCT coefficient input from second layer decoding section 405, and outputs a second layer decoded signal obtained as a time domain component to switch 407.

Based on control information input from control section 401, if the bit stream input to speech decoding apparatus 400 comprises first layer encoded information and second layer encoded information, switch 407 outputs the second layer decoded signal input from time domain transform section 406 as an output signal, whereas if the bit stream comprises only first layer encoded information, switch 407 outputs the first layer decoded signal input from first layer decoding section 402 as an output signal.

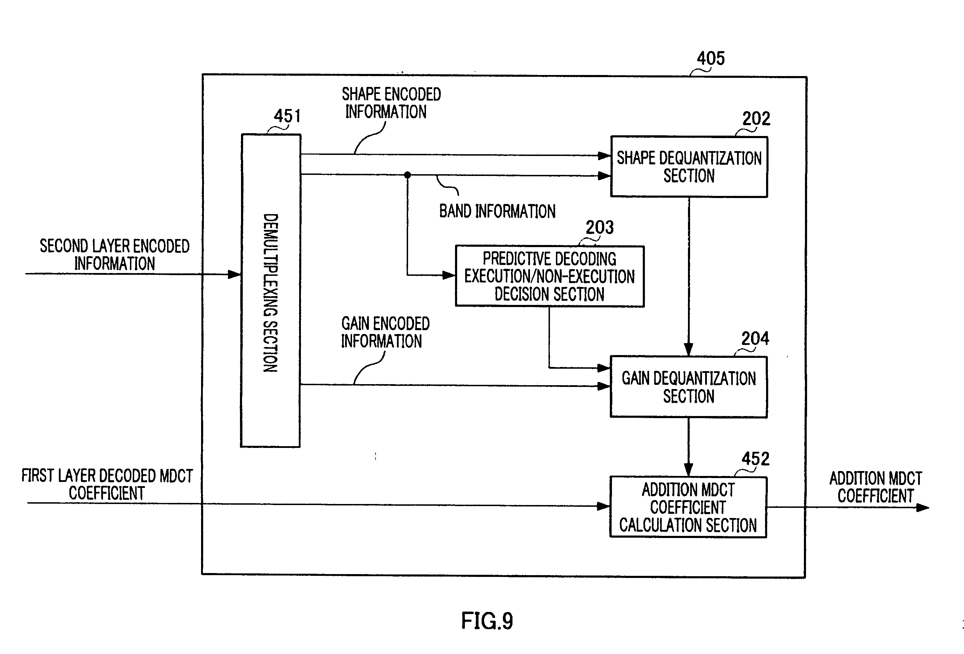

FIG.9 is a block diagram showing the main configuration of the interior of second layer decoding section 405. Second layer decoding section 405 has a similar basic configuration to that of speech decoding apparatus 200 according to Embodiment 1 (see FIG. 3), and therefore identical configuration elements are assigned the same reference codes and descriptions thereof are omitted here.

Second layer decoding section 405 differs from speech decoding apparatus 200 in being further equipped with addition MDCT coefficient calculation section 452. Also, processing differs in part between demultiplexing section 451 of second layer decoding section 405 and demultiplexing section 201 of speech decoding apparatus 200, and a different reference code is assigned to indicate this.

Demultiplexing section 451 demultiplexes band information, shape encoded information, and gain encoded information from second layer encoded information input from control section 401, and outputs the obtained band information to shape dequantization section 202 and predictive decoding execution/non-execution decision section 203, the obtained shape encoded information to shape dequantization section 202, and the obtained gain encoded information to gain dequantization section 204.

Addition MDCT coefficient calculation section 452 adds together the first layer decoded MDCT coefficient input from frequency domain transform section 404 and the second layer decoded MDCT coefficient input from gain dequantization section 204, and outputs the obtained addition result to time domain transform section 406 as an addition MDCT coefficient.

Thus, according to this embodiment, when a frequency component of a different band is made a quantization target in each frame, non-temporal parameter predictive encoding is performed adaptively in addition to applying scalable encoding, thereby enabling the encoded information amount in speech encoding to be reduced, and speech/audio signal encoding error and decoded signal audio quality degradation to be reduced.

In this embodiment, a case has been described by way of example in which second layer encoding section 308 takes a difference component of a first layer MDCT coefficient and second layer MDCT coefficient as an encoding target, but the present invention is not limited to this, and second layer encoding section 308 may also take a difference component of a first layer MDCT coefficient and second layer MDCT coefficient as an encoding target for a band of a predetermined frequency or below, or may take an input signal MDCT coefficient itself as an encoding target for a band higher than a predetermined frequency. That is to say, switching may be performed between use or non-use of a difference component according to the band.

In this embodiment, a case has been described by way of example in which the method of selecting a second layer encoding quantization target band is to select the region for which the energy of a residual component of a first layer MDCT coefficient and second layer MDCT coefficient is highest, but the present invention is not limited to this, and the region for which the first layer MDCT coefficient energy is highest may also be selected. For example, the energy of each first layer MDCT coefficient subband may be calculated, after which the energies of each subband are added together on a region-by-region basis, and the region for which energy is highest is selected as a second layer encoding quantization target band. On the decoding apparatus side, the region for which energy is highest among the regions of the first layer decoded MDCT coefficient obtained by first layer decoding is selected as a second layer decoding dequantization target band. By this means the coding bit rate can be reduced, since band information relating to a second layer encoding quantization band is not transmitted from the encoding apparatus side.

In this embodiment, a case has been described by way of example in which second layer encoding section 308 selects and performs quantization on a quantization target band for a residual component of a first layer MDCT coefficient and second layer MDCT coefficient, but the present invention is not limited to this, and second layer encoding section 308 may also predict a second layer MDCT coefficient from a first layer MDCT coefficient, and select and perform quantization on a quantization target band for a residual component of that predicted MDCT coefficient and an actual second layer MDCT coefficient. This enables encoding efficiency to be further improved by utilizing a correlation between a first layer MDCT coefficient and second layer MDCT coefficient.

(Embodiment 3)

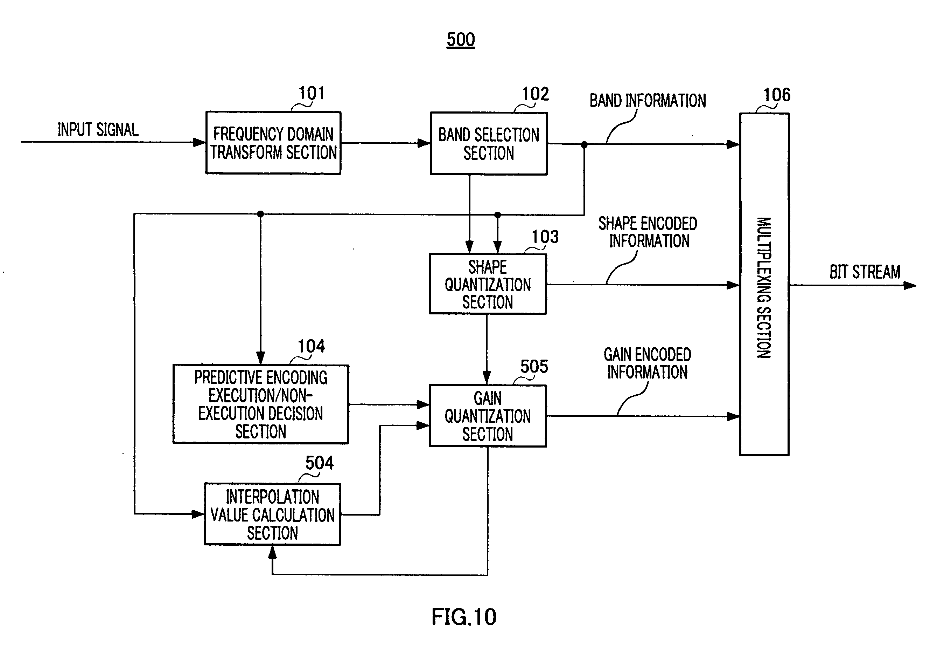

FIG.10 is a block diagram showing the main configuration of speech encoding apparatus 500 according to Embodiment 3 of the present invention. Speech encoding apparatus 500 has a similar basic configuration to that of speech encoding apparatus 100 shown in FIG.1, and therefore identical configuration elements are assigned the same reference codes and descriptions thereof are omitted here.

Speech encoding apparatus 500 differs from speech encoding apparatus 100 in being further equipped with interpolation value calculation section 504. Also, processing differs in part between gain quantization section 505 of speech encoding apparatus 500 and gain quantization section 105 of speech encoding apparatus 100, and a different reference code is assigned to indicate this.

Interpolation value calculation section 504 has an internal buffer that stores band information indicating a quantization target band of a past frame. Using a quantization gain value of a quantization target band of a past frame read from gain quantization section 505, interpolation value calculation section 504 interpolates a gain value of a band that was not quantized in a past frame among current-frame quantization target bands indicated by band information input from band selection section 102. Interpolation value calculation section 504 outputs an obtained gain interpolation value to gain quantization section 505.

Gain quantization section 505 differs from gain quantization section 105 of speech encoding apparatus 100 in using a gain interpolation value input from interpolation value calculation section 504 in addition to a past-frame quantization gain value stored in an internal buffer and an internal gain codebook when performing predictive encoding.

The gain value interpolation method used by interpolation value calculation section 504 will now be described in detail.

Interpolation value calculation section 504 has an internal buffer that stores band information m_max input from band selection section 102 in a past frame. Here, a case will be described by way of example in which an internal buffer is provided that stores band information m_max for the past three frames.

Interpolation value calculation section 504 first calculates a gain value of other than a band indicated by band information m_max for the past three frames by performing linear interpolation. An interpolation value is calculated in

accordance with Equation (19) for a gain value of a lower band than the band indicated by band information m_max, and an interpolation value is calculated in accordance with Equation (20) for a gain value of a higher band than the band indicated by band information m_max.

$$\beta_0 \cdot q_0 + \beta_1 \cdot q_1 + \beta_2 \cdot q_2 + \beta_3 \cdot g = 0 \qquad \ldots \text{(Equation 19)}$$

$$\beta_0' \cdot q_0 + \beta_1' \cdot q_1 + \beta_2' \cdot q_2 + \beta_3' \cdot g = 0 \qquad \ldots \text{(Equation 20)}$$

In Equation (19) and Equation (20), $\beta_i$ indicates an interpolation coefficient, $q_i$ indicates a gain value of a quantization target band indicated by band information m_max of a past frame, and g indicates a gain interpolation value of an unquantized band adjacent to a quantization target band indicated by band information m_max of a past frame. Here, a lower value of i indicates a proportionally lower-frequency band, and in Equation (19) g indicates a gain interpolation value of an adjacent band on the high-band side of a quantization target band indicated by band information m_max of a past frame, while in Equation (20) g indicates a gain interpolation value of an adjacent band on the low-band side of a quantization target band indicated by band information m_max of a past frame. For interpolation coefficient $\beta_i$, a value is assumed to be used that has been found beforehand statistically so as to satisfy Equation (19) and Equation (20). Here, a case is described in which different interpolation coefficients $\beta_i$ are used in Equation (19) and Equation (20), but a similar set of prediction coefficients $\alpha_i$ may also be used in Equation (19) and Equation (20).

As shown in Equation (19) and Equation (20), it is possible to interpolate a gain value of one band on the high-band side or the low-band side adjacent to a quantization target band indicated by past-frame band information m_max of a past frame in interpolation value calculation section 504. Interpolation value calculation section 504 successively interpolates gain values of adjacent unquantized bands by repeating the operations in Equation (19) and Equation (20) using the results obtained from Equation (19) and Equation (20).

In this way, interpolation value calculation section 504 interpolates gain values of bands other than a band indicated by band information m_max of the past three frames among current-frame quantization target bands indicated by band information input from band selection section 102, using quantized gain values of the past three frames read from gain quantization section 505.

Next, a predictive encoding operation in gain quantization section 505 will be described.

Gain quantization section 505 performs quantization by predicting a current-frame gain value using a stored past-frame quantization gain value, a gain interpolation value input from interpolation value calculation section 504, and an internal gain codebook. Specifically, gain quantization section 505 searches an internal gain codebook composed of quantity GQ of gain code vectors for each of L subbands, and finds an index of a gain code vector for which the result of Equation (21) below is a minimum.

$$Gain\_q(i) = \sum_{j=0}^{L-1} \left\{ Gain\_i(j+j'') - \sum_{t=1}^{3} \left( \alpha_t \cdot C_{j+j'}^t \right) - \alpha_0 \cdot GC_j^i \right\}^2 \quad (i = 0, \cdots, GQ-1)$$

$$\ldots \text{(Equation 21)}$$

In Equation (21), $GC_j^i$ indicates a gain code vector composing a gain codebook, i indicates a gain code vector index, and j indicates an index of a gain code vector element. Here, $C_j^t$ indicates a quantization gain value of t frames before in time, so that when t=1, for example, $C_j^t$ indicates a quantization gain value of one frame before in time. Also, $\alpha$ is a 4th-order linear prediction coefficient stored in gain quantization section 505. A gain interpolation value calculated in accordance with Equation (19) and Equation (20) by interpolation value calculation section 504 is used as a gain value of a band not selected as a quantization target band in the past three frames. Gain quantization section 505 treats L subbands within one region as an L-dimensional vector, and performs vector quantization.

Gain quantization section 505 outputs gain code vector index G_min for which the result of Equation (21) above is a minimum to multiplexing section 106 as gain encoded information. Gain quantization section 505 also updates the internal buffer in accordance with Equation (22) below using gain encoded information G_min and quantization gain value $C_j^t$ obtained in the current frame.

$$\begin{cases} C_{j+j^*}^3 = C_{j+j^*}^2 \\ C_{j+j^*}^2 = C_{j+j^*}^1 \qquad (j=0,\cdots,L-1) \qquad \qquad \ldots(Equation\ 22) \\ C_{j+j^*}^1 = GC_j^{G-\min} \end{cases}$$

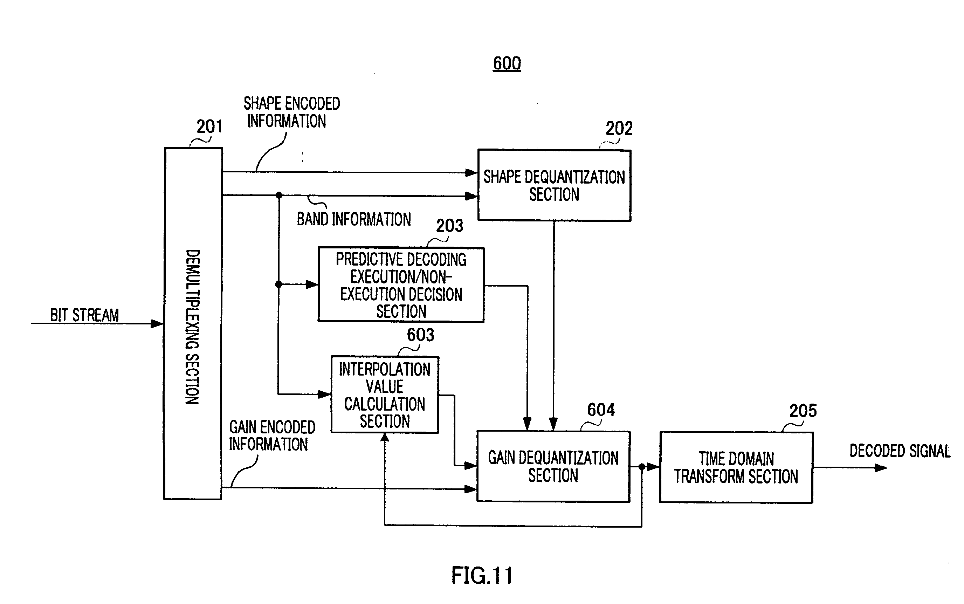

FIG.11 is a block diagram showing the main configuration of speech decoding apparatus 600 according to Embodiment 3 of the present invention. Speech decoding apparatus 600 has a similar basic configuration to that of speech decoding apparatus 200 shown in FIG.3, and therefore identical configuration elements are assigned the same reference codes and descriptions thereof are omitted here.

Speech decoding apparatus 600 differs from speech decoding apparatus 200 in being further equipped with interpolation value calculation section 603. Also, processing differs in part between gain dequantization section 604 of speech decoding apparatus 600 and gain dequantization section 204 of speech decoding apparatus 200, and a different reference code is assigned to indicate this.

Interpolation value calculation section 603 has an internal buffer that stores band information indicating band information dequantized in a past frame. Using a gain value of a band dequantized in a past frame read from gain dequantization section 604, interpolation value calculation section 603 interpolates a gain value of a band that was not dequantized in a past frame among current-frame quantization target bands indicated by band information input from demultiplexing section 201. Interpolation value calculation section 603 outputs an obtained gain interpolation value to gain dequantization section 604.

Gaindequantization section 604 differs from gain dequantization section 204 of speech decoding apparatus 200 in using a gain interpolation value input from interpolation value calculation section 603 in addition to a stored past-frame dequantized gain value and an internal gain codebook when performing predictive encoding.

The gain value interpolation method used by interpolation value calculation section 603 is similar to the gain value interpolation method used by interpolation value calculation section 504, and therefore a detailed description thereof is omitted here.

Next, a predictive decoding operation in gain dequantization section 604 will be described.

Gain dequantization section 604 performs dequantization by predicting a current-frame gain value using a stored gain value dequantized in a past frame, an interpolation gain value input from interpolation value calculation section 603, and an internal gain codebook. Specifically, gain dequantization section 604 obtains gain value Gain_q' by performing gain dequantization in accordance with Equation (23) below.

$$Gain\_q'(j+j'') = \sum_{t=1}^{3}\left(\alpha_t \cdot C'''_{j+j^*}\right) + \alpha_0 \cdot GC_j^{G-\min} \quad (j=0,\cdots,L-1)$$

$$\ldots(Equation\ 23)$$

In Equation (23), $C''^t_j$ indicates a gain value of t frames before in time, so that when t=1, for example, $C''^t_j$ indicates a gain value of one frame before. Also, $\alpha$ is a 4th-order linear prediction coefficient stored in gain dequantization section 604. A gain interpolation value calculated by interpolation value calculation section 603 is used as a gain value of a band not selected as a quantization target in the past three frames. Gain dequantization section 604 treats L subbands within one region as an L-dimensional vector, and performs vector dequantization.

Next, gain dequantization section 604 calculates a decoded MDCT coefficient in accordance with Equation (24) below using a gain value obtained by current-frame dequantization and a shape value input from shape dequantization section 202, and updates the internal buffer in accordance with Equation (25) below. Here, a calculated decoded MDCT coefficient is denoted by $X''_k$. Also, in MDCT coefficient dequantization, if k is present within B(j'') through B(j''+1)-1, gain value Gain q' (j) takes the value of Gain_q'(j'').

$$X''_k = Gain\_q'(j) \cdot Shape\_q'(k) \begin{pmatrix} k = B(j''), \cdots, B(j''+1)-1 \\ j = j'', \cdots, j''+L-1 \end{pmatrix}$$

$$\cdots (\text{Equation } 24)$$

$$\begin{cases} C''^3_j = C''^2_j \\ C''^2_j = C''^1_j \qquad (j = j'', \cdots, j''+L-1) \qquad \cdots (\text{Equation } 25) \\ C''^1_j = Gain\_q''(j) \end{cases}$$

Thus, according to this embodiment, when performing frequency domain parameter quantization of a different quantization target band of each frame, values of adjacent unquantized bands are successively interpolated from a quantized value in a past frame, and predictive quantization is performed using an interpolation value. Consequently, the encoding precision of speech encoding can be further improved.

In this embodiment, a case has been described by way of example in which a fixed interpolation coefficient β found beforehand is used when calculating a gain interpolation value, but the present invention is not limited to this, and interpolation may also be performed after adjusting previously found interpolation coefficient β. For example, a prediction coefficient may be adjusted according to the distribution of gain of a band quantized in each frame. Specifically, it is possible to improve the encoding precision of speech encoding by performing adjustment so that a prediction coefficient is weakened and the weight of current-frame gain is increased when variation in gain quantized in each frame is large.

In this embodiment, a case has been described by way of example in which a consecutive plurality of bands (one region) comprising a band quantized in each frame is made a target, but the present invention is not limited to this, and a plurality of regions may also be made a quantization target. In such a case, it is possible to improve the encoding precision of speech encoding by employing a method whereby linear prediction of end values of the respective regions is performed for a band between selected regions in addition to the interpolation method according to Equation (19) and Equation (20).

(Embodiment 4)

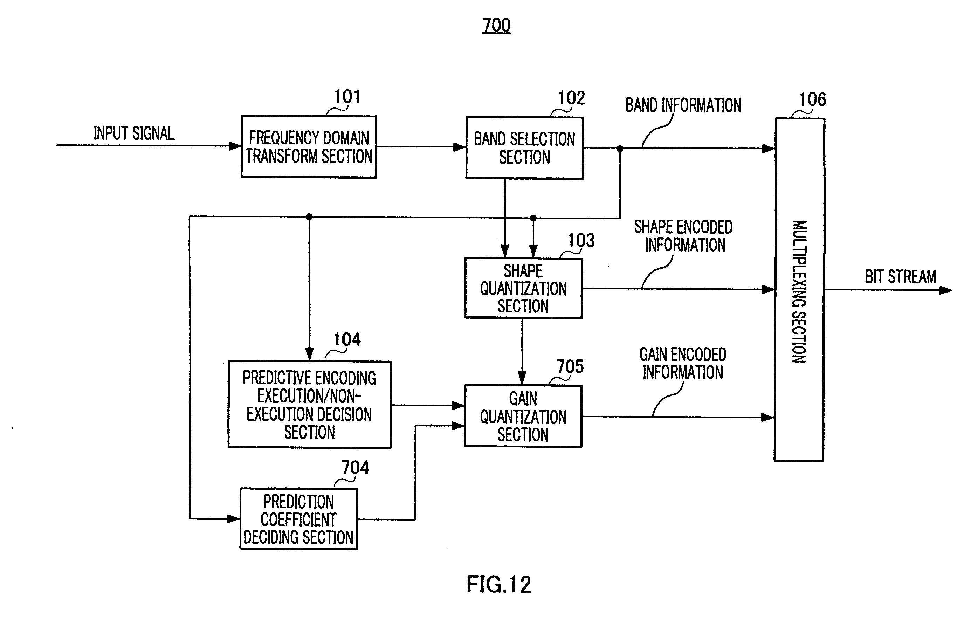

FIG.12 is a block diagram showing the main configuration of speech encoding apparatus 700 according to Embodiment 4 of the present invention. Speech encoding apparatus 700 has a similar basic configuration to that of speech encoding apparatus 100 shown in FIG.1, and therefore identical configuration elements are assigned the same reference codes and descriptions thereof are omitted here.

Speech encoding apparatus 700 differs from speech encoding apparatus 100 in being further equipped with prediction coefficient deciding section 704. Also, processing differs in part between gain quantization section 705 of speech encoding apparatus 700 and gain quantization section 105 of speech encoding apparatus 100, and a different reference code is assigned to indicate this.

Prediction coefficient deciding section 704 has an internal buffer that stores band information indicating a quantization target band of a past frame, decides a prediction coefficient to be used in gain quantization section 705 quantization based on past-frame band information, and outputs a decided prediction coefficient to gain quantization section 705.

Gain quantization section 705 differs from gain quantization section 105 of speech encoding apparatus 100 in using a prediction coefficient input from prediction coefficient deciding section 704 instead of a prediction coefficient decided beforehand when performing predictive encoding.

A prediction coefficient deciding operation in prediction coefficient deciding section 704 will now be described.

Prediction coefficient deciding section 704 has an internal buffer that stores band information m_max input from band selection section 102 in a past frame. Here, a case will be described by way of example in which an internal buffer is provided that stores band information m_max for the past three frames.

Using band information m_max stored in the internal buffer and band information m_max input from band selection section 102 in the current frame, prediction coefficient deciding section 704 finds a number of subbands common to a current-frame quantization target band and past-frame quantization target band. Prediction coefficient deciding section 704 decides prediction coefficients to be set A and outputs this to gain quantization section 705 if the number of common subbands is greater than or equal to a predetermined value, or decides prediction coefficients to be set B and outputs this to gain quantization section 705 if the number of common subbands is less than the predetermined value. Here, prediction coefficient set A is a parameter set that emphasizes a past-frame value more, and makes the weight of a past-frame gain value larger, than in the case of prediction coefficient set B. For example, in the case of 4th-order prediction coefficients, it is possible for set A to be decided as ($\alpha a0=0.60$, $\alpha a1= 0.25$, $\alpha a2=0.10$, $\alpha a3=0.05$), and for set B to be decided as ($\alpha b0=0.80$, $\alpha b1=0.10$, $\alpha b2=0.05$, $\alpha b3=0.05$).

Then prediction coefficient deciding section 704 updates the internal buffer using band information m_max input fromband selection section 102 in the current frame.

Next, a predictive encoding operation in gain quantization section 705 will be described.

Gain quantization section 705 has an internal buffer that stores a quantization gain value obtained in a past frame. Gain quantization section 705 performs quantization by predicting a current-frame gain value using a prediction coefficient input from prediction coefficient deciding section 704 and past-frame quantization gain value $C_j^t$ stored in the internal buffer. Specifically, gain quantization section 705 searches an internal gain codebook composed of quantity GQ of gain code vectors for each of L subbands, and finds an index of a gain code vector for which the result of Equation (26) below is a minimum if a prediction coefficient is set A, or finds an index of a gain code vector for which the result of Equation (27) below is a minimum if a prediction coefficient is set B.

$$Gain\_q(i) = \sum_{j=0}^{L-1}\left\{Gain\_i(j+j'') - \sum_{t=1}^{3}\left(\alpha a_t \cdot C'_{j+j'}\right) - \alpha a_0 \cdot GC_j^i\right\}^2 \quad (i=0,\cdots,GQ-1)$$

$$\ldots(\text{Equation 26})$$

$$Gain\_q(i) = \sum_{j=0}^{L-1}\left\{Gain\_i(j+j'') - \sum_{t=1}^{3}\left(\alpha b_t \cdot C'_{j+j'}\right) - \alpha b_0 \cdot GC_j^i\right\}^2 \quad (i=0,\cdots,GQ-1)$$

$$\ldots(\text{Equation 27})$$

In Equation (26) and Equation (27), $GC_j^i$ indicates a gain code vector composing a gain codebook, i indicates a gain code vector index, and j indicates an index of a gain code vector element. Here, $C_j^t$ indicates a gain value of t frames before in time, so that when t=1, for example, $C_j^t$ indicates a gain value of one frame before in time. Also, $\alpha$ is a 4th-order linear prediction coefficient stored in gain quantization section 705. Gain quantization section 705 treats L subbands within one region as an L-dimensional vector, and performs vector quantization. If there is no gain value of a subband corresponding to a past frame in the internal buffer, gain quantization section 705 substitutes the gain value of the nearest subband in frequency in the internal buffer in Equation (26) or Equation (27) above.

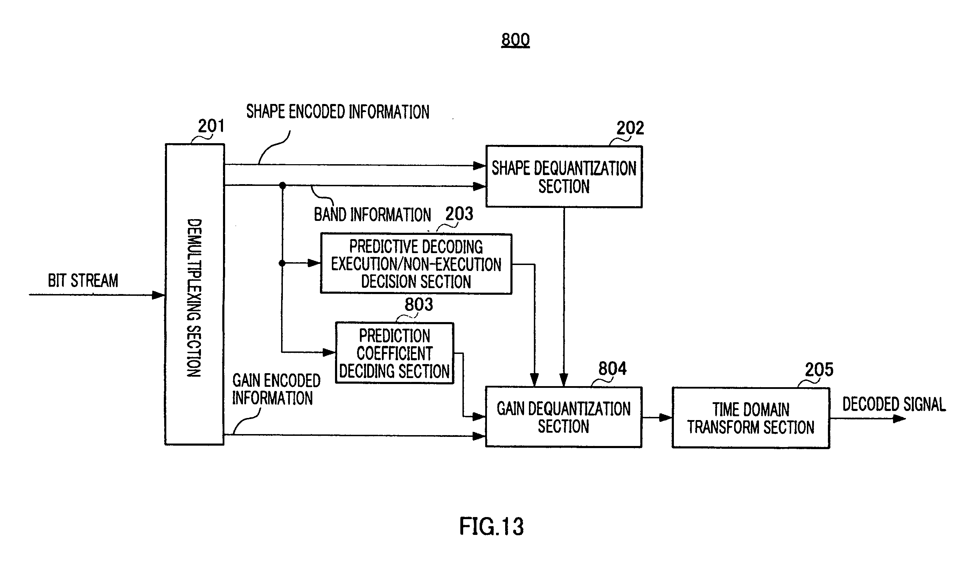

FIG.13 is a block diagram showing the main configuration of speech decoding apparatus 800 according to Embodiment 4 of the present invention. Speech decoding apparatus 800 has a similar basic configuration to that of speech decoding apparatus 200 shown in FIG.3, and therefore identical configuration elements are assigned the same reference codes and descriptions thereof are omitted here.

Speech decoding apparatus 800 differs from speech decoding apparatus 200 in being further equipped with prediction coefficient deciding section 803. Also, processing differs in part between gain dequantization section 804 of speech decoding apparatus 800 and gain dequantization section 204 of speech decoding apparatus 200, and a different reference code is assigned to indicate this.

Prediction coefficient deciding section 803 has an internal buffer that stores band information input from demultiplexing section 201 in a past frame, decides a prediction coefficient to be used in gain dequantization section 804 quantization based on past-frame band information, and outputs a decided prediction coefficient to gain dequantization section 804.

Gain dequantization section 804 differs from gain dequantization section 204 of speech decoding apparatus 200 in using a prediction coefficient input from prediction coefficient deciding section 803 instead of a prediction coefficient decided beforehand when performing predictive decoding.

The prediction coefficient deciding method used by prediction coefficient deciding section 803 is similar to the prediction coefficient deciding method used by prediction coefficient deciding section 704 of speech encoding apparatus 700, and therefore a detailed description of the operation of prediction coefficient deciding section 803 operation is omitted here.

Next, a predictive decoding operation in gain dequantization section 804 will be described.

Gain dequantization section 804 has an internal buffer that stores a gain value obtained in a past frame. Gain dequantization section 804 performs dequantization by predicting a current-frame gain value using a prediction coefficient input from prediction coefficient deciding section 803 and a past-frame gain value stored in the internal buffer. Specifically, gain dequantization section 804 has the same kind of internal gain codebook as gain quantization section 705 of speech encoding apparatus 700, and obtains gain value Gain_q' by performing gain dequantization in accordance with Equation (28) below if a prediction coefficient input from prediction coefficient deciding section 803 is set A, or in accordance with Equation (29) below if the prediction coefficient is set B.

$$Gain\_q'(j + j'') = \sum_{t=1}^{3} \left( \alpha a_t \cdot C'''_{j+j''} \right) + \alpha a_0 \cdot GC_j^{G - \min} \quad (j = 0, \cdots, L-1)$$

$$\ldots (\text{Equation } 28)$$

$$Gain\_q'(j + j'') = \sum_{t=1}^{3} \left( \alpha b_t \cdot C'''_{j+j''} \right) + \alpha b_0 \cdot GC_j^{G - \min} \quad (j = 0, \cdots, L-1)$$

$$\ldots (\text{Equation } 29)$$

In Equation (28) and Equation (29), $C''^t_j$ indicates a gain value of t frames before in time, so that when t=1, for example, $C''^t_j$ indicates a gain value of one frame before. Also, $\alpha a_i$ and $\alpha b_i$ indicate prediction coefficient set A and set B input from prediction coefficient deciding section 803. Gain dequantization section 804 treats L subbands within one region as an L-dimensional vector, and performs vector dequantization.

Thus, according to this embodiment, when performing frequency domain parameter quantization of a different quantization target band of each frame, predictive encoding is performed by selecting, from a plurality of prediction coefficient sets, a prediction coefficient set that makes the weight of a past-frame gain value proportionally larger the greater the number of subbands common to a past-frame quantization target band and current-frame quantization target band. Consequently, the encoding precision of speech encoding can be further improved.

In this embodiment, a case has been described by way of example in which two kinds of prediction coefficient sets are provided beforehand, and a prediction coefficient used in predictive encoding is switched according to the number of subbands common to a past-frame quantization target band and current-frame quantization target band, but the present invention is not limited to this, and three or more kinds of prediction coefficient sets may also be provided beforehand.

In this embodiment, a case has been described by way of example in which, if a quantization target band in the current frame has not been quantized in a past frame, the value of the closest band in a past frame is substituted, but the present invention is not limited to this, and if a quantization target band value in the current frame has not been quantized in a past frame, predictive encoding may also be performed by taking the relevant past-frame prediction coefficient as zero, adding a prediction coefficient of that frame to a current-frame prediction coefficient, calculating a new prediction coefficient set, and using those prediction coefficients. By this means, the effect of predictive encoding can be switched more flexibly, and the encoding precision of speech encoding can be further improved.

(Embodiment 5)

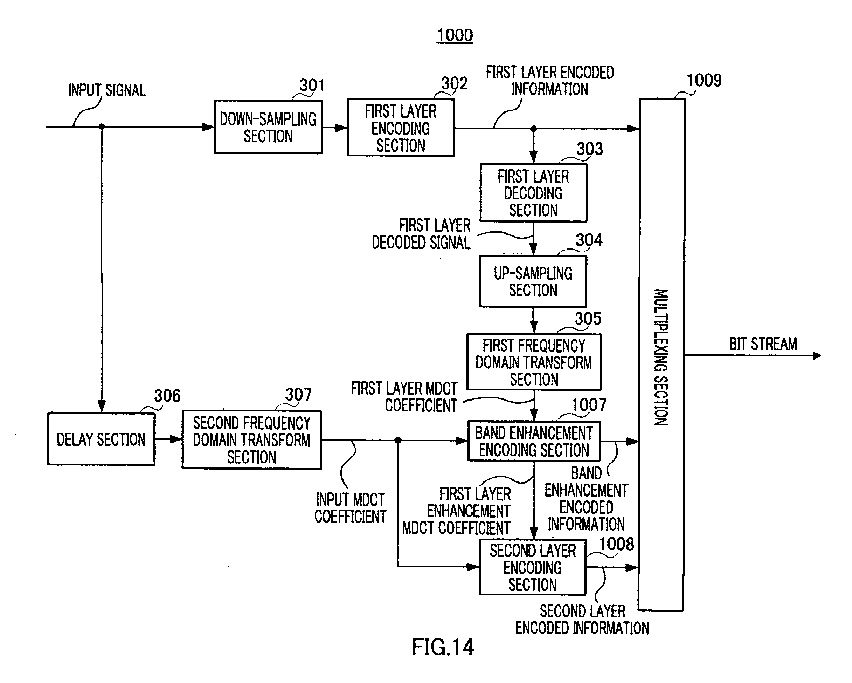

FIG.14 is a block diagram showing the main configuration of speech encoding apparatus 1000 according to Embodiment 5 of the present invention. Speech encoding apparatus 1000 has a similar basic configuration to that of speech encoding apparatus 300 shown in FIG.6, and therefore identical configuration elements are assigned the same reference codes and descriptions thereof are omitted here.

Speech encoding apparatus 1000 differs from speech encoding apparatus 300 in being further equipped with band enhancement encoding section 1007. Also, processing differs in part between second layer encoding section 1008 and multiplexing section 1009 of speech encoding apparatus 1000 and second layer encoding section 308 and multiplexing section 309 of speech encoding apparatus 300, and different reference codes are assigned to indicate this.

Band enhancement encoding section 1007 performs band enhancement encoding using a first layer MDCT coefficient input from first frequency domain transform section 305 and an input MDCT coefficient input from second frequency domain transform section 307, and outputs obtained band enhancement encoded information to multiplexing section 1009.

Multiplexing section 1009 differs from multiplexing section 309 only in also multiplexing band enhancement encoded information in addition to first layer encoded information and second layer encoded information.

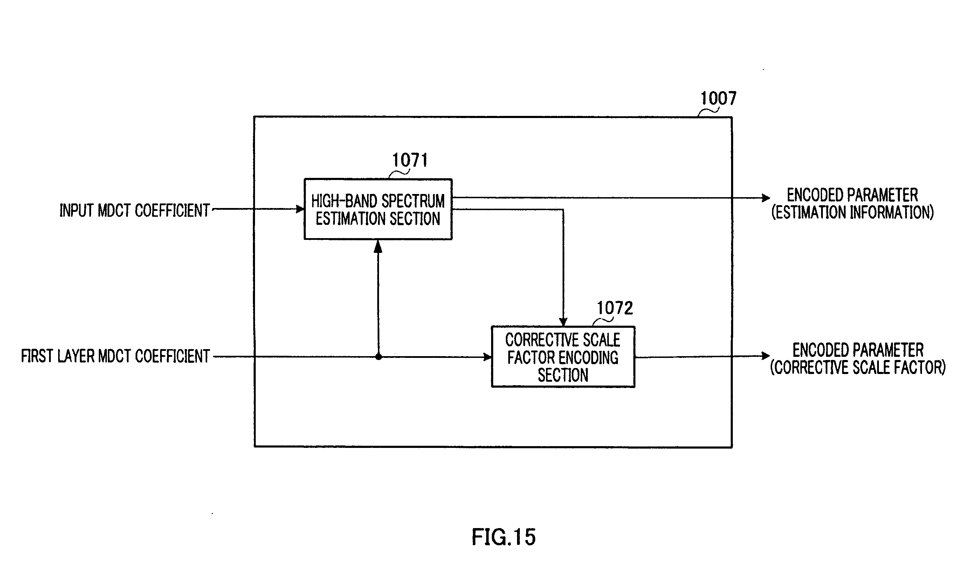

FIG.15 is a block diagram showing the main configuration of the interior of band enhancement encoding section 1007.

In FIG. 15, band enhancement encoding section 1007 is equipped with high-band spectrum estimation section 1071 and corrective scale factor encoding section 1072.

High-band spectrum estimation section 1071 estimates a high-band spectrum of signal bands FL through FH using a low-band spectrum of signal bands 0 through FL of an input MDCT coefficient input from second frequency domain transform section 307, to obtain an estimated spectrum. The estimated spectrum derivation method is to find an estimated spectrum such that the degree of similarity with the high-band spectrum becomes a maximum by transforming the low-band spectrum based on this low-band spectrum. High-band spectrum estimation section 1071 encodes information relating to this estimated spectrum (estimation information), outputs an obtained encoding parameter, and also provides the estimated spectrum itself to corrective scale factor encoding section 1072.

In the following description, an estimated spectrum output from high-band spectrum estimation section 1071 is called a first spectrum, and a first layer MDCT coefficient (high-band spectrum) output from first frequency domain transform section 305 is called a second spectrum.

The above-described kinds of spectra and corresponding signal bands can be summarized as follows.

Narrowband spectrum (low-band spectrum) ... 0 through FL Wideband spectrum ... 0 through FH First spectrum (estimated spectrum) ... FL through FH Second spectrum (high-band spectrum) ... FL through FH

Corrective scale factor encoding section 1072 corrects a first spectrum scale factor so that the first spectrum scale factor approaches a second spectrum scale factor, and encodes and outputs information relating to this corrective scale factor.

Band enhancement encoded information output from band enhancement encoding section 1007 to multiplexing section 1009 includes an estimation information encoding parameter output from high-band spectrum estimation section 1071 and a corrective scale factor encoding parameter output from corrective scale factor encoding section 1072.

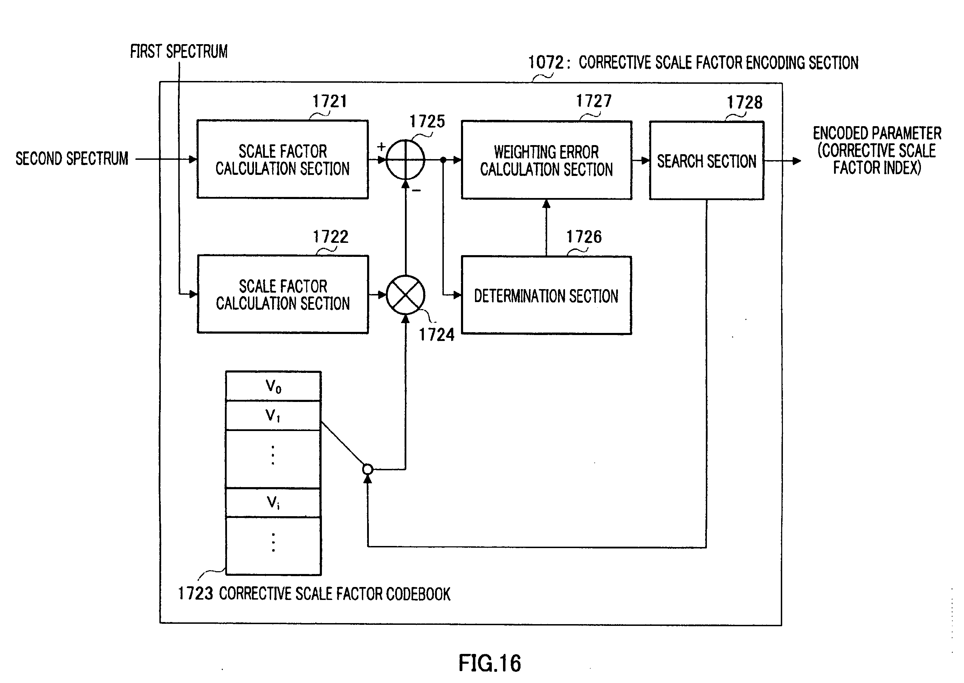

FIG.16 is a block diagram showing the main configuration of the interior of corrective scale factor encoding section 1072.

Corrective scale factor encoding section 1072 is equipped with scale factor calculation sections 1721 and 1722, corrective scale factor codebook 1723, multiplier 1724, subtracter 1725, determination section 1726, weighting error calculation section 1727, and search section 1728. These sections perform the following operations.

Scale factor calculation section 1721 divides input second spectrum signal bands FL through FH into a plurality of subbands, finds the size of a spectrum included in each subband, and outputs this to subtracter 1725. Specifically, division into subbands is performed associated with a critical band, and division is performed into equal intervals on the Bark scale. Also, scale factor calculation section 1721 finds the average amplitude of spectra included in the subbands, and takes this as second scale factor SF2(k) {0≤k<NB}, where NB represents the number of subbands. A maximum amplitude value or the like may be used instead of an average amplitude.

Scale factor calculation section 1722 divides input first spectrum signal bands FL through FH into a plurality of subbands, calculates first scale factor SF1(k) {0≤k<NB} of the subbands, and outputs this to multiplier 1724. As with scale factor calculation section 1721, a maximum amplitude value or the like may be used instead of an average amplitude.

In the subsequent processing, parameters in the plurality of subbands are integrated into one vector value. For example, quantity NB of scale factors are represented as one vector. A description will be given taking a case in which each processing operation is performed for each of these vectors - that is, a case in which vector quantization is performed - as an example.

Corrective scale factor codebook 1723 stores a plurality of corrective scale factor candidates, and sequentially outputs one of the stored corrective scale factor candidates to multiplier 1724 in accordance with a directive from search section 1728. The plurality of corrective scale factor candidates stored in corrective scale factor codebook 1723 are represented by a vector.

Multiplier 1724 multiplies a first scale factor output from scale factor calculation section 1722 by a corrective scale factor candidate output from corrective scale factor codebook 1723, and provides the multiplication result to subtracter 1725.

Subtracter 1725 subtracts multiplier 1724 output - that is, the product of the first scale factor and corrective scale factor - from the second scale factor output from scale factor calculation section 1721, and provides an error signal thereby obtained to weighting error calculation section 1727 and determination section 1726.

Determination section 1726 decides a weighting vector to be provided to weighting error calculation section 1727 based on the sign of the error signal provided from subtracter 1725. Specifically, error signal d(k) provided from subtracter 1725 is represented by Equation (30) below.

$$d(k) = SF2(k) - v_i(k) \cdot SF1(k) \quad (0 \le k < NB) \qquad \ldots (Equation\ 30)$$

Here, $v_i(k)$ represents an i'th corrective scale factor candidate. Determination section 1726 checks the sign of d(k), selects $w_{pos}$ as a weight if d (k) is positive, or selects $w_{neg}$ as a weight if d (k) is negative, and outputs weighting vector w (k) composed of these to weighting error calculation section 1727. These weights have the relative size relationship shown in Equation (31) below.

$$0 < w_{pos} < w_{neg} \qquad \ldots (Equation\ 31)$$

For example, if number of subbands NB=4, and the signs of d(k) are {+, -, -, +}, weighting vector w(k) output to weighting error calculation section 1727 is represented by w(k)={$w_{pos}$, $w_{neg}$, $w_{neg}$, $w_{pos}$}.

Weighting error calculation section 1727 first calculates the square of the error signal provided from subtracter 1725, and then multiplies weighting vector w(k) provided from determination section 1726 by the square of the error signal to calculate weighted square error E, and provides the result of this calculation to search section 1728. Here, weighted square error E is represented as shown in Equation (32) below.

$$E = \sum_{k=0}^{NB-1} w(k) \cdot d(k)^2 \qquad \ldots (Equation\ 32)$$

Search section 1728 controls corrective scale factor codebook 1723 and sequentially outputs stored corrective scale factor candidates, and by means of closed loop processing finds a corrective scale factor candidate for which weighted square error E output from weighting error calculation section 1727 is a minimum. Search section 1728 outputs index iopt of the found corrective scale factor candidate as an encoding parameter.

When a weight used when calculating weighted square error E is set according to the sign of an error signal and the kind of relationship shown in Equation (30) applies to that weight, as described above, the following kind of effect is obtained. Namely, a case in which error signal d(k) is positive is a case in which a decoded value generated on the decoding side (in terms of the encoding side, a value obtained by multiplying a first scale factor by a corrective scale factor) is smaller than a second scale factor, which is the target value. Also, a case in which error signal d (k) is negative is a case in which a decoded value generated on the decoding side is greater than a second scale factor, which is the target value. Therefore, by setting a weight when error signal d(k) is positive so as to be smaller than a weight when error signal d(k) is negative, when square error values are of the same order a corrective scale factor candidate that generates a decoded value smaller than a second scale factor becomes prone to be selected.

The following kind of improvement effect is obtained by band enhancement encoding section 1007 processing. For example, when a high-band spectrum is estimated using a low-band spectrum, as in this embodiment, a lower bit rate can generally be achieved. However, while a lower bit rate can be achieved, the precision of an estimated spectrum-that is, the similarity between an estimated spectrum and high-band spectrum - cannot be said to be sufficiently high, as described above. In such a case, if a scale factor decoded value becomes greater than a target value, and a post-quantization scale factor operates in the direction of strengthening an estimated spectrum, the low precision of the estimated spectrum tends to be perceptible to the human ear as quality degradation. Conversely, when a scale factor decoded value becomes smaller than a target value, and a post-quantization scale factor operates in the direction of attenuating this estimated spectrum, low precision of the estimated spectrum ceases to be noticeable, and an effect of improving the audio quality of the decoded signal is obtained. This tendency has also been confirmed in a computer simulation.

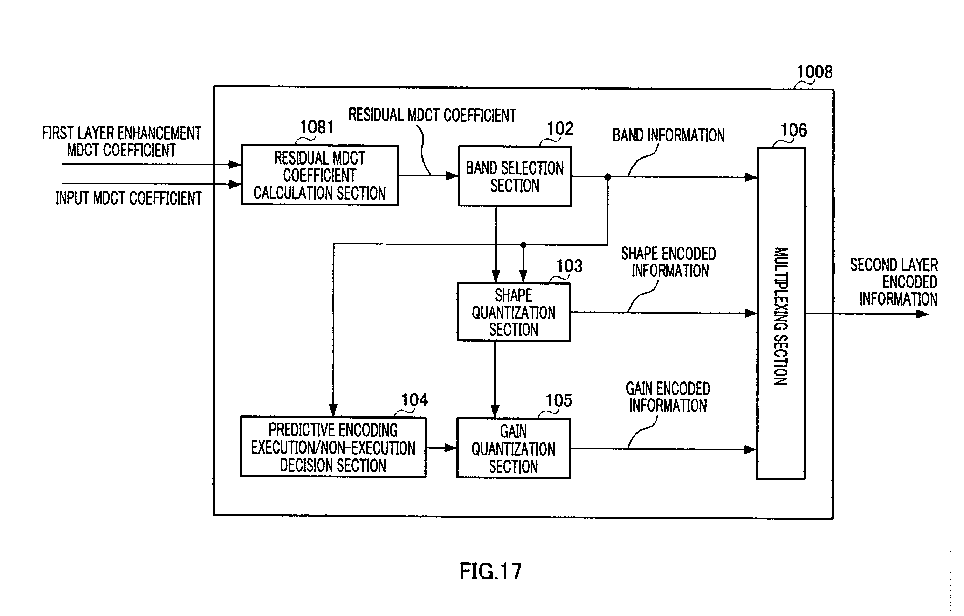

FIG.17 is a block diagram showing the main configuration of the interior of second layer encoding section 1008.

Second layer encoding section 1008 has a similar basic configuration to that of second layer encoding section 308 shown in see FIG.7, and therefore identical configuration elements are assigned the same reference codes and descriptions thereof are omitted here. Processing differs in part between residual MDCT coefficient calculation section 1081 of second layer encoding section 1008 and residual MDCT coefficient calculation section 381 of second layer encoding section 308, and a different reference code is assigned to indicate this.

Residual MDCT coefficient calculation section 1081 calculates a residual MDCT that is to be a quantization target in the second layer encoding section from an input input MDCT coefficient and first layer enhancement MDCT coefficient. Residual MDCT coefficient calculation section 1081 differs from residual MDCT coefficient calculation section 381 according to Embodiment 2 in taking a residue of the input MDCT coefficient and first layer enhancement MDCT coefficient as a residual MDCT coefficient for a band not enhanced by band enhancement encoding section 1007 and taking an input MDCT coefficient itself, rather than a residue, as a residual MDCT coefficient for a band enhanced by band enhancement encoding section 1007.

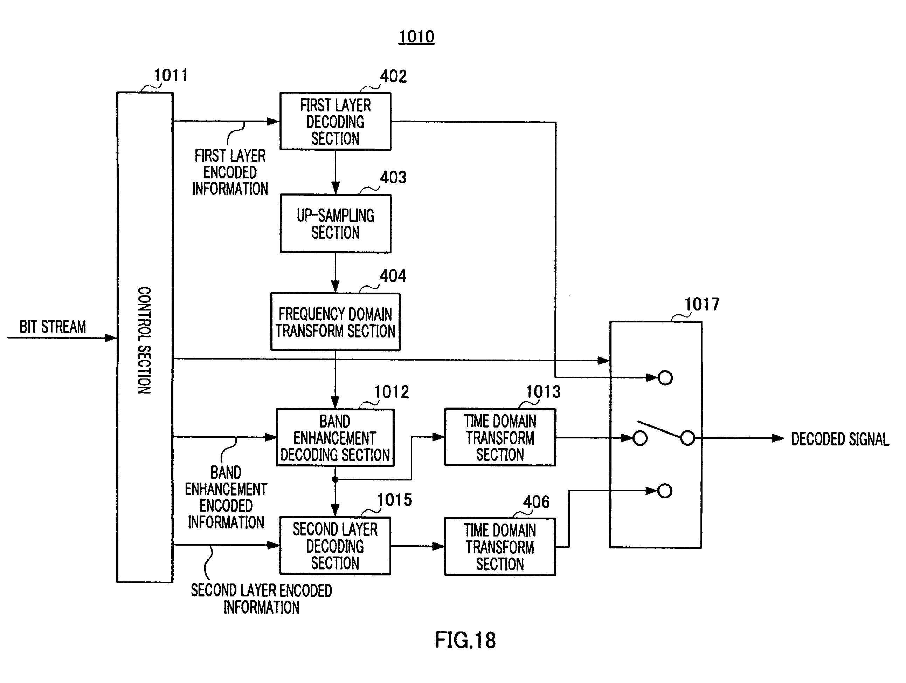

FIG.18 is a block diagram showing the main configuration of speech decoding apparatus 1010 according to Embodiment 5 of the present invention. Speech decoding apparatus 1010 has a similar basic configuration to that of speech decoding apparatus 400 shown in FIG.8, and therefore identical configuration elements are assigned the same reference codes and descriptions thereof are omitted here.

Speech decoding apparatus 1010 differs from speech decoding apparatus 400 in being further equipped with band enhancement decoding section 1012 and time domain transform section 1013. Also, processing differs in part between control section 1011, second layer decoding section 1015, and switch 1017 of speech decoding apparatus 1010 and control section 401, second layer decoding section 405, and switch 407 of speech decoding apparatus 400, and different reference codes are assigned to indicate this.

Control section 1011 analyzes configuration elements of a bit stream transmitted from speech encoding apparatus 1000, and according to these bit stream configuration elements, adaptively outputs appropriate encoded information to first layer decoding section 402, band enhancement decoding section 1012, and second layer decoding section 1015, and also outputs control information to switch 1017. Specifically, if the bit stream comprises first layer encoded information, band enhancement encoded information, and second layer encoded information, control section 1011 outputs the first layer encoded information to first layer decoding section 402, outputs the band enhancement encoded information to band enhancement decoding section 1012, and outputs the second layer encoded information to second layer decoding section 1015. If the bit stream comprises only first layer encoded information and band enhancement encoded information, control section 1011 outputs the first layer encoded information to first layer decoding section 402, and outputs the band enhancement encoded information to band enhancement decoding section 1012. If the bit stream comprises only first layer encoded information, control section 1011 outputs this first layer encoded information to first layer decoding section 402. Also, control section 1011 outputs control information that controls switch 1017 to switch 1017.

Band enhancement decoding section 1012 performs band enhancement processing using band enhancement encoded information input from control section 1011 and a first layer decoded MDCT coefficient input from frequency domain transform section 404, to obtain a first layer enhancement MDCT coefficient. Then band enhancement decoding section 1012 outputs the obtained first layer enhancement MDCT coefficient to time domain transform section 1013 and second layer decoding section 1015. The main internal configuration and actual operation of band enhancement decoding section 1012 will be described later herein.

Time domain transform section 1013 performs an IMDCT on the first layer enhancement MDCT coefficient input from band enhancement decoding section 1012, and outputs a first layer enhancement decoded signal obtained as a time domain component to switch 1017.

Second layer decoding section 1015 performs gain dequantization and shape dequantization using the second layer encoded information input from control section 1011 and the first layer enhancement MDCT coefficient input from band enhancement decoding section 1012, to obtain a second layer decoded MDCT coefficient. Second layer decoding section 1015 adds together the obtained second layer decoded MDCT coefficient and first layer decoded MDCT coefficient, and outputs the obtained addition result to time domain transform section 406 as an addition MDCT coefficient. The main internal configuration and actual operation of second layer decoding section 1015 will be described later herein.

Based on control information input from control section 1011, if the bit stream input to speech decoding apparatus 1010 comprises first layer encoded information, band enhancement encoded information, and second layer encoded information, switch 1017 outputs the second layer decoded signal input from time domain transform section 406 as an output signal. If the bit stream comprises only first layer encoded information and band enhancement encoded information, switch 1017 outputs the first layer enhancement decoded signal input from time domain transform section 1013 as an output signal. If the bit stream comprises only first layer encoded information, switch 1017 outputs the first layer decoded signal input from first layer decoding section 402 as an output signal.

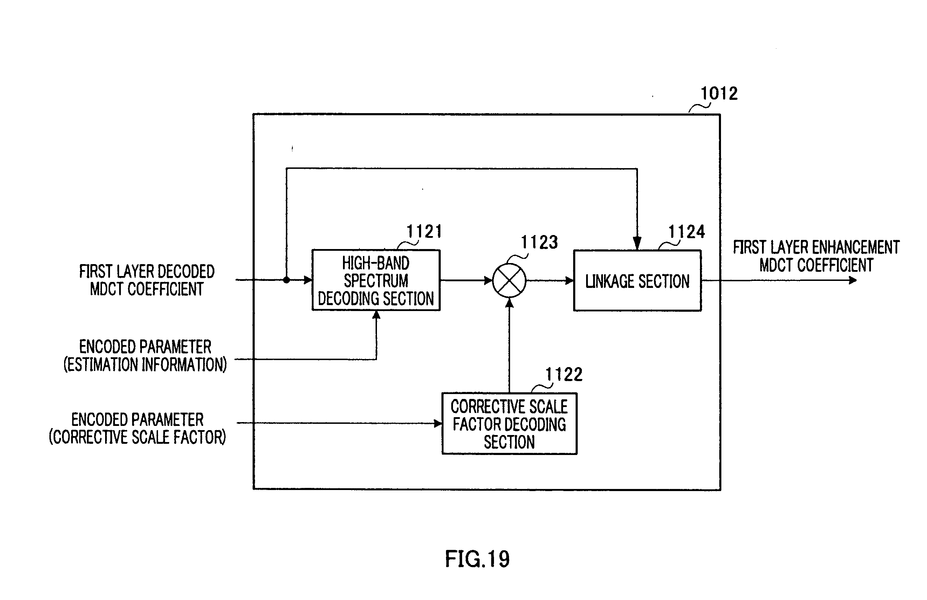

FIG.19 is a block diagram showing the main configuration of the interior of band enhancement decoding section 1012. Band enhancement decoding section 1012 comprises high-band spectrum decoding section 1121, corrective scale factor decoding section 1122, multiplier 1123, and linkage section 1124.

High-band spectrum decoding section 1121 decodes an estimated spectrum (fine spectrum) of bands FL through FH using an estimation information encoding parameter and first spectrum included in band enhancement encoded information input from control section 1011. The obtained estimated spectrum is provided to multiplier 1123.

Corrective scale factor decoding section 1122 decodes a corrective scale factor using a corrective scale factor encoding parameter included in band enhancement encoded information input from control section 1011. Specifically, corrective scale factor decoding section 1122 references an internal corrective scale factor codebook (not shown) and outputs a corresponding corrective scale factor to multiplier 1123.

Multiplier 1123 multiplies the estimated spectrum output from high-band spectrum decoding section 1121 by the corrective scale factor output from corrective scale factor decoding section 1122, and outputs the multiplication result to linkage section 1124.

Linkage section 1124 links the first spectrum and the estimated spectrum output from multiplier 1123 in the frequency domain, to generate a wideband decoded spectrum of signal bands 0 through FH, and outputs this to time domain transform section 1013 as a first layer enhancement MDCT coefficient.

By means of band enhancement decoding section 1012, when an input signal is transformed to a frequency-domain coefficient and a scale factor is quantized in upper layer frequency-domain encoding, scale factor quantization is performed using a weighted distortion scale such that a quantization candidate for which the scale factor becomes small becomes prone to be selected. That is, a quantization candidate whereby the scale factor after quantization is smaller than the scale factor before quantization, are more likely to be selected. Thus, degradation of perceptual subjective quality can be suppressed even when the number of bits allocated to scale factor quantization is insufficient.

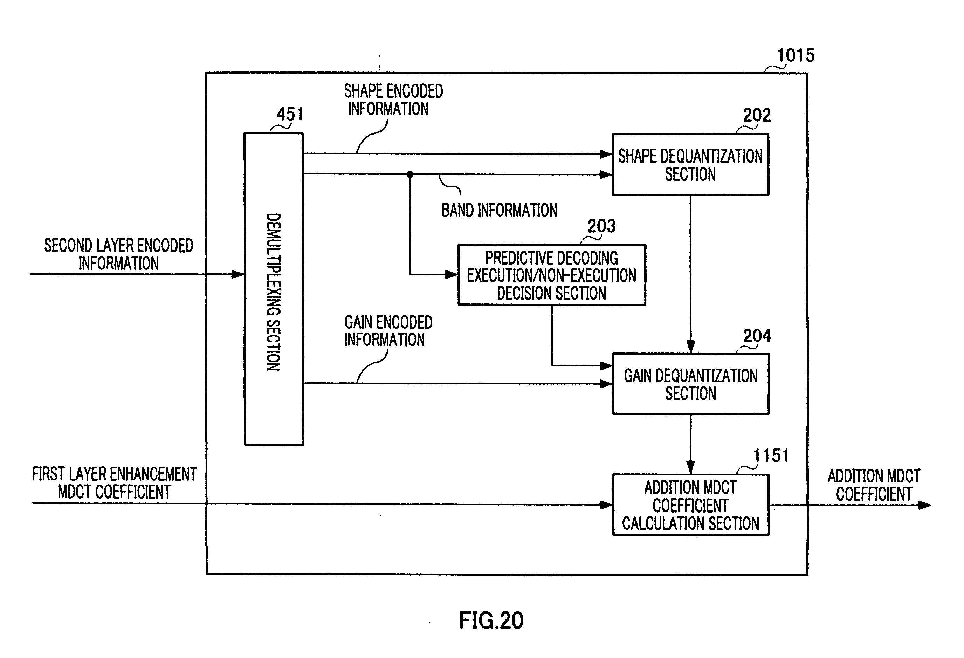

FIG.20 is a block diagram showing the main configuration of the interior of second layer decoding section 1015. Second layer decoding section 1015 has a similar basic configuration to that of second layer decoding section 405 shown in FIG.9, and therefore identical configuration elements are assigned the same reference codes and descriptions thereof are omitted here.

Processing differs in part between addition MDCT coefficient calculation section 1151 of second layer decoding section 1015 and addition MDCT coefficient calculation section 452 of second layer decoding section 405, and a different reference code is assigned to indicate this.

Addition MDCT coefficient calculation section 1151 has a first layer enhancement MDCT coefficient as input from band enhancement decoding section 1012, and a second layer decoded MDCT coefficient as input from gain dequantization section 204. Addition MDCT coefficient calculation section 1151 adds together the first layer decoded MDCT coefficient and the second layer decoded MDCT coefficient, and outputs an addition MDCT coefficient. For a band-enhanced band, the first layer enhancement MDCT coefficient value is added as zero in addition MDCT coefficient calculation section 1151. That is to say, for a band-enhanced band, the second layer decoded MDCT coefficient value is taken as the addition MDCT coefficient value.

Thus, according to this embodiment, when a frequency component of a different band is made a quantization target in each frame, non-temporal parameter predictive encoding is performed adaptively in addition to applying scalable encoding using band enhancement technology. Consequently, the encoded information amount in speech encoding can be reduced, and speech/audio signal encoding error and decoded signal audio quality degradation can be further reduced.

Also, since a residue is not calculated for a component of a band enhanced by a band enhancement encoding method, the energy of a quantization target component does not increase in an upper layer, and quantization efficiency can be improved.

In this embodiment, a case has been described by way of example in which a method is applied whereby band enhancement encoded information is calculated in an encoding apparatus using the correlation between a low-band component decoded by a first layer decoding section and a high-band component of an input signal, but the present invention is not limited to this, and can also be similarly applied to a configuration that employs a method whereby band enhancement encoded information is not calculated, and pseudo-generation of a high band is performed by means of a noise component, as with AMR-WB (Adaptive MultiRate - Wideband). Alternatively, a band selection method of the present invention can be similarly applied to the band enhancement encoding method described in this example, or a scalable encoding/decoding method that does not employ a high-band component generation method also used in AMR-WB.

(Embodiment 6)

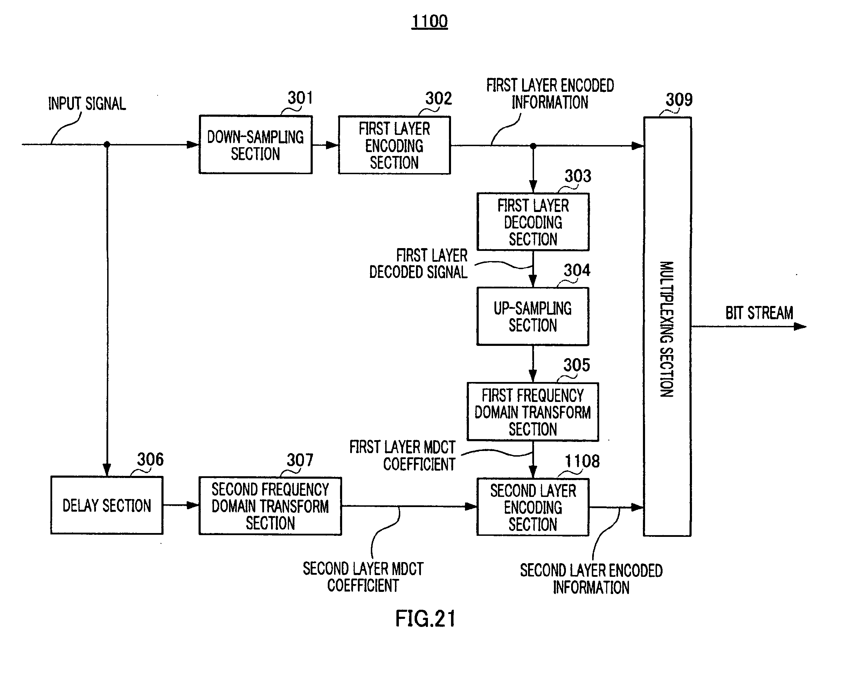

FIG.21 is a block diagram showing the main configuration of speech encoding apparatus 1100 according to Embodiment 6 of the present invention.

In this figure, speech encoding apparatus 1100 is equipped with down-sampling section 301, first layer encoding section 302, first layer decoding section 303, up-sampling section 304, first frequency domain transform section 305, delay section 306, second frequency domain transform section 307, second layer encoding section 1108, and multiplexing section 309, and has a scalable configuration comprising two layers. In the first layer, a CELP speech encoding method is applied, and in the second layer, the speech encoding method described in Embodiment 1 of the present invention is applied.

With the exception of second layer encoding section 1108, configuration elements in speech encoding apparatus 1100 shown in FIG.21 are identical to the configuration elements of speech encoding apparatus 300 shown in FIG.6, and therefore identical configuration elements are assigned the same reference codes and descriptions thereof are omitted here.

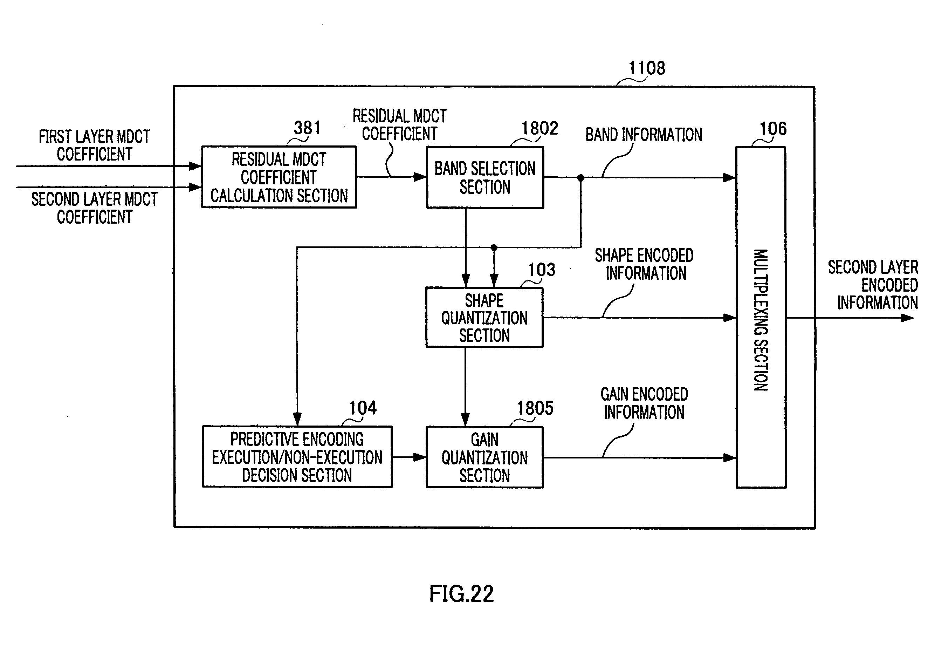

FIG.22 is a block diagram showing the main configuration of the interior of second layer encoding section 1108. Second layer encoding section 1108 mainly comprises residual MDCT coefficient calculation section 381, band selection section 1802, shape quantization section 103, predictive encoding execution/non-execution decision section 104, gain quantization section 1805, and multiplexing section 106. With the exception of band selection section 1802 and gain quantization section 1805, configuration elements in second layer encoding section 1108 are identical to the configuration elements of second layer encoding section 308 shown in FIG.7, and therefore identical configuration elements are assigned the same reference codes and descriptions thereof are omitted here.

Band selection section 1802 first divides MDCT coefficient $X_k$ into a plurality of subbands. Here, a description will be given taking a case in which MDCT coefficient $X_k$ is divided equally into J subbands (where J is a natural number) as an example. Then band selection section 1802 selects L subbands (where L is a natural number) from among the J subbands, and obtains M kinds of regions (where M is a natural number).

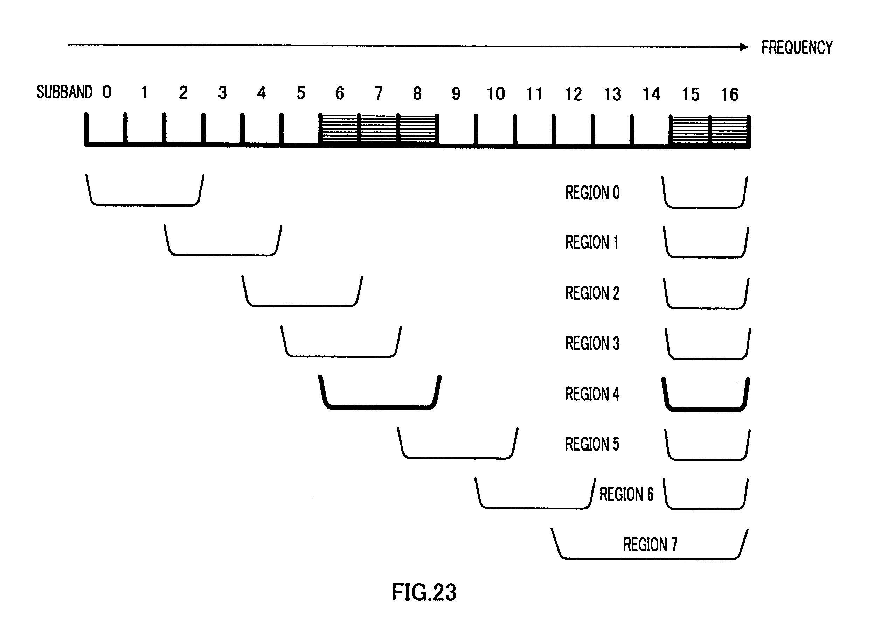

FIG.23 is a drawing showing an example of the configuration of regions obtained by band selection section 1802.

In this figure, the number of subbands is 17 (J=17), the number of kinds of regions is eight (M=8), and each region is composed of two subband groups (the number of bands composing these two subband groups being three and two respectively). Of these two subband groups, the subband group comprising two bands located on the high-band side is fixed throughout all frames, the subband indices being, for example, 15 and 16. For example, region 4 is composed of subbands 6 through 8, 15, and 16.

Next, band selection section 1802 calculates average energy E(m) of each of the M kinds of regions in accordance with Equation (33) below.

$$E(m) = \frac{\sum_{j' \in Region(m)} \sum_{k=B(j')}^{B(j')+W(j')} (X_k)^2}{L} \quad (m = 0, \cdots, M-1) \qquad ...(Equation\ 33)$$

In this equation, j' indicates the index of each of J subbands, and m indicates the index of each of M kinds of regions. Region (m) means a collection of indices of L subbands composing region m, and B(j') indicates the minimum value among the indices of a plurality of MDCT coefficients composing subband j'. W(j) indicates the bandwidth of subband j', and in the following description, a case in which the bandwidths of the J subbands are all equal - that is, a case in which W(j') is a constant - will be described as an example.

Next, when a region for which average energy E (m) is a maximum - for example, region m_max is selected, band selection section 1802 selects a band composed of j' $\in$ Region (m_max) subbands as a quantization target band, and outputs index m_max indicating this region as band information to shape quantization section 103, predictive encoding execution/non-execution decision section 104, and multiplexing section 106. Band selection section 1802 also outputs residual MDCT coefficient $X_k$ to shape quantization section 103.

Gain quantization section 1805 has an internal buffer that stores a quantization gain value obtained in a past frame. If a determination result input from predictive encoding execution/non-execution decision section 104 indicates that predictive encoding is to be performed, gain quantization section 1805 performs quantization by predicting a current-frame gain value using past-frame quantization gain value $C_j^t$, stored in the internal buffer. Specifically, gain quantization section 1805 searches an internal gain codebook composed of quantity GQ of gain code vectors for each of L subbands, and finds an index of a gain code vector for which the result of Equation (34) below is a minimum.

$$Gain\_q(i) = \sum_{j' \in Region(m\_max)} \left\{ Gain\_i(j') - \sum_{t=1}^{3} (\alpha_t \cdot C_{j'}^t) - \alpha_0 \cdot GC_k \right\}^2 \begin{pmatrix} i = 0, \cdots, GQ-1 \\ k = 0, \cdots, L-1 \end{pmatrix}$$

$$...(Equation\ 34)$$

In this equation, $GC^i_k$ indicates a gain code vector composing a gain codebook, i indicates a gain code vector index, and k indicates an index of a gain code vector element. For example, if the number of subbands composing a region is five (L=5), k has a value of 0 to 4. Here, gains of subbands of a selected region are linked so that subband indices are in ascending order, consecutive gains are treated as one L-dimensional gain code vector, and vector quantization is performed. Therefore, to give a description using FIG.23, in the case of region 4, gain values of subband indices 6, 7, 8, 15, and 16 are linked and treated as a 5-dimensional gain code vector. Also, $C^t_j$, indicates a gain value of t frames before in time, so that when t=1, for example, $C^t_j$, indicates a gain value of one frame before in time, and $\alpha$ is a 4th-order linear prediction coefficient stored in gain quantization section 1805.

Gain quantization section 1805 outputs gain code vector index G__min for which the result of Equation (34) above is a minimum to multiplexing section 106 as gain encoded information. If there is no gain value of a subband corresponding to a past frame in the internal buffer, gain quantization section 1805 substitutes the gain value of the nearest subband in frequency in the internal buffer in Equation (34) above.

On the other hand, if the determination result input from predictive encoding execution/non-execution decision section 104 indicates that predictive encoding is not to be performed, gain quantization section 1805 directly quantizes ideal gain value Gain_i (j') input from shape quantization section 103 in accordance with Equation (35) below. Here, gain quantization section 1805 treats an ideal gain value as an L-dimensional vector, and performs vector quantization.

$$Gain\_q(i) = \sum_{j' \in Region(m\_max)} \left\{ Gain\_i(j') - GC^i_k \right\}^2 \left( \begin{array}{l} i = 0, \cdots, GQ - 1 \\ k = 0, \cdots, L - 1 \end{array} \right)$$

$$\ldots \text{(Equation 35)}$$

Here, a codebook index that makes Equation (35) above a minimum is denoted by G_min.

Gain quantization section 1805 outputs G_min to multiplexing section 106 as gain encoded information. Gain quantization section 1805 also updates the internal buffer in accordance with Equation (36) below using gain encoded information G_min and quantization gain value $c^t_j$, obtained in the current frame. That is to say, in Equation (36), a $C^1_j$, value is updated with gain code vector $GC^{G\_min}_j$ element index j and j' satisfying j' $\in$ Region(m_max) respectively associated in ascending order.

$$\begin{cases} C^3_{j'} = C^2_{j'} \\ C^2_{j'} = C^1_{j'} \\ C^1_{j'} = GC^{G\_min}_{j'} \end{cases} \quad \left( \begin{array}{l} j' \in Region(m\_max) \\ j = 0, \cdots, L - 1 \end{array} \right) \qquad \ldots \text{(Equation 36)}$$

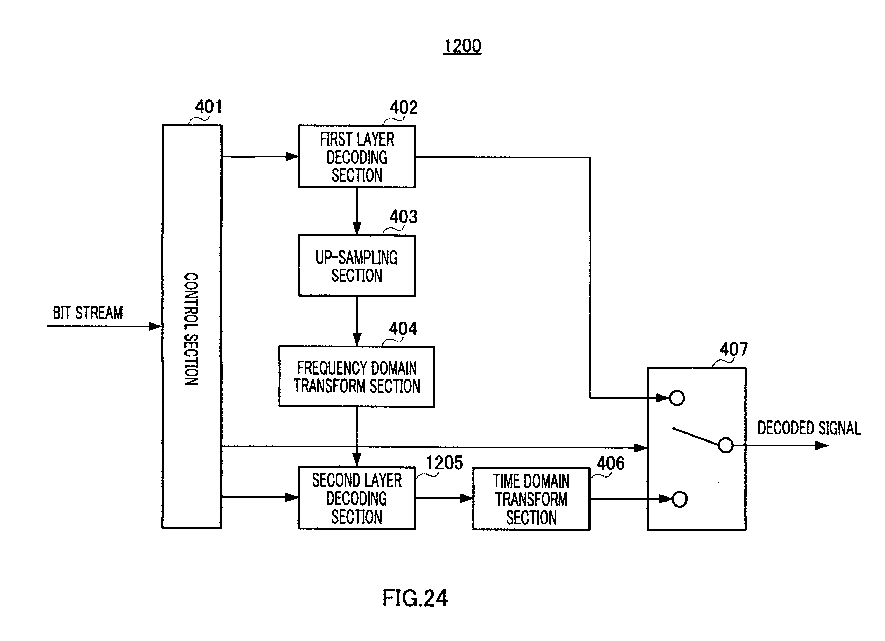

FIG.24 is a block diagram showing the main configuration of speech decoding apparatus 1200 according to this embodiment.

In this figure, speech decoding apparatus 1200 is equipped with control section 401, first layer decoding section 402, up-sampling section 403, frequency domain transform section 404, second layer decoding section 1205, time domain transform section 406, and switch 407.

With the exception of second layer decoding section 1205, configuration elements in speech decoding apparatus 1200 shown in FIG.24 are identical to the configuration elements of speech decoding apparatus 400 shown in FIG.8, and therefore identical configuration elements are assigned the same reference codes and descriptions thereof are omitted here.

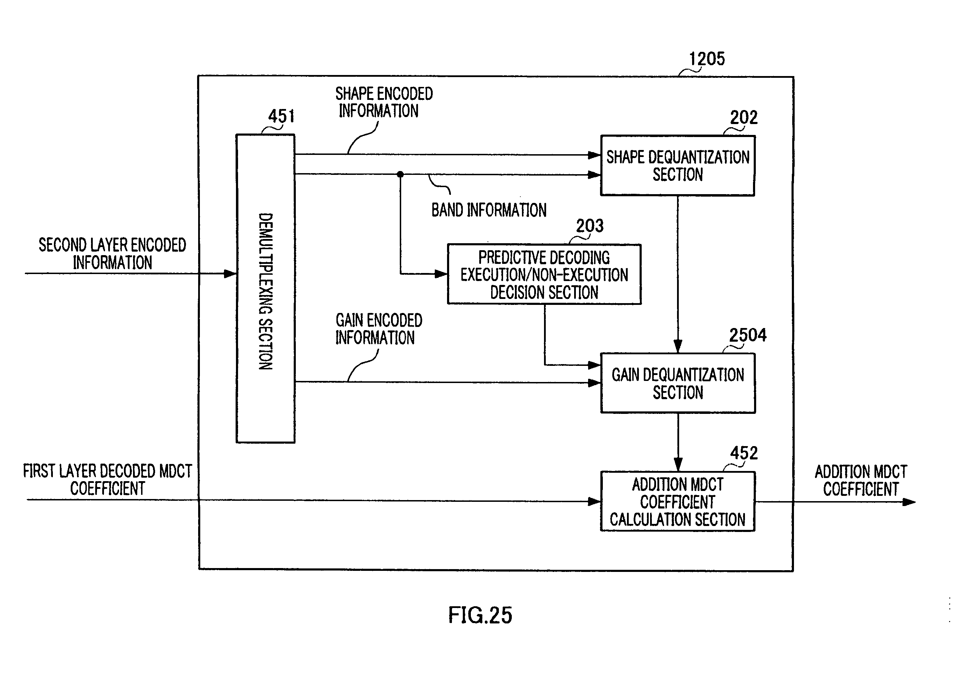

FIG.25 is a block diagram showing the main configuration of the interior of second layer decoding section 1205. Second layer decoding section 1205 mainly comprises demultiplexing section 451, shape dequantization section 202, predictive decoding execution/non-execution decision section 203, gain dequantization section 2504, and addition MDCT coefficient calculation section 452. With the exception of gain dequantization section 2504, configuration elements in second layer decoding section 1205 are identical to the configuration elements of second layer decoding section 405 shown in FIG.9, and therefore identical configuration elements are assigned the same reference codes and descriptions thereof are omitted here.

Gain dequantization section 2504 has an internal buffer that stores a gain value obtained in a past frame. If a determination result input from predictive decoding execution/non-execution decision section 203 indicates that predictive decoding is to be performed, gain dequantization section 2504 performs dequantization by predicting a current-frame gain value using a past-frame gain value stored in the internal buffer. Specifically, gain dequantization section 2504 has the same kind of internal gain codebook ($GC^{G\_min}_k$, where k indicates an element index) as gain quantization section 105 of speech encoding apparatus 100, and obtains gain value Gain_q' by performing gain dequantization in accordance with Equation (37) below. Here, $C''^t_{j'}$ indicates a gain value of t frames before in time, so that when t=1, for example, $C''^t_{j'}$ indicates a gain value of one frame before in time. Also, $\alpha$ is a 4th-order linear prediction coefficient stored in gain dequantization section 2504. Gain dequantization section 2504 treats L subbands within one region as an L-dimensional vector, and performs vector dequantization. That is to say, in Equation (37), a Gain_q' (j') value is calculated with gain code vector $GC^{G\_min}_k$ element index k and j' satisfying j' $\in$ Region(m_max) respectively associated in ascending order.

$$Gain\_q'\left(j'\right) = \sum_{t=1}^{3}\left(\alpha_t \cdot C'''^t_{j'}\right) + \alpha_0 \cdot GC^{G\_\min}_k \quad \begin{pmatrix} j' \in Region(m\_max) \\ k = 0, \cdots, L-1 \end{pmatrix}$$

$$\ldots(Equation\ 37)$$

If there is no gain value of a subband corresponding to a past frame in the internal buffer, gain dequantization section 2504 substitutes the gain value of the nearest subband in frequency in the internal buffer in Equation (37) above.

On the other hand, if the determination result input from predictive decoding execution/non-execution decision section 203 indicates that predictive decoding is not to be performed, gain dequantization section 2504 performs dequantization of a gain value in accordance with Equation (38) below using the above-described gain codebook. Here, a gain value is treated as an L-dimensional vector, and vector dequantization is performed. That is to say, when predictive decoding is not performed, gain dequantization section 2504 takes gain code vector $GC_k^{G\_min}$ corresponding to gain encoded information G_min directly as a gain value. In Equation (38), k and j' are respectively associated in ascending order in the same way as in Equation (37).

$$Gain\_q'\left(j'\right) = GC^{G\_\min}_k \quad \begin{pmatrix} j' \in Region(m\_max) \\ k = 0, \cdots, L-1 \end{pmatrix} \qquad \ldots(Equation\ 38)$$

Next, gain dequantization section 2504 calculates a decoded MDCT coefficient in accordance with Equation (39) below using a gain value obtained by current-frame dequantization and a shape value input from shape dequantization section 202, and updates the internal buffer in accordance with Equation (40) below. In Equation (40), a $C''^1_j$ value is updated with j of dequantized gain value Gain_q'(j) and j' satisfying j' $\in$ Region(m_max) respectively associated in ascending order. Here, a calculated decoded MDCT coefficient is denoted by $X''_k$. Also, in MDCT coefficient dequantization, if k is present within B(j') through B(j'+1)1, the gain value takes the value of Gain q'(j').

$$X''_k = Gain\_q'(j') \cdot Shape\_q'(k) \begin{pmatrix} k = B(j'), \cdots, B(j'+1) - 1 \\ j' \in Region(m\_max) \end{pmatrix}$$

$$\ldots(Equation\ 39)$$

$$\begin{cases} C'''^3_{j'} = C''^2_{j'} \\ C'''^2_{j'} = C''^1_{j'} \\ C'''^1_{j'} = Gain\_q'(j) \end{cases} \quad \begin{pmatrix} j' \in Region(m\_max) \\ j = 0, \cdots, L-1 \end{pmatrix} \qquad \ldots(Equation\ 40)$$

Gain dequantization section 2504 outputs decoded MDCT coefficient $X''_k$ calculated in accordance with Equation (39) above to addition MDCT coefficient calculation section 452.

Thus, according to this embodiment, as compared with selecting one region composed of adjacent subbands from among all bands as a quantization target band, a plurality of bands for which it is wished to improve audio quality are set beforehand across a wide range, and a nonconsecutive plurality of bands spanning a wide range are selected as quantization target bands. Consequently, both low-band and high-band quality can be improved at the same time.

In this embodiment, the reason for always fixing subbands included in a quantization target band on the high-band side, as shown in FIG.23, is that encoding distortion is still large for a high band in the first layer of a scalable codec. Therefore, audio quality is improved by also fixedly selecting a high band that has not been encoded with very high precision by the first layer as a quantization target in addition to selecting a low or middle band having perceptual significance to selection as a quantization target in the second layer.

In this embodiment, a case has been described by way of example in which a band that becomes a high-band quantization target is fixed by including the same high-band subbands (specifically, subband indices 15 and 16) throughout all frames, but the present invention is not limited to this, and a band that becomes a high-band quantization target may also be selected from among a plurality of quantization target band candidates for a high-band subband in the same way as for a low-band subband. In such a case, selection may be performed after multiplying by a larger weight the higher the subband area is. It is also possible for bands that become candidates to be changed adaptively according to the input signal sampling rate, coding bit rate, and first layer decoded signal spectral characteristics, or the spectral characteristics of a differential signal for an input signal and first layer decoded signal, or the like. For example, a possible method is to give priority as a quantization target band candidate to a part where the energy distribution of the spectrum (residual MDCT coefficient) of a differential signal for the input signal and first layer decoded signal is high.

In this embodiment, a case has been described by way of example in which a high-band-side subband group composing a region is fixed, and whether or not predictive encoding is to be applied to a gain quantization section is determined according to the number of subbands common to a quantization target band selected in the current frame and a quantization target band selected in a past frame, but the present invention is not limited to this, and predictive encoding may also always be applied to gain of a high-band-side subband group composing a region, with determination of whether or not predictive encoding is to be performed being performed only for a low-band-side subband group. In this case, the number of subbands common to a quantization target band selected in the current frame and a quantization target band selected in a past frame is taken into consideration only for a low-band-side subband group. That is to say, in this case, a quantization vector is quantized after division into a part for which predictive encoding is performed and a part for which predictive encoding is not performed. In this way, since determination of whether or not predictive encoding is necessary for a high-band side fixed subband group composing a region is not performed, and predictive encoding is always performed, gain can be quantized more efficiently.

In this embodiment, a case has been described by way of example in which switching is performed between application and non-application of predictive encoding in a gain quantization section according to the number of subbands common to a quantization target band selected in the current frame and a quantization target band selected one frame back in time, but the present invention is not limited to this, and a number of subbands common to a quantization target band selected in the current frame and a quantization target band selected two or more frames back in time may also be used. In this case, even if the number of subbands common to a quantization target band selected in the current frame and a quantization target band selected one frame back in time is less than or equal to a predetermined value, predictive encoding may be applied in a gain quantization section according to the number of subbands common to a quantization target band selected in the current frame and a quantization target band selected two or more frames back in time.

In this embodiment, a case has been described by way of example in which a region is composed of a low-band-side subband group and a high-band-side subband group, but the present invention is not limited to this, and, for example, a subband group may also be set in a middle band, and a region may be composed of three or more subband groups, the number of subband groups composing a region may also be changed adaptively according to the input signal sampling rate, coding bit rate, and first layer decoded signal spectral characteristics, or the spectral characteristics of a differential signal for an input signal and first layer decoded signal, or the like.

In this embodiment, a case has been described by way of example in which a high-band-side subband group composing a region is fixed throughout all frames, but the present invention is not limited to this, and a low-band-side subband group composing a region may also be fixed throughout all frames. Also, both high-band-side and low-band-side subband groups composing a region may also be fixed throughout all frames, or both high-band-side and low-band-side subband groups may be searched for and selected on a frame-by-frame basis. Moreover, the various above-described methods may be applied to three or more subband groups among subband groups composing a region.

In this embodiment, a case has been described by way of example in which, of subbands composing a region, the number of subbands composing a high-band-side subband group is smaller than the number of subbands composing a low-band-side subband group (the number of high-band-side subband group subbands being two, and the number of low-band-side subband group subbands being three), but the present invention is not limited to this, and the number of subbands composing a high-band-side subband group may also be equal to, or greater than, the number of subbands composing a low-band-side subband group. The number of subbands composing each subband group may also be changed adaptively according to the input signal sampling rate, coding bit rate, first layer decoded signal spectral characteristics, spectral characteristics of a differential signal for an input signal and first layer decoded signal, or the like.

In this embodiment, a case has been described by way of example in which encoding using a CELP encoding method is performed by first layer encoding section 302, but the present invention is not limited to this, and encoding using an encoding method other than CELP (such as transform encoding, for example) may also be performed.

(Embodiment 7)

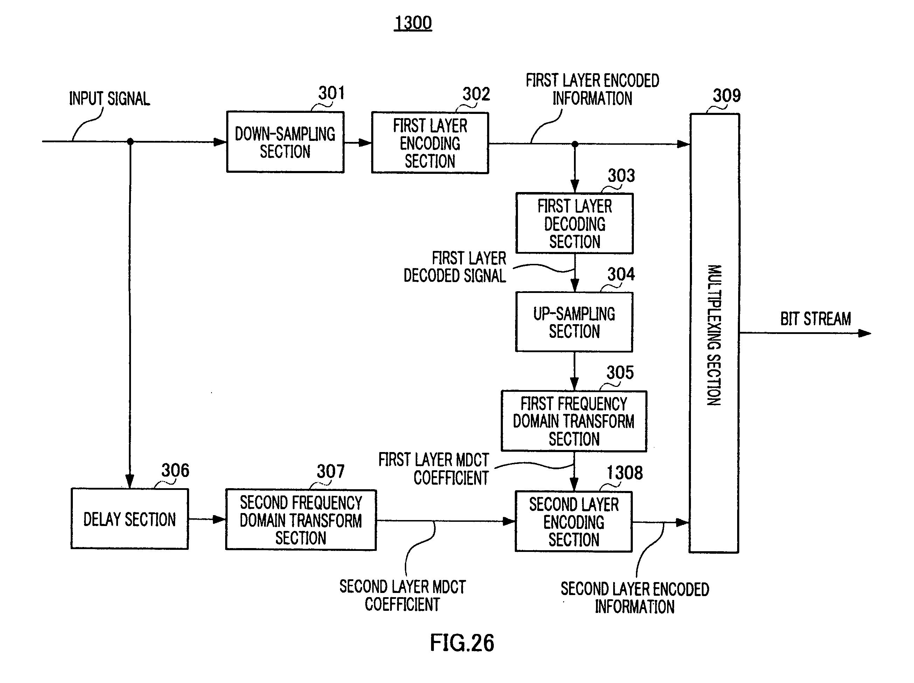

FIG.26 is a block diagram showing the main configuration of speech encoding apparatus 1300 according to Embodiment 7 of the present invention.

In this figure, speech encoding apparatus 1300 is equipped with down-sampling section 301, first layer encoding section 302, first layer decoding section 303, up-sampling section 304, first frequency domain transform section 305, delay section 306, second frequency domain transform section 307, second layer encoding section 1308, and multiplexing section 309, and has a scalable configuration comprising two layers. In the first layer, a CELP speech encoding method is applied, and in the second layer, the speech encoding method described in Embodiment 1 of the present invention is applied.

With the exception of second layer encoding section 1308, configuration elements in speech encoding apparatus 1300 shown in FIG.26 are identical to the configuration elements of speech encoding apparatus 300 shown in FIG.6, and therefore identical configuration elements are assigned the same reference codes and descriptions thereof are omitted here.

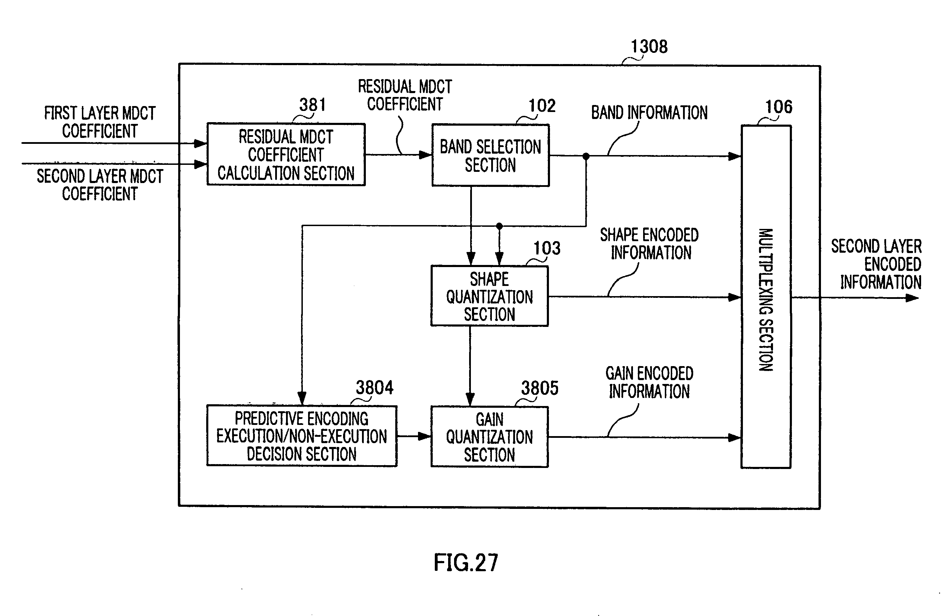

FIG.27 is a block diagram showing the main configuration of the interior of second layer encoding section 1308. Second layer encoding section 1308 mainly comprises residual MDCT coefficient calculation section 381, band selection section 102, shape quantization section 103, predictive encoding execution/non-execution decision section 3804, gain quantization section 3805, and multiplexing section 106. With the exception of predictive encoding execution/non-execution decision section 3804 and gain quantization section 3805, configuration elements in second layer encoding section 1308 are identical to the configuration elements of second layer encoding section 308 shown in FIG.7, and therefore identical configuration elements are assigned the same reference codes and descriptions thereof are omitted here.

Predictive encoding execution/non-execution decision section 3804 has an internal buffer that stores band information m_max input from band selection section 102 in a past frame. Here, a case will be described by way of example in which predictive encoding execution/non-execution decision section 3804 has an internal buffer that stores band information m_max for the past three frames. Predictive encoding execution/non-execution decision section 3804 first detects a subband common to a past-frame quantization target band and current-frame quantization target band using band information m_max input from band selection section 102 in a past frame and band information m_max input from band selection section 102 in the current frame. Of L subbands indicated by band information m_max input from band selection section 102, predictive encoding execution/non-execution decision section 3804 determines that predictive encoding is to be applied, and sets Pred_Flag(j)=ON, for a subband selected as a quantization target one frame back in time. On the other hand, of L subbands indicated by band information m_max input from band selection section 102, predictive encoding execution/non-execution decision section 3804 determines that predictive encoding is not to be applied, and sets Pred_Flag(j)=OFF, for a subband not selected as a quantization target one frame back in time. Here, Pred_Flag is a flag indicating a predictive encoding application/non-application determination result for each subband, with an ON value meaning that predictive encoding is to be applied to a subband gain value, and an OFF value meaning that predictive encoding is not to be applied to a subband gain value. Predictive encoding execution/non-execution decision section 3804 outputs a determination result for each subband to gain quantization section 3805. Then predictive encoding execution/non-execution decision section 3804 updates the internal buffer storing band information using band information m_max input from band selection section 102 in the current frame.

Gain quantization section 3805 has an internal buffer that stores a quantization gain value obtained in a past frame. Gain quantization section 3805 switches between execution/non-execution of application of predictive encoding in current-frame gain value quantization according to a determination result input from predictive encoding execution/non-execution decision section 3804. For example, if predictive encoding is to be performed, gain quantization section 3805 searches an internal gain codebook composed of quantity GQ of gain code vectors for each of L subbands, performs a distance calculation corresponding to the determination result input from predictive encoding execution/non-execution decision section 3804, and finds an index of a gain code vector for which the result of Equation (41) below is a minimum. In Equation (41), one or other distance calculation is performed according to Pred_Flag (j) for all j' s satisfying $j \in$ Region (m_max), and a gain vector index is found for which the total value of the error is a minimum.

$$Gain\_q(i) = \begin{cases} \sum_{j \in Region(m\_max)} \left\{ Gain\_i(j) - \sum_{r=1}^{3}(\alpha_r \cdot C_j^r) - \alpha_0 \cdot GC_k^i \right\}^2 & (if(Pred\_Flag(j) == ON)) \\ \sum_{j \in Region(m\_max)} \left\{ Gain\_i(j) - GC_k^i \right\}^2 & (if(Pred\_Flag(j) == OFF)) \end{cases} \quad \begin{pmatrix} i = 0, \cdots, GQ-1 \\ k = 0, \cdots, L-1 \end{pmatrix}$$

$$\ldots (\text{Equation } 41)$$

In this equation, $GC_k^i$ indicates a gain code vector composing a gain codebook, i indicates a gain code vector index, and k indicates an index of a gain code vector element. For example, if the number of subbands composing a region is five (L=5), k has a value of 0 to 4. Here, $C_j^t$ indicates a gain value of t frames before in time, so that when t=1, for example, $C_j^t$ indicates a gain value of one frame before in time. Also, $\alpha$ is a 4th-order linear prediction coefficient stored in gain quantization section 3805. Gain quantization section 3805 treats L subbands within one region as an L-dimensional vector, and performs vector quantization.

Gain quantization section 3805 outputs gain code vector index G_min for which the result of Equation (41) above is a minimum to multiplexing section 106 as gain encoded information.

Gain quantization section 3805 outputs G_min to multiplexing section 106 as gain encoded information. Gain quantization section 3805 also updates the internal buffer in accordance with Equation (42) below using gain encoded information G_min and quantization gain value $C_j^t$ obtained in the current frame. In Equation (42), a $C_{j'}^i$ value is updated with gain code vector $GC_j^{G\_min}$ j element index j and j' satisfying j' $\in$ Region (m_max) respectively associated in ascending order.

$$\begin{cases} C_{j'}^3 = C_{j'}^2 \\ C_{j'}^2 = C_{j'}^1 \\ C_{j'}^1 = GC_{j'}^{G\_min} \end{cases} \quad \begin{pmatrix} j' \in Region(m\_max) \\ j = 0, \cdots, L-1 \end{pmatrix} \quad \ldots (\text{Equation } 42)$$

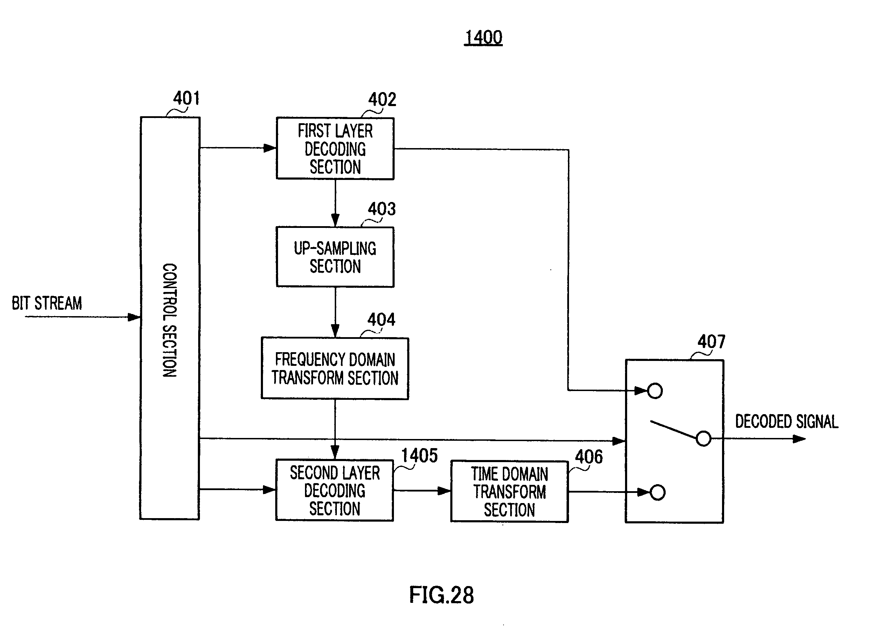

FIG.28 is a block diagram showing the main configuration of speech decoding apparatus 1400 according to this embodiment.

In this figure, speech decoding apparatus 1400 is equipped with control section 401, first layer decoding section 402, up-sampling section 403, frequency domain transform section 404, second layer decoding section 1405, time domain transform section 406, and switch 407.

With the exception of second layer decoding section 1405, configuration elements in speech decoding apparatus 1400 shown in FIG.28 are identical to the configuration elements of speech decoding apparatus 400 shown in FIG.8, and therefore identical configuration elements are assigned the same reference codes and descriptions thereof are omitted here.

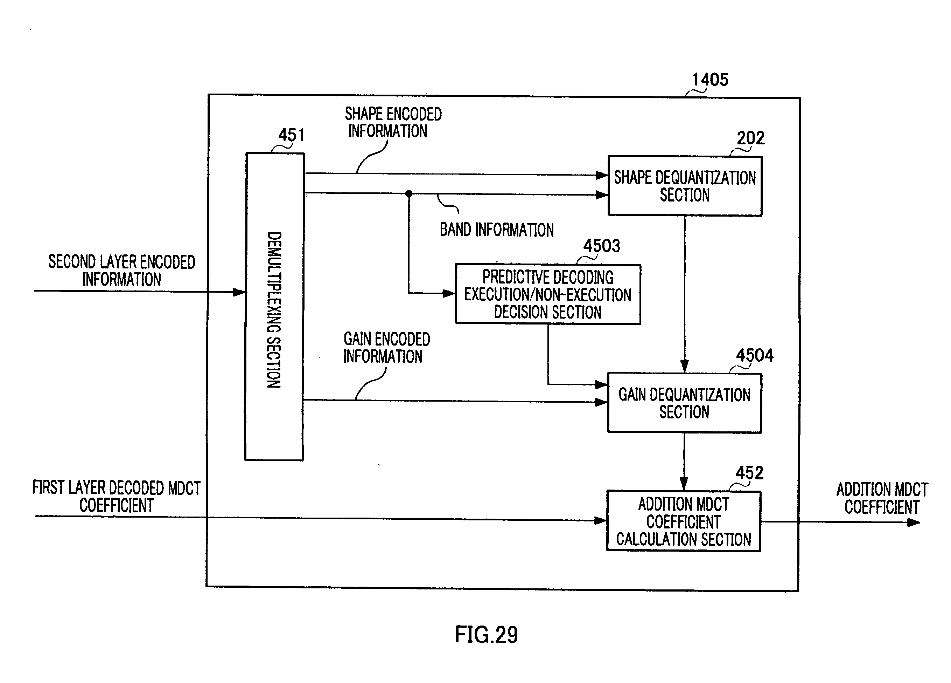

FIG.29 is a block diagram showing the main configuration of the interior of second layer decoding section 1405. Second layer decoding section 1405 mainly comprises demultiplexing section 451, shape dequantization section 202, predictive decoding execution/non-execution decision section 4503, gain dequantization section 4504, and addition MDCT coefficient calculation section 452. With the exception of predictive decoding execution/non-execution decision section 4503 and gain dequantization section 4504, configuration elements in second layer decoding section 1405 shown in FIG.29 are identical to the configuration elements of second layer decoding section 405 shown in FIG.9, and therefore identical configuration elements are assigned the same reference codes and descriptions thereof are omitted here.

Predictive decoding execution/non-execution decision section 4503 has an internal buffer that stores band information m_max input from demultiplexing section 451 in a past frame. Here, a case will be described by way of example in which predictive decoding execution/non-execution decision section 4503 has an internal buffer that stores band information m_max for the past three frames. Predictive decoding execution/non-execution decision section 4503 first detects a subband common to a past-frame quantization target band and current-frame quantization target band using band information m_max input from demultiplexing section 451 in a past frame and band information m_max input from demultiplexing section 451 in the current frame. Of L subbands indicated by band information m_max input from demultiplexing section 451, predictive decoding execution/non-execution decision section 4503 determines that predictive decoding is to be applied, and sets Pred_Flag(j)=ON, for a subband selected as a quantization target one frame back in time. On the other hand, of L subbands indicated by band information m_max input from demultiplexing section 451, predictive decoding execution/non-execution decision section 4503 determines that predictive decoding is not to be applied, and sets Pred_Flag(j)=OFF, for a subband not selected as a quantization target one frame back in time. Here, Pred_Flag is a flag indicating a predictive decoding application/non-application determination result for each subband, with an ON value meaning that predictive decoding is to be applied to a subband gain value, and an OFF value meaning that predictive decoding is not to be applied to a subband gain value. Next, predictive decoding execution/non-execution decision section 4503 outputs a determination result for each subband to gain dequantization section 4504. Then predictive decoding execution/non-execution decision section 4503 updates the internal buffer storing band information using band information m_max input from demultiplexing section 451 in the current frame.

Gain dequantization section 4504 has an internal buffer that stores a gain value obtained in a past frame, and switches between execution/non-execution of application of predictive decoding in current-frame gain value decoding according to a determination result input from predictive decoding execution/non-execution decision section 4503. Gain dequantization section 4504 has the same kind of internal gain codebook as gain quantization section 105 of speech encoding apparatus 100, and when performing predictive decoding, for example, obtains gain value Gain_q' by performing gain dequantization in accordance with Equation (43) below. Here, $C''^t_j$ indicates a gain value of t frames before in time, so that when t=1, for example, $C''^t_j$ indicates a gain value of one frame before. Also, $\alpha$ is a 4th-order linear prediction coefficient stored in gain dequantization section 4504. Gain dequantization section 4504 treats L subbands within one region as an L-dimensional vector, and performs vector dequantization. In Equation (43), a Gain_q' (j') value is calculated with gain code vector $GC^{G\_min}_k$ element index k and j' satisfying j' $\in$ Region(m_max) respectively associated in ascending order.

$$Gain\_q'(j') = \begin{cases} (if(Pred\_Flag(j') == ON)) \\ \sum_{i=1}^{3}\left(\alpha_i \cdot C''^i_j\right) + \alpha_0 \cdot GC^{G-\min}_k \quad \begin{pmatrix} j' \in Region(m\_max) \\ k = 0,\cdots,L-1 \end{pmatrix} \\ (if(Pred\_Flag(j') == OFF)) \\ GC^{G-\min}_k \end{cases}$$

$$\ldots(Equation\ 43)$$

Next, gain dequantization section 4504 calculates a decoded MDCT coefficient in accordance with Equation (44) below using a gain value obtained by current-frame dequantization and a shape value input from shape dequantization section 202, and updates the internal buffer in accordance with Equation (45) below. In Equation (45), a $C''^1_{j'}$ value is updated with j of dequantized gain value Gain_q' (j) and j' satisfying j' $\in$ Region(m_max) respectively associated in ascending order. Here, a calculated decoded MDCT coefficient is denoted by $X''_k$. Also, in MDCT coefficient dequantization, if k is present within B (j') through B(j'+1)-1, the gain value takes the value of Gain_q'(j') .

$$X''_k = Gain\_q'(j') \cdot Shape\_q'(k) \quad \begin{pmatrix} k = B(j'),\cdots,B(j'+L)-1 \\ j' \in Region(m\_max) \end{pmatrix}$$

$$\ldots(Equation\ 44)$$

$$\begin{cases} C''^3_{j'} = C''^2_{j'} \\ C''^2_{j'} = C''^1_{j'} \\ C''^1_{j'} = Gain\_q'(j) \end{cases} \quad \begin{pmatrix} j' \in Region(m\_max) \\ j = 0,\cdots,L-1 \end{pmatrix} \quad \ldots(Equation\ 45)$$

Gain dequantization section 4504 outputs decoded MDCT coefficient $X''_k$ calculated in accordance with Equation (44) above to addition MDCT coefficient calculation section 452.

Thus, according to this embodiment, at the time of gain quantization of a quantization target band selected in each frame, whether or not each subband included in a quantization target band was quantized in a past frame is detected. Then vector quantization is performed, with predictive encoding being applied to a subband quantized in a past frame, and with predictive encoding not being applied to a subband not quantized in a past frame. By this means, frequency domain parameter encoding can be carried out more efficiently than with a method whereby predictive encoding application/non-application switching is performed for an entire vector.

In this embodiment, a method has been described whereby switching is performed between application and non-application of predictive encoding in a gain quantization section according to the number of subbands common to a quantization target band selected in the current frame and a quantization target band selected one frame back in time, but the present invention is not limited to this, and a number of subbands common to a quantization target band selected in the current frame and a quantization target band selected two or more frames back in time may also be used. In this case, even if the number of subbands common to a quantization target band selected in the current frame and a quantization target band selected one frame back in time is less than or equal to a predetermined value, predictive encoding may be applied in a gain quantization section according to the number of subbands common to a quantization target band selected in the current frame and a quantization target band selected two or more frames back in time.

It is also possible for the quantization method described in this embodiment to be combined with the quantization target band selection method described in Embodiment 6. A case will be described in which, for example, a region that is a quantization target band is composed of a low-band-side subband group and a high-band-side subband group, the high-band-side subband group is fixed throughout all frames, and a vector in which low-band-side subband group gain and high-band-side subband group are made consecutive is quantized. In this case, within a quantization target band gain vector, vector quantization is performed with predictive encoding always being applied for an element indicating high-band-side subband group gain, and predictive encoding not being applied for an element indicating low-band-side subband group gain. By this means, gain vector quantization can be carried out more efficiently than when predictive encoding application/non-application switching is performed for an entire vector. At this time, in low-band-side subband group, a method whereby vector quantization is performed with predictive encoding being applied to a subband quantized in a past frame, and with predictive encoding not being applied to a subband not quantized in a past frame, is also efficient. Also, for an element indicating low-band-side subband group gain, quantization is performed by switching between application and non-application of predictive encoding using subbands composing a quantization target band selected in a past frame in time, as described in Embodiment 1. By this means, gain vector quantization can be performed still more efficiently. It is also possible for the present invention to be applied to a configuration that combines above-described configurations.

This concludes a description of embodiments of the present invention.

In the above embodiments, cases have been described by way of example in which the method of selecting a quantization target band is to select the region with the highest energy in all bands, but the present invention is not limited to this, and a certain band may also be preliminarily selected beforehand, after which a quantization target band is finally selected in the preliminarily selected band. In such a case, a preliminarily selected band may be decided according to the input signal sampling rate, coding bit rate, or the like. For example, one method is to select a low band preliminarily when the sampling rate is low.

In the above embodiments, MDCT is used as a transform encoding method, and therefore "MDCT coefficient" used in the above embodiments essentially means "spectrum". Therefore, the expression "MDCT coefficient" may be replaced by "spectrum".

In the above embodiments, examples have been shown in which speech decoding apparatuses 200, 200a, 400, 600, 800, 1010, 1200, and 1400 receive as input and process encoded data transmitted from speech encoding apparatuses 100, 100a, 300, 500, 700, 1000, 1100, and 1300, respectively, but encoded data output by an encoding apparatus of a different configuration capable of generating encoded data having a similar configuration may also be input and processed.

An encoding apparatus, decoding apparatus, and method thereof according to the present invention are not limited to the above-described embodiments, and various variations and modifications may be possible without departing from the scope of the present invention. For example, it is possible for embodiments to be implemented by being combined appropriately.

It is possible for an encoding apparatus and decoding apparatus according to the present invention to be installed in a communication terminal apparatus and base station apparatus in a mobile communication system, thereby enabling a communication terminal apparatus, base station apparatus, and mobile communication system that have the same kind of operational effects as described above to be provided.

A case has here been described by way of example in which the present invention is configured as hardware, but it is also possible for the present invention to be implemented by software. For example, the same kind of functions as those of an encoding apparatus and decoding apparatus according to the present invention can be realized by writing an algorithm of an encoding method and decoding method according to the present invention in a programming language, storing this program in memory, and having it executed by an information processing means.

The function blocks used in the descriptions of the above embodiments are typically implemented as LSIs, which are integrated circuits. These may be implemented individually as single chips, or a single chip may incorporate some or all of them.

Here, the term LSI has been used, but the terms IC, system LSI, super LSI, ultra LSI, and so forth may also be used according to differences in the degree of integration.

The method of implementing integrated circuitry is not limited to LSI, and implementation by means of dedicated circuitry or a general-purpose processor may also be used. An FPGA (Field Programmable Gate Array) for which programming is possible after LSI fabrication, or a reconfigurable processor allowing reconfiguration of circuit cell connections and settings within an LSI, may also be used.

In the event of the introduction of an integrated circuit implementation technology whereby LSI is replaced by a different technology as an advance in, or derivation from, semiconductor technology, integration of the function blocks may of course be performed using that technology. The application of biotechnology or the like is also a possibility.

Industrial Applicability

An encoding apparatus and so forth according to the present invention is suitable for use in a communication terminal apparatus, base station apparatus, or the like, in a mobile communication system.

**Claims**

**1.** A speech encoding apparatus (100, 100a, 500, 700) adapted to perform encoding on a frame-by-frame basis, the speech encoding apparatus comprising:

a transform section (101) adapted to transform an input audio/speech signal to a frequency domain for obtaining a frequency domain parameter;
a selection section (102) adapted to divide the frequency domain parameter into a plurality of subbands, and further adapted to select a quantization target band composed of a natural number of consecutive subbands of the plurality of subbands, and further adapted to generate a band information indicating the quantization target band;
a shape quantization section (103) adapted to quantize a shape of the frequency domain parameter in the quantization target band;
a gain quantization section (105, 505, 705) adapted to encode a gain of the frequency domain parameter in the quantization target band for obtaining a gain encoded information; and
a determination section (104) adapted:

to determine that predictive encoding is to be performed when the number of subbands common to the current-frame quantization target band and a quantization target band selected in the past is equal to or greater than a predetermined value, and
to determine that predictive encoding is not to be performed when the number of common subbands is less than the predetermined value,

wherein the gain quantization section is adapted:

to obtain the gain encoded information by performing predictive encoding on the gain of the frequency domain parameter in the quantization target band using past gain encoded information when the determination section has determined that predictive encoding is to be performed, and
to obtain the gain encoded information by directly quantizing the gain of the frequency domain parameter in the quantization target band when the determination section has determined that predictive encoding is not to be performed.

**2.** The speech encoding apparatus according to claim 1, wherein the gain quantization section is further adapted to obtain the gain encoded information by performing vector quantization of the gain of the frequency domain parameter.

**3.** The speech encoding apparatus according to claim 1, wherein the gain quantization section is further adapted to obtain the gain encoded information by performing predictive quantizing of the gain using a gain of a frequency domain parameter in a past frame.

4. The speech encoding apparatus according to claim 1, wherein the selection section is further adapted to select a region for which energy is highest among regions composed of a plurality of subbands as the quantization target band.

5. The speech encoding apparatus according to claim 1, wherein the selection section is further adapted to select a band for which energy is highest among the candidate bands as the quantization target band, when the candidate bands exist for which a number of subbands common to the quantization target band selected in the past is equal to or greater than a predetermined value and energy is equal to or greater than a predetermined value, and wherein the selection section is further adapted to select a band for which energy is highest in all bands of the frequency domain as the quantization target band, when the candidate bands do not exist.

6. The speech encoding apparatus according to claim 1, wherein the selection section is further adapted to select a band closest to the quantization target band selected in the past among bands for which energy is equal to or greater than a predetermined value as the quantization target band.

7. The speech encoding apparatus according to claim 1, wherein the selection section is further adapted to select the quantization target band after multiplication by a weight that is larger the more toward a low-band side a subband is.

8. The speech encoding apparatus according to claim 1, wherein the selection section is further adapted to select a low-band-side fixed subband as the quantization target band.

9. The speech encoding apparatus according to claim 1, wherein the selection section is further adapted to select the quantization target band after multiplication by a weight that is larger the higher the frequency of selection in the past of a subband is.

10. The speech encoding apparatus according to claim 1, further comprising an interpolation section (504) adapted to perform interpolation on a gain of a frequency domain parameter in a subband not quantized in the past among subbands indicated by the band information using past gain encoded information, for obtaining an interpolation value, wherein the gain quantization section is further adapted to also use the interpolation value when performing the predictive encoding.

11. The speech encoding apparatus according to claim 1, further comprising a deciding section (704) adapted to decide a prediction coefficient such that a weight of a gain value of a past frame is larger the larger a subband common to a quantization target band of a past frame and a quantization target band of a current frame is, wherein the gain quantization section is further adapted to use the prediction coefficient when performing the predictive encoding.

12. The speech encoding apparatus according to claim 1, wherein the selection section is further adapted to fixedly select a predetermined subband as part of the quantization target band.

13. The speech encoding apparatus according to claim 1, wherein the selection section is further adapted to select the quantization target band after multiplication by a weight that is larger the more toward a high-band side a subband is in part of the quantization target band.

14. The speech encoding apparatus according to claim 1, wherein the gain quantization section is further adapted to perform predictive encoding on a gain of a frequency domain parameter in part of the quantization target band, and to perform non-predictive encoding on a gain of a frequency domain parameter in a remaining part.

15. The speech encoding apparatus according to claim 1, wherein the gain quantization section is further adapted to perform vector quantization of the gain of a nonconsecutive plurality of subbands.

16. A speech decoding apparatus (200, 200a, 600, 800) comprising:

a receiving section (201) adapted to receive band information indicating a quantization target band, which is composed of a natural number of consecutive subbands of a plurality of subbands, wherein the plurality of subbands is a subdivided frequency domain parameter of an input audio/speech signal;
a shape dequantization section (202) adapted to decode a shape encoded information in which a shape of a frequency domain parameter in the quantization target band is quantized, for generating a decoded shape;
a gain dequantization section (204, 604, 804) adapted to decode a gain encoded information, in which a gain of the frequency domain parameter in the quantization target band is quantized, for generating a decoded gain, and to decode a frequency parameter using the decoded shape and the decoded gain for generating a decoded frequency domain parameter;

a time domain transform section (205) adapted to transform the decoded frequency domain parameter to a time domain for obtaining a time domain decoded signal; and

a determination section (203) adapted:

to find a number of subbands common to a current-frame quantization target band and a past-frame quantization target band using the received band information to determine that predictive decoding is to be performed when the number of subbands common to the current-frame quantization target band and a past-frame quantization target band is equal to or greater than a predetermined value, and

to determine that predictive decoding is not to be performed when the number of common subbands is less than the predetermined value,

wherein the gain dequantization section is adapted:

to perform predictive decoding of the gain of the frequency domain parameter in the current-frame quantization target band using gain obtained in past gain decoding, when the determination section has determined that predictive decoding is to be performed; and

to directly perform dequantization of the gain encoded information, in which gain of a frequency domain parameter is quantized in the current-frame quantization target band when the determination section has determined that predictive decoding is not to be performed.

17. A speech encoding method for performing encoding on a frame-by-frame basis, the method comprising the steps of:

transforming an input audio/speech signal to a frequency domain for obtaining a frequency domain parameter;

dividing the frequency domain parameter into a plurality of subbands;

selecting a quantization target band composed of a natural number of consecutive subbands of the plurality of subbands;

generating a band information indicating the quantization target band;

quantizing a shape of the frequency domain parameter in the quantization target band for obtaining a shape encoded information;

encoding a gain of the frequency domain parameter in the quantization target band for obtaining a gain encoded information;

determining that predictive encoding is to be performed when the number of subbands common to the current-frame quantization target band and a quantization target band selected in the past is equal to or greater than a predetermined value;

determining that predictive encoding is not to be performed when the number of common subbands is less than the predetermined value;

obtaining the gain encoded information by performing predictive encoding on the gain of the frequency domain parameter in the quantization target band using past gain encoded information, when it is determined that predictive encoding is to be performed; and

obtaining the gain encoded information by directly quantizing the gain of the frequency domain parameter in the quantization target band, when it is determined that predictive encoding is not to be performed.

18. A speech decoding method comprising the steps of:

receiving band information indicating a quantization target band, which is composed of a natural number of consecutive subbands of a plurality of subbands, wherein the plurality of subbands is a subdivided frequency domain parameter of an input audio/speech signal;

decoding a shape encoded information in which a shape of a frequency domain parameter in the quantization target band is quantized,for generating a decoded shape;

decoding a gain encoded information, in which a gain of a frequency domain parameter in the quantization target band is quantized, for generating a decoded gain;

decoding the frequency domain parameter using the decoded shape and the decoded gain for generating a decoded frequency domain parameter;

transforming the decoded frequency domain parameter to a time domain for obtaining a time domain decoded signal;

finding a number of subbands common to a current-frame quantization target band and a past-frame quantization target band using the received band information;
determining that predictive decoding is to be performed when the number of subbands common to the current-frame quantization target band and a past-frame quantization target band is equal to or greater than a predetermined value;
determining that predictive decoding is not to be performed when the number of common subbands is less than the predetermined value;
performing predictive decoding of the gain of the frequency domain parameter in the current-frame quantization target band using gain obtained in past gain decoding, when it is determined that predictive decoding is to be performed; and
directly performing dequantization of the gain encoded information, in which gain of a frequency domain parameter is quantized in the current-frame quantization target band, when it is determined that predictive decoding is not to be performed.

**Patentansprüche**

1. Sprachkodierungsvorrichtung (100, 100a, 500, 700), die dazu eingerichtet ist, eine Kodierung auf Rahmen-für-Rahmen-Basis durchzuführen, wobei die Sprachkodierungsvorrichtung umfasst:

Einen Transformierungsabschnitt (101), der dazu eingerichtet ist, ein Eingangs-Audio/Sprachsignal in einen Frequenzbereich zu transformieren, um einen Frequenzbereichsparameter zu erhalten;
einen Auswahlabschnitt (102), der dazu eingerichtet ist, den Frequenzbereichsparameter in eine Vielzahl von Teilbändern zu teilen und der des Weiteren dazu eingerichtet ist, ein Quantisierungs-Zielband auszuwählen, das aus einer natürlichen Zahl von aufeinander folgenden Teilbändern der Vielzahl von Teilbändern zusammengesetzt ist, und der des Weiteren dazu eingerichtet ist, eine Bandinformation zu erzeugen, welche das Quantisierungs-Zielband anzeigt;
einen Form-Quantisierungsabschnitt (103), der dazu eingerichtet ist, eine Form des Frequenzbereichsparameters in dem Quantisierungs-Zielband zu quantisieren;
einen Verstärkungs-Quantisierungsabschnitt (105, 505, 705), der dazu eingerichtet ist, eine Verstärkung des Frequenzbereichsparameters in dem Quantisierungs-Zielband zu kodieren, um eine verstärkungskodierte Information zu erhalten; und
einen Bestimmungsabschnitt (104), der dazu eingerichtet ist:

zu bestimmen, dass prädiktive Kodierung durchzuführen ist, wenn die Anzahl der gemeinsamen Teilbänder des Quantisierungs-Zielbands des aktuellen Rahmens und eines in der Vergangenheit gewählten Quantisierungs-Zielbands gleich oder größer als ein vorgegebener Wert ist, und
zu bestimmen, dass keine prädiktive Kodierung durchzuführen ist, wenn die Anzahl der gemeinsamen Teilbänder kleiner als der vorgegebene Wert ist,

wobei der Verstärkungs-Quantisierungsabschnitt dazu eingerichtet ist:

die verstärkungskodierte Information durch Durchführen von prädiktiver Kodierung an der Verstärkung des Frequenzbereichsparameter in dem Quantisierungs-Zielband unter Verwendung vorheriger verstärkungskodierter Information zu erhalten, wenn der Bestimmungsabschnitt bestimmt hat, dass prädiktive Kodierung durchzuführen ist, und
die verstärkungskodierte Information durch direktes Quantisieren der Verstärkung des Frequenzbereichsparameters in dem Quantisierungs-Zielband zu erhalten, wenn der Bestimmungsabschnitt bestimmt hat, dass keine prädiktive Kodierung durchzuführen ist.

2. Sprachkodierungsvorrichtung nach Anspruch 1, wobei der Verstärkungs-Quantisierungsabschnitt des Weiteren dazu eingerichtet ist, die verstärkungskodierte Information durch Durchführen von Vektorquantisierung der Verstärkung des Frequenzbereichsparameters zu erhalten.

3. Sprachkodierungsvorrichtung nach Anspruch 1, wobei der Verstärkungs-Quantisierungsabschnitt des Weiteren dazu eingerichtet ist, die verstärkungskodierte Information durch Durchführen von prädiktiver Quantisierung der Verstärkung unter Verwendung einer Verstärkung eines Frequenzbereichsparameters in einem vorherigen Rahmen zu erhalten.

4. Sprachkodierungsvorrichtung nach Anspruch 1, wobei der Auswahlabschnitt des Weiteren dazu eingerichtet ist, einen Bereich, für den die Energie am höchsten ist, aus Bereichen, die aus einer Vielzahl von Teilbändern zusammengesetzt sind, als das Quantisierungs-Zielband auszuwählen.

5. Sprachkodierungsvorrichtung nach Anspruch 1, wobei der Auswahlabschnitt des Weiteren dazu eingerichtet ist, ein Band, für das die Energie am höchsten ist, aus den in Frage kommenden Bändern als das Quantisierungs-Zielband auszuwählen, wenn diejenigen in Frage kommenden Bänder existieren, für die eine Anzahl der gemeinsamen Teilbänder des in der Vergangenheit gewählten Quantisierungs-Zielbands gleich oder größer als ein vorgegebener Wert ist und die Energie gleich oder größer als ein vorgegebener Wert ist, und wobei der Auswahlabschnitt des Weiteren dazu eingerichtet ist, ein Band, für das die Energie am höchsten ist, aus allen Bändern des Frequenzbereichs als das Quantisierungs-Zielband auszuwählen, wenn die in Frage kommenden Bänder nicht existieren.

6. Sprachkodierungsvorrichtung nach Anspruch 1, wobei der Auswahlabschnitt des Weiteren dazu eingerichtet ist, ein Band, das dem in der Vergangenheit ausgewählten Quantisierung-Zielband am nächsten kommt, aus Bändern, für welche die Energie gleich oder größer als ein vorgegebener Wert ist, als das Quantisierungs-Zielband auszuwählen.

7. Sprachkodierungsvorrichtung nach Anspruch 1, wobei der Auswahlabschnitt des Weiteren dazu eingerichtet ist, das Quantisierungs-Zielband nach der Multiplikation mit einem Gewichtsfaktor auszuwählen, das umso größer ist, je weiter sich ein Teilband auf einer Niedrigbandseite befindet.

8. Sprachkodierungsvorrichtung nach Anspruch 1, wobei der Auswahlabschnitt des Weiteren dazu eingerichtet ist, ein festes Teilband auf der Niedrigbandseite als das Quantisierungs-Zielband auszuwählen.

9. Sprachkodierungsvorrichtung nach Anspruch 1, wobei der Auswahlabschnitt des Weiteren dazu eingerichtet ist, das Quantisierungs-Zielband nach der Multiplikation mit einem Gewichtsfaktor auszuwählen, das umso größer ist, je höher die in der Vergangenheit ausgewählte Frequenz eines Teilbands ist.

10. Sprachkodierungsvorrichtung nach Anspruch 1, des Weiteren umfassend einen Interpolationsabschnitt (504), der dazu eingerichtet ist, Interpolation an einer Verstärkung eines Frequenzbereichsparameters in einem in der Vergangenheit nicht quantisierten Teilband aus Teilbändern, die von der Bandinformation angezeigt werden, unter Verwendung vergangener verstärkungskodierter Informationen durchzuführen, um einen Interpolationswert zu erhalten, wobei der Verstärkungs-Quantisierungsabschnitt des Weiteren dazu eingerichtet ist, den Interpolationswert auch bei der Durchführung der prädiktiven Kodierung zu verwenden.

11. Sprachkodierungsvorrichtung nach Anspruch 1, des Weiteren umfassend einen Festlegungsabschnitt (704), der dazu eingerichtet ist, einen Prädiktionskoeffizienten so festzulegen, dass ein Gewichtsfaktor eines Verstärkungswerts eines vergangenen Rahmens größer ist, je größer ein gemeinsames Teilband eines Quantisierungs-Zielbands eines vergangenen Rahmens und eines Quantisierungs-Zielbands eines aktuellen Rahmen ist, wobei der Verstärkungs-Quantisierungsabschnitt des Weiteren dazu eingerichtet ist, den Prädiktionskoeffizienten bei der Durchführung der prädiktiven Kodierung zu verwenden.

12. Sprachkodierungsvorrichtung nach Anspruch 1, wobei der Auswahlabschnitt des Weiteren dazu eingerichtet ist, ein vorgegebenes Teilband als Teil des Quantisierungs-Zielbands fest auszuwählen.

13. Sprachkodierungsvorrichtung nach Anspruch 1, wobei der Auswahlabschnitt des Weiteren dazu eingerichtet ist, das Quantisierungs-Zielband nach der Multiplikation mit einem Gewichtsfaktor auszuwählen, das umso größer ist, je weiter sich ein Teilband in einem Teil des Quantisierungs-Zielbands auf einer Hochbandseite befindet.

14. Sprachkodierungsvorrichtung nach Anspruch 1, wobei der Verstärkungs-Quantisierungsabschnitt des Weiteren dazu eingerichtet ist, prädiktive Kodierung an einer Verstärkung eines Frequenzbereichsparameters in einem Teil des Quantisierungs-Zielbands durchzuführen und nicht-prädiktive Kodierung an einer Verstärkung eines Frequenzbereichsparameters in einem verbleibenden Teil durchzuführen.

15. Sprachkodierungsvorrichtung nach Anspruch 1, wobei der Verstärkungs-Quantisierungsabschnitt des Weiteren dazu eingerichtet ist, Vektorquantisierung der Verstärkung einer nicht aufeinander folgenden Vielzahl von Teilbändern durchzuführen.

16. Sprachkodierungsvorrichtung (200, 200a, 600, 800), umfassend:

einen Empfangsabschnitt (201), der dazu eingerichtet ist, Bandinformationen zu empfangen, die ein Quantisierungs-Zielband anzeigen, das aus einer natürlichen Zahl aufeinander folgender Teilbänder einer Vielzahl von Teilbändern zusammengesetzt ist, wobei die Vielzahl von Teilbändern ein unterteilter Frequenzbereichsparameter eines Eingangs-Audio/Sprachsignals ist;

einen Form-Dequantisierungsabschnitt (202), der dazu eingerichtet ist, eine formkodierte Information, in welcher eine Form eines Frequenzbereichsparameters in dem Quantisierungs-Zielband quantisiert ist, zu dekodieren, um eine dekodierte Form zu erzeugen;

einen Verstärkungs-Dequantisierungsabschnitt (204, 604, 804), der dazu eingerichtet ist, eine verstärkungskodierte Information, in der eine Verstärkung des Frequenzbereichsparameters in dem Quantisierungs-Zielband quantisiert ist, zu dekodieren, um eine dekodierte Verstärkung zu erzeugen, und einen Frequenzparameter unter Verwendung der dekodierten Form und der dekodierten Verstärkung zu dekodieren, um einen dekodierten Frequenzbereichsparameter zu erzeugen;

einen Zeitbereichs-Transformationsabschnitt (205), der dazu eingerichtet ist, den dekodierten Frequenzbereichsparameter in einen Zeitbereich zu transformieren,

um ein zeitbereichsdekodiertes Signal zu erhalten; und

einen Bestimmungsabschnitt (203), der dazu eingerichtet ist:

eine Anzahl von gemeinsamen Teilbändern eines Quantisierungs-Zielbands eines aktuellen Rahmens und eines Quantisierungs-Zielbands eines vergangenen Rahmens zu suchen, unter Verwendung der empfangenen Bandinformationen, um zu bestimmen, dass prädiktive Dekodierung durchgeführt werden muss, wenn die Anzahl der gemeinsamen Teilbänder des Quantisierungs-Zielbands des aktuellen Rahmens und des Quantisierungs-Zielbands eines vergangenen Rahmens gleich oder größer als ein vorgegebener Wert ist, und

zu bestimmen, dass keine prädiktive Dekodierung durchzuführen ist, wenn die Anzahl der gemeinsamen Teilbänder kleiner als der vorgegebene Wert ist;

wobei der Verstärkungs-Dequantisierungsabschnitt dazu eingerichtet ist:

prädiktive Dekodierung der Verstärkung des Frequenzbereichsparameters in dem Quantisierungs-Zielband des aktuellen Rahmens unter Verwendung einer in einer vergangenen Verstärkungsdekodierung erhaltenen Verstärkung durchzuführen, wenn der Bestimmungsabschnitt bestimmt hat, dass prädiktive Dekodierung durchgeführt werden muss; und

die Dequantisierung der verstärkungskodierten Information direkt durchzuführen, in welcher die Verstärkung eines Frequenzbereichsparameters in dem Quantisierungs-Zielband des aktuellen Rahmens quantisiert ist, wenn der Bestimmungsabschnitt bestimmt hat, dass keine prädiktive Dekodierung durchzuführen ist.

17. Sprachkodierungsverfahren zum Durchführen der Kodierung auf Rahmen-für-Rahmen-Basis, wobei das Verfahren folgende Schritte umfasst:

Transformieren eines Eingangs-Audio/Sprachsignals in einen Frequenzbereich, um einen Frequenzbereichsparameter zu erhalten;

Teilen des Frequenzbereichsparameters in eine Vielzahl von Teilbändern;

Auswählen eines Quantisierungs-Zielbands, das aus einer natürlichen Zahl aufeinander folgender Teilbänder der Vielzahl von Teilbändern zusammengesetzt ist;

Erzeugen einer Bandinformatiön, die das Quantisierungs-Zielband anzeigt;

Quantisieren einer Form des Frequenzbereichsparameters in dem Quantisierungs-Zielband, um eine formkodierte Information zu erhalten;

Kodieren einer Verstärkung des Frequenzbereichsparameters in dem Quantisierungs-Zielband, um eine verstärkungskodierte Information zu erhalten;

Bestimmen, dass prädiktive Kodierung durchzuführen ist, wenn die Anzahl der gemeinsamen Teilbänder des Quantisierungs-Zielbands des aktuellen Rahmens und des in der Vergangenheit gewählten Quantisierungs-Zielbands gleich oder größer als ein vorgegebener Wert ist;

Bestimmen, dass keine prädiktive Kodierung durchzuführen ist, wenn die Anzahl der gemeinsamen Teilbänder kleiner als der vorgegebene Wert ist,

Erhalten der verstärkungskodierten Information durch Durchführen von prädiktiver Kodierung an der Verstärkung des Frequenzbereichsparameter in dem Quantisierungs-Zielband unter Verwendung vergangener verstärkungskodierter Information, wenn bestimmt wird, dass prädiktive Kodierung durchzuführen ist, und

Erhalten der verstärkungskodierten Information durch direktes Quantisieren der Verstärkung des Frequenzbereichsparameters in dem Quantisierungs-Zielband, wenn bestimmt wird, dass keine prädiktive Kodierung durchzuführen ist.

**18.** Sprachdekodierungsverfahren, das folgende Schritte umfasst:

Empfangen von Bandinformationen, die ein Quantisierungs-Zielband anzeigen, das aus einer natürlichen Zahl aufeinander folgender Teilbänder einer Vielzahl von Teilbändern zusammengesetzt ist, wobei die Vielzahl von Teilbändern ein unterteilter Frequenzbereichsparameter eines Eingangs-Audio/Sprachsignals ist;

Dekodieren einer formkodierten Information, in der eine Form eines Frequenzbereichsparameters in dem Quantisierungs-Zielband quantisiert ist, um eine dekodierte Form zu erzeugen;

Dekodieren einer verstärkungskodierten Information, in der eine Verstärkung eines Frequenzbereichsparameters in dem Quantisierungs-Zielband quantisiert ist, um eine dekodierte Verstärkung zu erzeugen;

Dekodieren des Frequenzbereichsparameters unter Verwendung der dekodierten Form und der dekodierten Verstärkung, um einen dekodierten Frequenzbereichsparameter zu erzeugen;

Transformieren des dekodierten Frequenzbereichsparameters in einen Zeitbereich, um ein zeitbereichsdekodiertes Signal zu erhalten;

Finden einer Anzahl von gemeinsamen Teilbändern eines Quantisierungs-Zielbands eines aktuellen Rahmens und eines Quantisierungs-Zielbands eines vergangenen Rahmens unter Verwendung der empfangenen Bandinformation;

Bestimmen, dass prädiktive Dekodierung durchzuführen ist, wenn die Anzahl der gemeinsamen Teilbänder des Quantisierungs-Zielbands des aktuellen Rahmens und des Quantisierungs-Zielbands eines vergangenen Rahmens gleich oder größer als ein vorgegebener Wert ist;

Bestimmen, dass keine prädiktive Dekodierung durchzuführen ist, wenn die Anzahl der gemeinsamen Teilbänder kleiner als der vorgegebene Wert ist,

Durchführen von prädiktiver Dekodierung der Verstärkung des Frequenzbereichsparameters in dem Quantisierungs-Zielband des aktuellen Rahmens unter Verwendung einer in einer vergangenen Verstärkungsdekodierung erhaltenen Verstärkung, wenn bestimmt wird, dass prädiktive Dekodierung durchgeführt werden muss; und

direktes Durchführen von Dequantisierung der verstärkungskodierten Information, in welcher die Verstärkung eines Frequenzbereichsparameters in dem Quantisierungs-Zielband des aktuellen Rahmens quantisiert ist, wenn bestimmt wird, dass keine prädiktive Dekodierung durchzuführen ist.

## Revendications

**1.** Appareil de codage vocal (100, 100a, 500, 700) adapté à effectuer un codage trame par trame, l'appareil de codage vocal comprenant :

- une section de transformation (101) adaptée à transformer un signal audio/vocal d'entrée en un domaine fréquentiel pour obtenir un paramètre de domaine fréquentiel ;
- une section de sélection (102) adaptée à diviser le paramètre de domaine fréquentiel en une pluralité de sous-bandes, adaptée, en outre, à sélectionner une bande cible de quantification composée d'un nombre naturel de sous-bandes consécutives de la pluralité de sous-bandes et adaptée, en outre, à générer des informations de bande indiquant la bande cible de quantification ;
- une section de quantification de forme (103) adaptée à quantifier une forme du paramètre de domaine fréquentiel dans la bande cible de quantification ;
- une section de quantification de gain (105, 505, 705) adaptée à coder un gain du paramètre de domaine fréquentiel dans la bande cible de quantification pour obtenir des informations codées de gain ; et
- une section de détermination (104) adaptée à :

  - déterminer qu'un codage prédictif doit être effectué lorsque le nombre de sous-bandes communes à la bande cible de quantification de trame actuelle et à une bande cible de quantification sélectionnée antérieurement est supérieur ou égal à une valeur prédéterminée ; et
  - déterminer qu'un codage prédictif ne doit pas être effectué lorsque le nombre de sous-bandes communes est inférieur à la valeur prédéterminée ;

- dans lequel la section de quantification de gain est adaptée à :

- obtenir les informations codées de gain en effectuant un codage prédictif sur le gain du paramètre de domaine fréquentiel dans la bande cible de quantification en utilisant des informations codées de gain antérieures, lorsque la section de détermination a déterminé qu'un codage prédictif doit être effectué ; et
- obtenir les informations codées de gain en quantifiant directement le gain du paramètre de domaine fréquentiel dans la bande cible de quantification, lorsque la section de détermination a déterminé qu'un codage prédictif ne doit pas être effectué.

2. Appareil de codage vocal selon la revendication 1, dans lequel la section de quantification de gain est en outre adaptée à obtenir les informations codées de gain en effectuant une quantification vectorielle du gain du paramètre de domaine fréquentiel.

3. Appareil de codage vocal selon la revendication 1, dans lequel la section de quantification de gain est en outre adaptée à obtenir les informations codées de gain en effectuant une quantification prédictive du gain en utilisant un gain d'un paramètre de domaine fréquentiel de trame antérieure.

4. Appareil de codage vocal selon la revendication 1, dans lequel la section de sélection est en outre adaptée à sélectionner une région pour laquelle une énergie est la plus élevée parmi des régions composées d'une pluralité de sous-bandes en tant que bande cible de quantification.

5. Appareil de codage vocal selon la revendication 1, dans lequel la section de sélection est en outre adaptée à sélectionner une bande pour laquelle une énergie est la plus élevée parmi les bandes candidates en tant que bande cible de quantification, lorsque les bandes candidates existent pour lesquelles un nombre de sous-bandes communes à la bande cible de quantification sélectionnée antérieurement est supérieur ou égal à une valeur prédéterminée et qu'une énergie est supérieure ou égale à une valeur prédéterminée,

- et dans lequel la section de sélection est en outre adaptée à sélectionner une bande pour lequel une énergie est la plus élevée dans toutes les bandes du domaine fréquentiel en tant que bande cible de quantification, lorsque les bandes candidates n'existent pas.

6. Appareil de codage vocal selon la revendication 1, dans lequel la section de sélection est en outre adaptée à sélectionner une bande la plus proche de la bande cible de quantification sélectionnée antérieurement parmi des bandes pour lesquelles une énergie est supérieure ou égale à une valeur prédéterminée en tant que bande cible de quantification.

7. Appareil de codage vocal selon la revendication 1, dans lequel la section de sélection est en outre adaptée à sélectionner la bande cible de quantification après multiplication par une pondération plus grande à mesure qu'une sous-bande s'approche d'un côté de bande basse.

8. Appareil de codage vocal selon la revendication 1, dans lequel la section de sélection est en outre adaptée à sélectionner une sous-bande fixée du côté de bande basse en tant que bande cible de quantification.

9. Appareil de codage vocal selon la revendication 1, dans lequel la section de sélection est en outre adaptée à sélectionner la bande cible de quantification après multiplication par une pondération plus grande à mesure que la fréquence de sélection antérieure d'une sous-bande est plus élevée.

10. Appareil de codage vocal selon la revendication 1, comprenant en outre une section d'interpolation (504) adaptée à effectuer une interpolation sur un gain d'un paramètre de domaine fréquentiel dans une sous-bande non quantifiée antérieurement parmi des sous-bandes indiquées par les informations de bande en utilisant des informations codées de gain antérieures pour obtenir une valeur d'interpolation.,

- dans lequel la section de quantification de gain est en outre adaptée à utiliser également la valeur d'interpolation lorsqu'elle effectue le codage prédictif.

11. Appareil de codage vocal selon la revendication 1, comprenant en outre une section de décision (704) adaptée à décider d'un coefficient de prédiction tel qu'une pondération d'une valeur de gain de trame antérieure soit plus grande à mesure qu'une sous-bande commune à une bande cible de quantification de trame antérieure et une bande cible de quantification de trame actuelle est plus grande,

- dans lequel la section de quantification de gain est en outre adaptée à utiliser le coefficient de prédiction lorsqu'elle effectue le codage prédictif.

12. Appareil de codage vocal selon la revendication 1, dans lequel la section de sélection est en outre adaptée à sélectionner de manière fixe une sous-bande prédéterminée en tant que partie de la bande cible de quantification.

13. Appareil de codage vocal selon la revendication 1, dans lequel la section de sélection est en outre adaptée à sélectionner la bande cible de quantification après multiplication par une pondération plus grande à mesure qu'une sous-bande s'approche d'un côté de bande haute dans une partie de la bande cible de quantification.

14. Appareil de codage vocal selon la revendication 1, dans lequel la section de quantification de gain est en outre adaptée à effectuer un codage prédictif sur un gain d'un paramètre de domaine fréquentiel dans une partie de la bande cible de quantification et à effectuer un codage non-prédictif sur un gain d'un paramètre de domaine fréquentiel dans une partie restante.

15. Appareil de codage vocal selon la revendication 1, dans lequel la section de quantification de gain est en outre adaptée à effectuer une quantification vectorielle du gain d'une pluralité de sous-bandes non consécutives.

16. Appareil de décodage vocal (200, 200a, 600, 800) comprenant :

- une section de réception (201) adaptée à recevoir des informations de bande indiquant une bande cible de quantification, qui est composée d'un nombre naturel de sous-bandes consécutives d'une pluralité de sous-bandes, dans lequel la pluralité de sous-bandes est un paramètre de domaine fréquentiel subdivisé d'un signal audio/vocal d'entrée ;
- une section de déquantification de forme (202) adaptée à décoder des informations codées de forme, dans lesquelles une forme d'un paramètre de domaine fréquentiel dans la bande cible de quantification est quantifiée, pour générer une forme décodée ;
- une section de déquantification de gain (204, 604, 804) adaptée à décoder des informations codées de gain, dans lesquelles un gain du paramètre de domaine fréquentiel dans la bande cible de quantification est quantifié, pour générer un gain décodé et pour décoder un paramètre de fréquence en utilisant la forme décodée et le gain décodé pour générer un paramètre de domaine fréquentiel décodé ;
- une section de transformation de domaine temporel (205) adaptée à transformer le paramètre de domaine fréquentiel décodé en un domaine temporel pour obtenir un signal décodé de domaine temporel ; et
- une section de détermination (203) adaptée à :

- trouver un nombre de sous-bandes communes à une bande cible de quantification de trame actuelle et à une bande cible de quantification de trame antérieure en utilisant les informations de bande reçues pour déterminer qu'un décodage prédictif doit être effectué lorsque le nombre de sous-bandes communes à la bande cible de quantification de trame actuelle et à une bande cible de quantification de trame antérieure est supérieur ou égal à une valeur prédéterminée ; et
- déterminer qu'un décodage prédictif ne doit pas être effectué lorsque le nombre de sous-bandes communes est inférieur à la valeur prédéterminée ;

- dans lequel la section de déquantification de gain est adaptée à :
- effectuer un décodage prédictif du gain du paramètre de domaine fréquentiel dans la bande cible de quantification de trame actuelle en utilisant un gain obtenu au cours d'un décodage de gain antérieur, lorsque la section de détermination a déterminé qu'un décodage prédictif doit être effectué ; et
- effectuer directement une déquantification des informations codées de gain, dans lesquelles un gain d'un paramètre de domaine fréquentiel est quantifié dans la bande cible de quantification de trame actuelle, lorsque la section de détermination a déterminé qu'un décodage prédictif ne doit pas être effectué.

17. Procédé de codage vocal pour effectuer un codage trame par trame, le procédé comprenant les étapes consistant à :

- transformer un signal audio/vocal d'entrée en un domaine fréquentiel pour obtenir un paramètre de domaine fréquentiel ;

- diviser le paramètre de domaine fréquentiel en une pluralité de sous-bandes ;

- sélectionner une bande cible de quantification composée d'un nombre naturel de sous-bandes consécutives de la pluralité de sous-bandes ;

- générer des informations de bande indiquant la bande cible de quantification ;

- quantifier une forme du paramètre de domaine fréquentiel dans la bande cible de quantification pour obtenir des informations codées de forme ;

- coder un gain du paramètre de domaine fréquentiel dans la bande cible de quantification pour obtenir des informations codées de gain ;

- déterminer qu'un codage prédictif doit être effectué lorsque le nombre de sous-bandes communes à la bande cible de quantification de trame actuelle et à une bande cible de quantification sélectionnée antérieurement est supérieur ou égal à une valeur prédéterminée ;

- déterminer qu'un codage prédictif ne doit pas être effectué lorsque le nombre de sous-bandes communes est inférieur à la valeur prédéterminée ;

- obtenir les informations codées de gain en effectuant un codage prédictif sur le gain du paramètre de domaine fréquentiel dans la bande cible de quantification en utilisant des informations codées de gain antérieures, lorsqu'il est déterminé qu'un codage prédictif doit être effectué ; et

- obtenir les informations codées de gain en quantifiant directement le gain du paramètre de domaine fréquentiel dans la bande cible de quantification, lorsqu'il est déterminé qu'un codage prédictif ne doit pas être effectué.

**18.** Procédé de décodage vocal comprenant les étapes consistant à :

- recevoir des informations de bande indiquant une bande cible de quantification, qui est composée d'un nombre naturel de sous-bandes consécutives d'une pluralité de sous-bandes, pour lequel la pluralité de sous-bandes est un paramètre de domaine fréquentiel subdivisé d'un signal audio/vocal d'entrée ;

- décoder des informations codées de forme, dans lesquelles une forme d'un paramètre de domaine fréquentiel dans la bande cible de quantification est quantifiée, pour générer une forme décodée ;

- décoder des informations codées de gain, dans lesquelles un gain d'un paramètre de domaine fréquentiel dans la bande cible de quantification est quantifié, pour générer un gain décodé ;

- décoder le paramètre de domaine fréquentiel en utilisant la forme décodée et le gain décodé pour générer un paramètre de domaine fréquentiel décodé ;

- transformer le paramètre de domaine fréquentiel décodé en un domaine temporel pour obtenir un signal décodé de domaine temporel ;

- trouver un nombre de sous-bandes communes à une bande cible de quantification de trame actuelle et à une bande cible de quantification de trame antérieure en utilisant les informations de bande reçues ;

- déterminer qu'un décodage prédictif doit être effectué lorsque le nombre de sous-bandes communes à la bande cible de quantification de trame actuelle et à une bande cible de quantification de trame antérieure est supérieur ou égal à une valeur prédéterminée ;

- déterminer qu'un décodage prédictif ne doit pas être effectué lorsque le nombre de sous-bandes communes est inférieur à la valeur prédéterminée ;

- effectuer un décodage prédictif du gain du paramètre de domaine fréquentiel dans la bande cible de quantification de trame actuelle en utilisant un gain obtenu au cours d'un décodage de gain antérieur, lorsqu'il est déterminé qu'un décodage prédictif doit être effectué ; et

- effectuer directement une déquantification des informations codées de gain, dans lesquelles un gain d'un paramètre de domaine fréquentiel est quantifié dans la bande cible de quantification de trame actuelle, lorsqu'il est déterminé qu'un décodage prédictif ne doit pas être effectué.

100

FIG.1

FIG.2

FIG.3

FIG.4

EP 2 101 318 B1

**200a**

FIG.5

EP 2 101 318 B1

300

INPUT SIGNAL

301 DOWN-SAMPLING SECTION

302 FIRST LAYER ENCODING SECTION

FIRST LAYER ENCODED INFORMATION

303 FIRST LAYER DECODING SECTION

FIRST LAYER DECODED SIGNAL

304 UP-SAMPLING SECTION

305 FIRST FREQUENCY DOMAIN TRANSFORM SECTION

FIRST LAYER MDCT COEFFICIENT

306 DELAY SECTION

307 SECOND FREQUENCY DOMAIN TRANSFORM SECTION

SECOND LAYER MDCT COEFFICIENT

308 SECOND LAYER ENCODING SECTION

SECOND LAYER ENCODED INFORMATION

309 MULTIPLEXING SECTION

BIT STREAM

FIG.6

FIG.7

FIG.8

EP 2 101 318 B1

FIG.9

FIG.10

EP 2 101 318 B1

FIG.11

EP 2 101 318 B1

**FIG.12**

EP 2 101 318 B1

SHAPE ENCODED INFORMATION

201

202

SHAPE DEQUANTIZATION SECTION

BAND INFORMATION  203

PREDICTIVE DECODING EXECUTION/NON-EXECUTION DECISION SECTION

803

PREDICTION COEFFICIENT DECIDING SECTION

DEMULTIPLEXING SECTION

BIT STREAM

GAIN ENCODED INFORMATION

804

GAIN DEQUANTIZATION SECTION

205

TIME DOMAIN TRANSFORM SECTION

DECODED SIGNAL

FIG.13

FIG.14

FIG.15

FIRST SPECTRUM

1072 : CORRECTIVE SCALE FACTOR ENCODING SECTION

SECOND SPECTRUM

1721
SCALE FACTOR CALCULATION SECTION

1725

1727
WEIGHTING ERROR CALCULATION SECTION

1728
SEARCH SECTION

ENCODED PARAMETER (CORRECTIVE SCALE FACTOR INDEX)

1722
SCALE FACTOR CALCULATION SECTION

1724

1726
DETERMINATION SECTION

$V_0$
$V_1$
⋮
$V_i$
⋮

1723 CORRECTIVE SCALE FACTOR CODEBOOK

FIG.16

EP 2 101 318 B1

58

FIG.17

EP 2 101 318 B1

FIG.18

EP 2 101 318 B1

FIG.19

EP 2 101 318 B1

FIG.20

FIG.21

EP 2 101 318 B1

FIG.22

FIG.23

EP 2 101 318 B1

1200

401

402

FIRST LAYER
DECODING
SECTION

403

UP-SAMPLING
SECTION

BIT STREAM

CONTROL SECTION

404

FREQUENCY DOMAIN
TRANSFORM SECTION

407

DECODED SIGNAL

1205

406

SECOND LAYER
DECODING
SECTION

TIME DOMAIN
TRANSFORM
SECTION

FIG.24

FIG.25

FIG.26

EP 2 101 318 B1

FIG.27

FIG.28

FIG.29

EP 2 101 318 B1

**REFERENCES CITED IN THE DESCRIPTION**

**Patent documents cited in the description**

- JP HEI8211900 B

- US 2003093271 A1

**Non-patent literature cited in the description**

- **THOMAS ERIKSSON ; JAN LINDEN ; JAN SKOGLUND.** Exploiting Inter-frame Correlation In Spectral Quantization," "Acoustics, Speech, and Signal Processing. *ICASSP-96. Conference Proceedings,* 07 May 1996, vol. 2, 765-768

- **SALAVEDRA J. M. et al.** *APVQ Encoder Applied to Wideband Speech Coding,* 03 October 1996